(19) **Europäisches Patentamt**
European Patent Office
Office européen des brevets

(11) **EP 3 887 865 B1**

(12) **EUROPÄISCHE PATENTSCHRIFT**

(45) Veröffentlichungstag und Bekanntmachung des Hinweises auf die Patenterteilung:
**16.10.2024   Patentblatt 2024/42**

(21) Anmeldenummer: **19812931.4**

(22) Anmeldetag: **20.11.2019**

(51) Internationale Patentklassifikation (IPC):
**G01T 1/17** (2006.01)

(52) Gemeinsame Patentklassifikation (CPC):
**G01T 1/17; G01R 29/02**

(86) Internationale Anmeldenummer:
**PCT/EP2019/081996**

(87) Internationale Veröffentlichungsnummer:
**WO 2020/109117 (04.06.2020 Gazette 2020/23)**

(54) **VERFAHREN ZUR BESTIMMUNG EINER ANKUNFTSZEIT EINES EINE PHYSIKALISCHE MESSGRÖSSE REPRÄSENTIERENDEN, DIGITALISIERTEN SIGNALPULSES, AUSWERTEEINHEIT, VORRICHTUNG, AUSWERTESYSTEM UND STRAHLENDETEKTIONSSYSTEM**

METHOD FOR DETERMINING AN ARRIVAL TIME OF A DIGITISED SIGNAL PULSE REPRESENTING A PHYSICAL MEASURED VARIABLE, EVALUATION UNIT, DEVICE, EVALUATION SYSTEM AND BEAM DETECTION SYSTEM

PROCÉDÉ SERVANT À DÉFINIR UN TEMPS D'ARRIVÉE D'UNE IMPULSION DE SIGNAL NUMÉRISÉE REPRÉSENTANT UNE GRANDEUR DE MESURE PHYSIQUE, UNITÉ D'ÉVALUATION, DISPOSITIF, SYSTÈME D'ÉVALUATION ET SYSTÈME DE DÉTECTION DE RAYONS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.11.2018   DE 102018130022**

(43) Veröffentlichungstag der Anmeldung:
**06.10.2021   Patentblatt 2021/40**

(73) Patentinhaber: **Forschungszentrum Jülich GmbH 52425 Jülich (DE)**

(72) Erfinder:
• **JOKHOVETS, Lioubov
  52351 Düren (DE)**
• **GREWING, Christian
  52428 Jülich (DE)**
• **VAN WAASEN, Stefen
  41836 Hückelhoven (DE)**
• **ERVEN, Andreas
  50129 Bergheim (DE)**
• **KULESSA, Pawel
  31-422 Krakow (PL)**

(74) Vertreter: **Paul & Albrecht Patentanwälte PartG mbB
Stresemannallee 4b
41460 Neuss (DE)**

(56) Entgegenhaltungen:
• **A ERVEN ET AL: "PANDA STT Workshop Data analysis and results", 30 January 2017 (2017-01-30), XP055670083, Retrieved from the Internet <URL:https://indico.gsi.de/event/5290/session/9/contribution/23/material/slides/0.pdf> [retrieved on 20200219]**
• **HU W ET AL: "A simple and improved digital timing method for positron emission tomography", NUCLEAR INSTRUMENTS & METHODS IN PHYSICS RESEARCH. SECTION A, ELSEVIER BV * NORTH-HOLLAND, NL, vol. 622, no. 1, 1 October 2010 (2010-10-01), pages 219 - 224, XP027275378, ISSN: 0168-9002, [retrieved on 20100604]**

- JOKHOVETS L ET AL: "Improved Rise Approximation Method for Pulse Arrival Timing", IEEE TRANSACTIONS ON NUCLEAR SCIENCE, IEEE SERVICE CENTER, NEW YORK, NY, US, vol. 66, no. 8, 1 August 2019 (2019-08-01), pages 1942 - 1951, XP011739599, ISSN: 0018-9499, [retrieved on 20190814], DOI: 10.1109/TNS.2019.2923382

**Beschreibung**

Die Erfindung betrifft ein Verfahren zur Bestimmung einer Ankunftszeit eines eine physikalische Messgröße repräsentierenden, digitalisierten Signalpulses. Darüber hinaus betrifft die Erfindung eine Auswerteeinheit und eine Vorrichtung zur Bestimmung einer Ankunftszeit von eine physikalische Messgröße repräsentierenden Signalpulsen, ein Auswertesystem und ein Strahlendetektionssystem.

Verglichen mit analogen Verfahren bieten digitale Zeitmessungen viele Vorteile beim Analysieren von Signalen, insbesondere von Strahlungsdetektoren, vor allem aufgrund der Fähigkeit der wahren Echtzeitdatenverarbeitung.

Während die analoge Technik Ankunftszeit, Ladung oder Amplitude bereitstellt, bietet die digitale Technik die gesamte Information über die Signalform, was eine Energiefilterung und Filterung des kohärenten Rauschens sowie ein Durchführen von Korrekturen, die durch mögliche Basislinienverschiebungen und Puls-Pileups verursacht werden, erlaubt. Zusätzliche Vorteile der digitalen Technik sind die Flexibilität bei der Anwendung verschiedener Messparameter und Zeitmessalgorithmen und die Möglichkeit des Triggerns bzw. Auslösens und der Datenarchivierung für eine spätere Analyse. Ein Vorteil von analogen Verfahren ist, dass sie nicht durch die Quantisierung in der Zeit begrenzt sind und somit zu einer höheren Zeitauflösung führen könnten. Eine höhere Abtastrate bei digitalen Verfahren reduziert den Quantisierungsfehler, aber erfordert eine kosten- und stromverbrauchaufwendigere Implementierung von dem Filter bzw. Pulsformer (englisch: shaper) und den Analog-Digital-Wandlern (englisch: analog-to-digital converter, abgekürzt ADCs). Zudem wird der erforderliche digitale Datendurchsatz erhöht, was mehr Echtzeit-Verarbeitungsressourcen erfordert. Als Folge davon werden die Leistungsaufnahme und Kosten der gesamten Analog-/Abtast-/Digital-Kette deutlich höher.

Es gibt eine Reihe von digitalen Verfahren für die Messung der Ankunftszeit schneller elektrischer Pulse. Die relativ einfachen Verfahren, wie etwa das digitale Leading-Edge-Diskriminator-Verfahren (englisch: digital leading edge discrimation method, abgekürzt dLED) und die digitale Constant -Fraction-Diskriminator-Methode (englisch: digital constant fraction discrimination, abgekürzt dCFD) stammen von der analogen Technik. Bei diesen Verfahren wird die Zeit, zu der ein Puls einen bestimmten Schwellenwert erreicht, bestimmt [1]. Sowohl digitale als auch analoge Leading-Edge-Diskriminator-, also LED-Verfahren leiden unter dem "Time-Walk", das heißt der Abhängigkeit der Zeitmessung von der Pulsamplitude. Dieser Fehler kann teilweise reduziert werden, wenn ein konstanter Bruchteil des Pulsspitzenwertes als Schwellenwert verwendet wird (CFD-Technik). In digitaler Form implementiert sind diese Verfahren auch nicht frei von dem durch eine Zufalls-Abtastphase des ADC verursachten Fehler- dem Abtastphasenfehler (englisch: Sampling Phase Error, abgekürzt SPE).

Komplizierte Verfahren wurden entwickelt, um diesen Wert zu reduzieren. Diese sind insbesondere dCFD mit nichtlinearer Interpolation [1-2, 5], Moment- bzw. Pulsanalyse [1], Anpassung von Durchschnittswellenform oder analytischen Funktionen [3], Anwendung von Zeitmessfiltern [4] sowie die Verwendung von Nachschlagetabellen [5]. Die Verfahren erfordern eine mittlere bis hohe Verarbeitungsressource und sind nicht leicht konfigurierbar. Darüber hinaus berücksichtigen einige von ihnen einen Pulsspitzenwert oder Abtastwerte, die nach der Pulsspitze liegen, die meist durch statistische Schwankungen beeinflusst sind.

Insbesondere bei Mehrkanal-Gasdetektoren bzw. Driftkammern, sogenannten Straw-Tube-Spurdetektoren (englisch: straw tube tracker, abgekürzt STT) treten eine Vielzahl von Puls-Formen in Abhängigkeit von Cluster-Statistiken, Abstand der Bahn zum Anodendraht und Gasfüllung der Röhren auf [6]. Die Pulsform ist charakteristisch, zeigt oftmals einige wenige Wendepunkte am Pulsanstieg oder einige Spitzen. Pulse von Szintillatoren zeigen auch Abweichungen ihrer Spitzenformen aufgrund einer Photonen-Emissionsstatistik [5]. Daher kann nach Ansicht der Anmelderin erwartet werden, dass die Ankunftszeitmessverfahren, die den Anstieg der Pulse verwenden, eine höhere Zeitauflösung bereitstellen könnten als diejenigen, die Spitzenwerte oder die Analyse der kompletten Pulsform verwenden. Am attraktivsten ist nach Ansicht der Anmelderin eine Gruppe von Verfahren, wo die Puls-Vorderflanke mit einer Geraden angenähert wird [7-9]. Das Verfahren zur Approximation im maximalen Anstieg (englisch: Most Rise Approximation Method, abgekürzt: MRA Method) detektiert zunächst zwei benachbarte Abtastwerte am steilsten Teil der steigenden Flanke des Pulses und berechnet dann den Schnittpunkt der Linie durch diese Abtastwerte mit der Basislinie [7]. Bei dem Verfahren zur Approximation am ersten Anstieg (englisch: Initial Rise Approximation Method, abgekürzt: IRA Method) wird eine lineare Approximation unter Verwendung von den zwei allerersten Abtastwerten an dem Anstieg durchgeführt [9]. Eine Berechnung der Puls-Ankunftszeit bei diesen Verfahren ist einfach und erfordert niedrige Ressourcen. Jedoch wird die Linearanstiegsapproximation (LRA) von gewöhnlich nichtlinearen steigenden Flanken der Pulse von Strahlungsdetektoren im Allgemeinen zu einer schlechten Zeitauflösung führen. Eine zusätzliche Einbeziehung von Offline-Statistiküberlegungen [8] verbessert die Auflösung teilweise.

Aus dem Aufsatz "A simple and improved digital timing method for positron emission tomography", von Wei Hu et al., Nuclear Instruments & Methods in Physics Research, Section A, Elsevier B.V., Bd. 622, Nr. 1, 1. Oktober 2010, Seiten 219 bis 224 geht ein einfaches und verbessertes digitales Timingverfahren für die Positronen Emissionstomography (PET) hervor. Das Verfahren, das auch als "Initial Rise Interpolation Method" bezeichnet wird, ist auf einer wichtigen Eigenschaft von gamma-Signalen basiert: Ein auf geeignete Weise vorverstärkter und gesampelter Gammasignal-Puls ist dadurch charakterisiert, dass er mit einem initialen Anstieg von der Basislinie ankommt und dann einen maximalen Anstieg erreicht. Es ist offenbart, die Pulsankunftszeit durch Berechnung der Schnittstelle der initialen Anstiegslinie mit der Basislinie für jeden Gammasignalpuls zu erhalten. Dabei werden drei digitale Timingverfahren verwendet, um die CTR (Coincidence Timing Resolution) für zwei verschiedene Arten von PET-Sensoren zu messen. Die initiale Anstiegs-Interpolations-Methode liefert die beste Zeitauflösung für beide Arten.

Aus der US 2018/0113160 A1 geht ein Verfahren zum Schätzen eines Wertes der Ankunftszeit eines detektierten, digitalisierten Signalpulses hervor, dessen Basislinie, sofern vorhanden, subtrahiert wurde. Bei diesem Verfahren werden Werte des Pulses aus Bereichen erfasst, in denen der Puls sich ändert, wenn sein Ankunftszeit-Offset sich ändert, und eines oder mehrere Verhältnisse der erfassten Werte werden gebildet. Das bzw. die Verhältnisse werden als Variablen in einer Referenz-Kalibriertable oder -gleichung verwendet, um den geschätzten Wert der Ankunftszeit zu erhalten.

Aus der US 2018/0113203 A1 geht ein Verfahren zur Bestimmung der Ankunftszeit eines digitalisierten Signalpulses mit bekannter Basislinie hervor, bei dem ein Bereich um den Maximalwert des digitalisierten Pulses interpoliert wird, um den Maximalwert M oberhalb der Basislinie des Pulses zu ermitteln. Dieser Maximalwert M wird mit einem konstanten Bruchteil f multipliziert, um ein konstantes-Bruchteils-Level f*M zu erhalten, und die steigende Flanke des Pulses wird interpoliert, um die Zeit zu bestimmen, zu welcher der Puls das konstante-Bruchteils-Level f*M über der Basislinie überschreitet. Diese Zeit $t_A$ wird als die Ankunftszeit des Pulses erachtet.

Insbesondere, um eine Echtzeit-Verarbeitung zu ermöglichen, vor allem bei einer Vielzahl von Kanälen beispielsweise mittels eines feldprogrammierbaren Gate Arrays (englisch: field progammable gate array, abgekürzt FPGA), ist eine möglichst niedrige Verarbeitungsressource erstrebenswert.

Es ist daher eine Aufgabe der vorliegenden Erfindung, ein Verfahren der eingangs genannten Art anzugeben, welches sich mit geringeren Verarbeitungsressourcen durchführen lässt und gleichzeitig eine zuverlässige Bestimmung der Ankunftszeit von Signalpulsen ermöglicht. Darüber hinaus ist es eine Aufgabe der Erfindung, eine Einrichtung bzw. ein System anzugeben, welche diese Vorteile bietet.

Die Aufgabe wird gelöst durch ein Verfahren gemäß Anspruch 1.

Das Verfahren umfasst die Schritte, dass

- bestimmt wird, welche Form die steigende Flanke des Signalpulses aufweist, wobei die Form ausgewählt wird aus der Gruppe umfassend

    - einen zumindest im Wesentlichen linearen Anstieg,
    - einen nichtlinearen Anstieg ohne Wendepunkt und
    - einen S-ähnlichen nichtlinearen Anstieg mit wenigstens einem, insbesondere genau einem Wendepunkt,

- in allen drei Fällen mittels einer Auswerteeinheit eine Differenz zwischen dem Zeitpunkt des ersten Abtastpunktes des Signalpulses und einer Ankunftszeit des Signalpulses berechnet wird über die Gleichung

$$\Delta t = T \frac{k a_1}{a_2 - c k a_1}$$

wobei T die Abtastperiode darstellt, mit welcher der digitalisierte Signalpuls abgetastet ist, und $a_1$ der Abtast-, insbesondere Amplituden-Wert eines ersten Abtastpunktes $s_1$ und $a_2$ der Abtast-, insbesondere Amplituden-Wert eines zweiten, späteren Abtastpunktes $s_2$ des digitalisierten Signalpulses, wobei $s_1$ und $s_2$ bevorzugt die allerersten beiden Abtastpunkte auf der steigenden Flanke des Signalpulses sind, und wobei für den Fall, dass ein zumindest im Wesentlichen linearer Anstieg als Form der steigenden Flanke bestimmt wird, k =1 und c = 1 gesetzt wird, und für den Fall, dass ein nichtlinear Anstieg ohne Wendepunkt als Form der steigenden Flanke bestimmt wird, k = exp(-T/$\tau$) oder k=a(2T)/2a(T), wobei a(2T) und a(T) die Abtast-, insbesondere Amplituden-Werte eines dritten und zweiten Abtastpunktes eines digitalisierten Referenzpulses sind, bei dem der Abtast-, insbesondere Amplituden-Wert eines ersten Abtastpunktes auf der steigenden Flanke einem für die Digitalisierung des Referenzpulses angesetzten Schwellwert entspricht oder höchstens um einen vorgegebenen Wert oberhalb des Schwellwertes liegt, und c = 1 gesetzt wird, und für den Fall, dass ein S-ähnlicher nichtlinearer Anstieg mit wenigstens einem, insbesondere genaue einem Wendepunkt als Form der steigenden Flanke bestimmt wird, $k = m$ exp(-$T/\tau$) mit $3,30 \leq m \leq 4,0$, insbesondere $3,50 \leq m \leq 3,90$, bevorzugt $3,58 \leq m \leq 3,80$, oder k=a(2T)/a(T), wobei a(2T) und a(T) die Abtast-, insbesondere Amplituden-Werte eines dritten und zweiten Abtastpunktes auf der steigenden Flanke eines digitalisierten Referenzpulses sind, bei dem der Abtast-, insbesondere Amplituden-Wert eines ersten Abtastpunktes auf der steigenden Flanke einem für die Digitalisierung des Referenzpulses angesetzten Schwellwert entspricht oder höchstens um einen vorgegebenen Wert oberhalb des Schwellwertes liegt, und c = 0 gesetzt wird, wobei $\tau$ eine die

Puls-Peakzeit spezifizierende Zeitkonstante ist, und

- mittels der Auswerteeinheit unter Berücksichtigung des erhaltenen Wertes für Δt eine Ankunftszeit des Signalpulses berechnet wird, insbesondere über die Gleichung

$$t_m = t_1 - \Delta t,$$

wobei $t_1$ der Zeitpunkt des ersten Abtatspunktes $s_1$ des Signalpulses ist.

$\tau$ ist insbesondere eine Zeitkonstante, die für einen nichtlinearen Anstieg ohne Wendepunkt als Puls-Anstiegszeit und für einen nichtlinearen Anstieg mit Wendepunkt als die Hälfte der Puls-Anstiegszeit angenommen wird.

Die bestimmte Ankunftszeit wird bevorzugt bei der weiteren Verarbeitung des digitalisierten Signalpulses berücksichtigt.

Der erste Abtastpunkt kann Bezug auf den zweiten, späteren Abtastpunkt auch als früherer Abtastpunkt erachtet und bezeichnet werden.

Der vorliegenden Erfindung liegt mit anderen Worten einerseits die Idee zugrunde, bei der Bestimmung der Ankunftszeit von Signalpulsen deren Form zu berücksichtigen und verschiedene Pulsformen unterschiedlich zu approximieren:

    1. linearen Anstieg mit linearer Funktion,
    2. nichtlinearen Anstieg ohne Wendepunkt mit Response von CR-RC (Funktion gemäß unten stehender Gleichung (1) mit n=1)
    3. nichtlinear Anstieg mit Wendepunkt mit Response von CR-RC$^2$ (Funktion gemäß unten stehender Gleichung (1) mit n=2)

Dies stellt eine Abkehr vom Stand der Technik dar, der zwar verschiede Auswertemöglichkeiten zur Ankunftszeitbestimmung vorschlägt, jedoch keine unterschiedliche Behandlung verschiedener Pulsformen vorsieht. Das erfindungsgemäße Verfahren ermöglicht es, für alle drei Fälle von Pulsformen optimale Ergebnisse zu erhalten.

Auf der anderen Seite basiert die Erfindung auf der Erkenntnis, dass trotz der vorteilhaften unterschiedlichen Behandlung bzw. weiteren Verarbeitung im Falle verschiedener Pulsformen dieselbe Gleichung bzw. Gleichungsstruktur zur Berechnung des Zeit-Offsets Δt herangezogen werden kann, wobei für die Berücksichtigung verschiedener Pulsformen und Peak-Zeiten und Abtastraten lediglich ein Faktor bzw. Parameter in der Gleichung anzupassen ist, konkret k. Der weitere Faktor bzw. Parameter c ist darüber hinaus entweder 0 für die S-ähnliche Pulsform oder 1 für die anderen Pulsformen. Dies macht das erfindungsgemäße Verfahren besonders gut anwendbar auf verschieden Detektorarten, insbesondere verschiedene Arten von Strahlendetektoren.

Die Erfindung schlägt dabei eine einfache, leicht zu implementierende nichtlineare Anstiegsapproximation (nLRA) vor. Dabei wird die Puls-Start- bzw. Puls-Ankunftszeit direkt von den ersten beiden Punkten, konkret Samples $s_1$, $s_2$ auf der steigenden Flanke des Pulses abgeleitet und der Abtastphasenfehler signifikant reduziert, wodurch Zeitauflösungen deutlich unterhalb von 1/100 Bruchteil der Abtastperiode erzielt werden können.

Konkret werden gemäß der Erfindung drei verschiedene Pulsformen unterschieden, nämlich solche mit:

    1. zumindest im Wesentlichen linearem Anstieg
    2. nichtlinearem Anstieg ohne Wendepunkt
    3. nichtlinearem Anstieg mit wenigstens einem, insbesondere genau einem Wendepunkt - S-ähnlicher Anstieg

Erfindungsgemäß ist für diese drei Fälle vorgesehen:

- für den zumindest im Wesentlichen linearen Anstieg wird die LRA-Methode angewendet, mit einer Offset-Berechnung

$$\Delta t = T \frac{a_1}{a_2 - a_1}$$

- für den nichtlinearen Anstieg ohne Wendepunkt wird die nLRA-Methode angewendet, wobei der Offset berechnet wird durch

$$\Delta t = T \frac{ka_1}{a_2 - ka_1}$$

- für den S-ähnlichen nichtlinearen Anstieg wird die nLRA-Methode verwendet mit einer Offset-Berechnung von

$$\Delta t = T \frac{ka_1}{a_2}$$

Dies bedeutet, dass erfindungsgemäß für alle drei Typen von Pulsen die Ankunftszeitberechnungsformel

$$\Delta t = T \frac{ka_1}{a_2 - cka_1}$$

zur Anwendung kommt, wobei k=1 und c=1 für Pulse der ersten Art, $k = \exp(-T/\tau)$ oder k=a(2T)/2a(T), wobei a(2T) und a(T) die Abtast-, insbesondere Amplituden-Werte eines dritten und zweiten Abtastpunktes eines digitalisierten Referenzpulses (R) sind, bei dem der Abtast-, insbesondere Amplituden-Wert eines ersten Abtastpunktes auf der steigenden Flanke (F) einem für die Digitalisierung des Referenzpulses angesetzten Schwellwert entspricht oder höchstens um einen vorgegebene Wert oberhalb des Schwellwertes liegt, und c=1 für Pulse der zweiten Art und $k = m \exp(-T/\tau)$ mit $3{,}30 \leq m \leq 4{,}0$, insbesondere $3{,}50 \leq m \leq 3{,}90$, bevorzugt $3{,}58 \leq m \leq 3{,}80$, oder k=a(2T)/a(T), wobei a(2T) und a(T) die Abtast-, insbesondere Amplituden-Werte eines dritten und zweiten Abtastpunktes auf der steigenden Flanke (F) eines digitalisierten Referenzpulses (R) sind, bei dem der Abtast-, insbesondere Amplituden-Wert eines ersten Abtastpunktes auf der steigenden Flanke (F) einem für die Digitalisierung des Referenzpulses angesetzten Schwellwert entspricht oder höchstens um einen vorgegebenen Wert oberhalb des Schwellwertes liegt, und c=0 für Pulse der dritten Art angesetzt wird.

Die Erfindung macht es somit möglich, für alle drei Fälle die gleiche Ankunftszeitberechnungs-Einheit, etwa in Form eines entsprechend ausgebildeten und/oder eingerichteten bzw. konfigurierten FPGAs und/oder einer anwendungsspezifischen integrierten Schaltung (ASIC), zum Einsatz kommen kann.

Auch ist die Tatsache, dass dieselbe Gleichung nur mit unterschiedlichen Faktoren bzw. Parametern zum Einsatz kommen kann, besonders vorteilhaft für eine Implementierung, die auf einfache Weise an unterschiedliche Pulsformen und Abtastraten anpassbar ist. Wird der Algorithmus beispielsweise auf einer auf einem FPGA und/oder einem ASIC basierenden Auswerteeinheit implementiert, müssen nur die Werte der Faktoren bzw. Parameter angepasst werden, um auf eine andere Pulsform zu wechseln, bzw. können auch Werte für alle drei Pulsformen abgelegt und/oder auswählbar sein, um einfach auf eine Pulsformänderung zu reagieren. Auch kann eine Auswerteeinheit bereitgestellt werden, die von vornherein für die Ankunftszeitbestimmung in allen drei Fällen ausgelegt ist, die dann insbesondere ganz flexibel in Kombination mit unterschiedlichen Detektoren, insbesondere Strahledetektoren zum Einsatz kommen kann. Das erfindungsgemäße Verfahren ist insbesondere optimal geeignet, um in bzw. in Verbindung mit vielen Anwendungen gasförmiger Detektoren, Neutronen-Streu-Experimente oder beispielsweise PET-TOF-Detektoren zur Anwendung zu kommen.

Das erfindungsgemäße Verfahren kommt dabei gleichzeitig mit einer äußerst geringen Verarbeitungsressource aus und ermöglicht eine hohe Zeitauflösung. Insbesondere in Kombination mit einer langsamen Signalformung (englisch: shaping) mit Anstiegzeiten etwa im Bereich zwischen 40 und 10ns und einer niedrigen Abtastrate, etwa im Bereich von 50 bis 200 MSPS (Mega-Abtastwerte pro Sekunde, englisch: Mega Samples per Second) kann eine sehr niedrige Gesamtleistungsaufnahme der kompletten Analog-/Abtast-/Verabreitungs-Kette erreicht werden. Für Abtatsraten unterhalb von 100 MSPS können Zietauflösungen besser als 100 ps bei einer Leistungsaufnahme von nur 100 mW pro Kanal erzielt werden. Dies erlaubt es, hunderte von Kanälen innerhalb eines einzigen, typischen FPGA-Chips (der insbesondere die digitale Verarbeitungskette bzw. einen Teil dieser bildet) oder innerhalb eines ASICs, die bevorzugt die gesamte Analog-/Abtast-/Verarbeitungs-Kette umfasst, zu verarbeiten.

Bevorzugt kann vorgesehen sein, dass das Verhältnis der Dauer der steigenden Flanke des Pulses bzw. der Pulse und der Abtastrate derart ist oder gewählt wird, dass auf der steigenden Flanke zwei bis sechs Abtastpunkte liegen.

Eine besonders bevorzugte Ausführungsform des erfindungsgemäßen Verfahrens zeichnet sich dadurch aus, dass das Verhältnis der Abtastrate zu der Dauer der steigenden Flanke des Signalpulses derart gewählt oder eingestellt wird, dass mindestens zwei Samples, also Abtastpunkte, bevorzugt mindestens drei Abtastpunkte, besonders bevorzugt genau drei Abtastpunkte auf der steigenden Flanke liegen. Dies ermöglicht insbesondere eine Timing-Effizienz von 100 oder mehr.

Alternativ oder zusätzlich kann vorgesehen sein, dass der Puls bzw. die Pulse mit einer Abtastrate von weniger als 200 Mega-Samples pro Sekunde (MSPS), insbesondere weniger als 150 Mega-Samples pro Sekunde (MSPS), bevorzugt weniger als 100 Mega-Samples pro Sekunde (MSPS) digitalisiert ist oder wird bzw. sind oder werden. Dies kann beispielsweise mittels geeigneter pipelined ADCs erzielt werden, welche eine gut optimierte Stromverbrauch/Abtastraten-Kombination besitzen. Außerdem sind Abtastraten von bis zu 200 MSPS besonders gut geeignet für den Datenstrom moderner FPGAs. FPGAs erlauben eine Datenerfassung (mit I/O SerDes) von bis zu 1200 MHz und eine Taktung der Datenverarbeitung von bis zu 200-250 MHz. Durch diese Eigenschaften ist die Verwendung von pipelined ADCs und FPGAS für die Echtzeit-Signal-Verarbeitung besonders gut geeignet. Besonders bevorzugt ist bzw. wird der Puls mit einer Abtastrate im Bereich von 50 bis 200 MSPS, insbesondere 50 bis 150 MSPS, bevorzugt 50 bis 100 MSPS digitalisiert.

Für Pulse, die sich durch eine Dauer der Anstiegsflanke von beispielsweise 30 ns auszeichnen, entsprechen die Abtastraten von weniger als 200 MSPS, insbesondere weniger als 150 MSPS, bevorzugt weniger als 100 MSPS einer Anzahl von weniger als 6 Abtastpunkten auf der steigenden Flanke, insbesondere von weniger als 5 oder 4 Abtastpunkten auf der steigenden Flanke, bevorzugt einer Anzahl von weniger als 3 Abtastpunkten auf der steigenden Flanke.

Es versteht sich, dass - etwa im Rahmen einer Mesung, insbesondere Strahlungsmessung - eine Vielzahl von eine physikalische Messgröße repräsentierenden Signalpulsen entstehen und erfasst werden können, auch über eine Vielzahl von Kanälen. Dann wird bevorzugt für mehrere, insbesondere alle Signalpulse eine Ankunftszeit (für jeden Kanal) unter Durchführung des erfindungsgemäßen Verfahrens bestimmt.

Die vorliegende Erfindung geht u.a. von folgenden Überlegungen aus.

Insbesondere, was Pulse angeht, die durch Strahlungsdetektoren erzeugt werden, gibt es im Allgemeinen zwei Fälle. Der erste betrifft sehr kurze Sensorpulse, die als Deltafunktion betrachtet werden können. Beispiele solcher Pulse sind eine Einzel-Cluster-Antwort von Gasdetektoren und eine kurze Laserpulsantwort von Photovervielfacherröhren und Silizium-Photovervielfachern (SiPMs).

Gas-Detektoren, insbesondere Straw Tubes, sind in der Regel Proportionalzähler, bestehend aus einer gasgefüllten Röhre mit einer leitfähigen Innenschicht als Kathode und einem entlang der Zylinderachse gespannten Anodendraht. Teilchen, welche die Gas-gefüllten Röhren/Tubes passieren, ionisieren das Detektorgas, produzieren also Ionen und Elektronen (Ionisationseffekt).

Abhängig davon, welche geladenen Teilchen das Gas durchqueren, gibt es einen oder auch mehrere Ionisationspunkte bzw. Einzelwechselwirkungen in dem Gas. An jedem Ionisationspunkt bzw. durch jede Einzelwechselwirkung entsteht ein Ionisationscluster mit einem oder mehreren Elektronen und einem oder mehreren positive Ionen. Je nachdem, welche geladenen Teilchen das Gas durchqueren, wird somit nur einer oder werden mehrere Cluster in dem Gas erzeugt. Eine $^{55}$Fe-Quelle beispielsweise erzeugt immer eine einzelne Wechselwirkung und somit einen einzelnen Cluster. Man spricht daher auch von einer Einzel-Cluster-Antwort bzw. $^{55}$Fe-Einzel-Cluster-Antwort (siehe auch [6]).

In den Gas-Detektoren trennt ein radial starkes elektrisches Feld zwischen dem Draht (Anode) und dem Außenleiter die Elektronen und positive Ionen, die von den geladenen Teilchen erzeugt werden. Der bzw. die Elektronen-Cluster der primären Ionisation driften zur Anode, an der üblicherweise eine positive Spannung von etwa wenigen kV anliegt, während die Ionen zur Kathode hin driften. Die Elektronenanzahl wird nahe der Anode aufgrund des Avalanche-Effektes erhöht und die die Anode erreichenden Elektronen verursachen einen Anodenstrom, der Verstärkt wird, wobei der Verstärker in der Regel einen Shaper/Former umfasst. Die Antwort ist insbesondere durch das Ausgangssignal des Verstärkers (mit Shaper) gegeben. In demjenigen Falle, dass mehrere Cluster erzeugt werden, ist die Pulsform in der Regel durch eine Überlagerung von mehreren Cluster-Antworten gegeben.

Im Zusammenhang mit der Erzeugung von Clustern in Gas-Detektoren sei rein beispielhaft auch auf [13] verwiesen.

Silizium-Photovervielfacher (SiPMs), auch bekannt als Mehrfachpixel-Photonenzähler (MPPCs), sind eine relativ neue Art von Detektoren, die aus einer parallelen Anordnung von Photonenzählmikrozellen bestehen, die eine Einzelphoton-Avalanche-Diode (englisch: Single Photon Avalanche Diode, abgekürzt: SPAD) und ein integriertes Löschelement aufweisen. Die parallel geschalteten Anoden des Silizium-Detektors liefern ein Ausgangsstromsignal, das zu dem einfallenden Photonenfluss direkt proportional ist. Die extrem bemerkenswerte Leistung, die von den SiPM-Detektoren in Bezug auf eine hohe Photonendetektionseffizienz, schnelle transiente Antwort, exzellente Zeitmessauflösung und einen breiten Spektralbereich erreicht wird, gibt ihnen ein starkes inhärentes Potenzial zum Ersetzen von klassischen Phototube-Detektoren. Silizium-Photovervielfacher (SiPMs) und Mehrfachpixel-Photonenzähler (MPPCs) sind Photonenzähldetektoren, die in der Regel empfindlich auf Photonen mit Energien im ultravioletten, sichtbaren und nahen Infrarotbereich sind [4]. Anordnungen von SiPMs/MPPCs und Szintillatoren können für die Energiespektroskopie und Zeitmessung von ionisierender Strahlung verwendet werden.

Photovervielfacherröhren und Silizium-Photovervielfacher (SiPMs) haben eine Pulsdauer von wenigen Nanosekunden. Um solche Pulse abzutasten, insbesondere digitalisieren zu können, kann deren Dauer durch eine geeignete bzw. entsprechende Pulsformung(englisch: shaping) erhöht werden. Dies kann durch eine elektrische Schaltung erreicht werden, die aus einem einzigen Hochpassfilter gefolgt von n Stufen von RC-Integratoren besteht: CR-RC$^n$. Die Pulsantwort dieser Schaltung wird beschrieben durch

$$V(t) = A\left(\frac{t-t_s}{\tau}\right)^n \exp\left(-\frac{t-t_s}{\tau}\right), \qquad (1)$$

wobei t und $t_s$ Zeit beziehungsweise Start- (Ankunfts-) Zeit des Pulses sind, mit $t_s \leq t$, A ein amplitudenbezogener Faktor ist, n eine ganze Zahl ist und $\tau$ eine Zeitkonstante, die die Puls-Peakzeit/Pulsspitzenzeit (engl.: pulse peaking time) spezifiziert. Letztere beträgt $n\tau$. Zum Beispiel für Gasdetektoren, wo eine CR-RC$^2$-Formung verwendet wird, gibt Gleichung (1) mit n = 2 die Form einer Einzelclusterantwort auf $^{55}$Fe-Bestrahlung an [6].

Die Puls-Peakzeit (bzw. Pulsspitzenzeit bzw. pulse peak(ing) time bzw. (Puls-)Anstiegszeit bzw. (Puls-)Anstiegszeit bzw. (Puls-)Anstiegsdauer bzw. Dauer des Anstiegs bzw. Dauer der steigenden Flanke bzw. pulse rise time - die Begriffe werden synonym verwendet) ist insbesondere diejenige Zeit bzw. Zeitspanne, die zwischen dem Beginn eines Pulses und dem Zeitpunkt, an dem der Puls sein (einziges bzw. im Falle mehrerer erstes) Maximum erreicht hat, liegt bzw. vergeht. Mit anderen Worten ist es insbesondere die Zeit bis zu dem (einzigen bzw. ersten) Maximum/ Peak eines Pulses bzw. die Dauer seines Anstiegs bzw. seiner steigenden Flanke.

Rein beispielhaft sei im Zusammenhang mit der Puls-Peakzeit auch auf [14] verwiesen.

Es sei angemerkt, dass insbesondere für den Fall, dass die Pulsform nur durch eine Formung/ein Shaping bestimmt ist, die Puls-Peakzeit in der Regel bekannt ist. Insbesondere für den Fall, dass die Pulsform auch durch andere Faktoren bestimmt wird, kann die Puls-Peakzeit beispielsweise abgeschätzt werden.

In dem vorstehend zweitgenannten Fall wird der Detektorausgangspuls nicht nur durch eine Pulsformung, sondern auch durch andere Faktoren bestimmt. Insbesondere kann eine rauschfreie Gammastrahlenantwort von Strahlungsdetektoren, wie etwa einem SiPM gekoppelt mit einem Cer-dotiertem Lutetium-Yttrium-Orthosilikat (LYSO) Szintillator, durch Gleichung (1) mit n = 1 gut beschrieben werden. Eine solche Pulsform wurde für die beiden am häufigsten verwendeten SiPMs von Sensl und Hamamatsu mit $\tau$ von 20-50ns berichtet [9-11]. Diese Pulsdauer ist für eine Niedrigratenabtastung ausreichend, ohne irgendeine Pulsformung anzuwenden. Ein anderes Beispiel ist eine Mehrfachclusterantwort in einem Straw-Rohr-Spurdetektor (englisch straw tube tracker, abgekürzt STT). Ihre Form kann durch Gleichung (1) mit n = 2 modelliert werden, jedoch mit einem erhöhten Wert von $\tau$ verglichen mit dem der verwendeten Formungsschaltung.

Entsprechend zeichnet sich eine bevorzugte Ausführungsform des erfindungsgemäßen Verfahrens dadurch aus, dass als Form für die steigende Flanke des Pulses ein nichtlinearer Anstieg ohne Wendepunkt gewählt wird, wenn die Pulsform durch die Gleichung

$$V(t) = A\left(\frac{t-t_s}{\tau}\right)^n \exp\left(-\frac{t-t_s}{\tau}\right)$$

mit n = 1 beschrieben werden kann,

und

als Form für die steigende Flanke des Pulses ein S-ähnlicher nichtlinearer Anstieg mit wenigstens einem Wendepunkt für den Fall gewählt wird, dass die Pulsform durch die Gleichung

$$V(t) = A\left(\frac{t-t_s}{\tau}\right)^n \exp\left(-\frac{t-t_s}{\tau}\right)$$

mit n = 2 beschrieben werden kann, wobei t die Zeit, $t_s$ die Ankunftszeit des Pulses, A ein amplitudenbezogener Faktor und $\tau$ eine die Puls-Peakzeit spezifizierende Zeitkonstante ist.

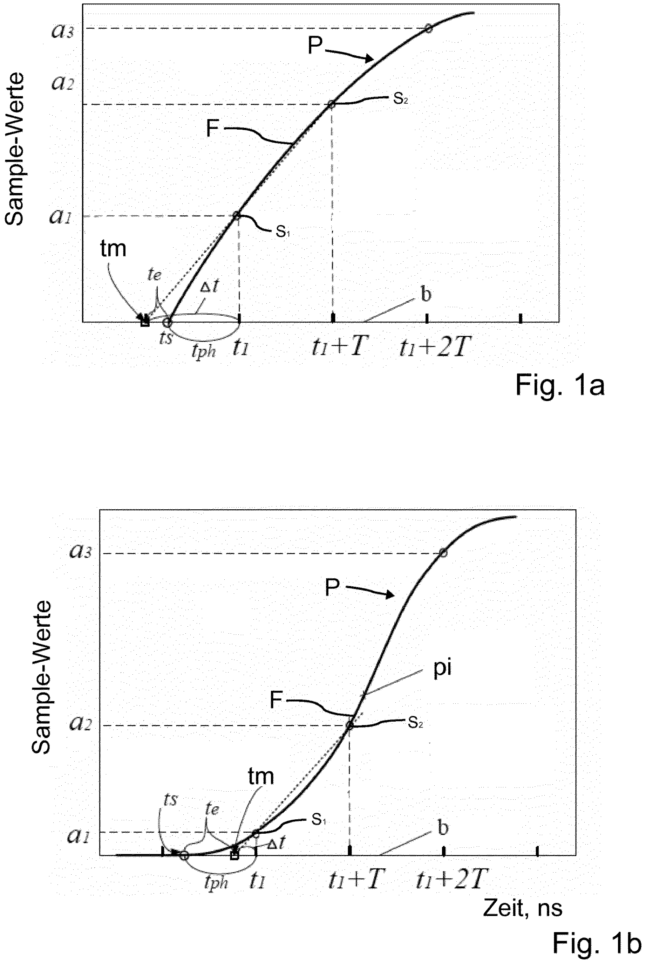

Im Folgenden wird die Genauigkeit der Linearanstiegsapproximations-Technik (LRA) für elektrische Pulse, deren Form durch die vorstehende Gleichung (1) mit n = 1 und n = 2 modelliert werden kann, erwogen. Der Hauptunterschied zwischen den zwei Signalformen ist, dass erstere (n=1) durch eine monoton abnehmende Steigung des Pulsanstiegs gekennzeichnet ist, wohingegen die letztere (n=2) ein S-ähnliches Verhalten besitzt, d.h. es gibt einen Wendepunkt an der Puls-Vorderflanke. Diese Pulsformen sind in Figur 1 dargestellt, konkret der Fall n =1 in Figur 1 a) und der Fall n=2 in Figur 1 b). Jeder Puls P ist dabei über der Basislinie b gezeigt.

In dem freilaufenden Abtastmodus wird das Detektorsignal nach dem Nyquist-Shannon-Theorem für die darauffolgende Analog-Digital-Wandlung verstärkt und durch einen Tiefpassfilter gefiltert. ADCs werden synchron getaktet, um kontinuierliche Abtastpunkte bereitzustellen. Die ADC-Daten durchlaufen eine digitale Echtzeit-Formung bzw. Filterung und kommen zu der ersten Verarbeitungsaufgabe. Das heißt die Detektierung eines Signals. Zu diesem Zweck wird bevorzugt ein Schwellenwert über dem Rauschpegel spezifiziert und die Abtastwerte des Datenstroms werden damit verglichen. Wenn der Abtastwert über dem Schwellwert liegt, wird der Puls detektiert. Dann wird eine Zeitmarke $t_m$ durch Berechnen eines Schnittpunkts der Basislinie b mit einer Geraden durch die zwei allerersten Abtastwerte ($a_1$, $t_1$ und $a_2$, $t_2$) an dem Pulsanstieg, also der Pulsflanke erhalten, wie in Figur 1 für CR-RC- (Figur 1 a)) beziehungsweise CR-RC$^2$-pulsformen (Figur 1b)) veranschaulicht. Wie man sieht, gilt $t_m = t_1 - \Delta t$, wobei der Zeitversatz $\Delta t$ gegeben ist durch

$$\Delta t = T \frac{a_1}{a_2 - a_1} = T \frac{r}{1-r}, \qquad (2)$$

Dabei ist T die Abtastperiode und $r = a_1/a_2$. Dann ist

$$t_m = t_1 - T \frac{r}{1-r}. \qquad (3)$$

Die Zeitmarke $t_m$ hat eine Bedeutung der berechneten Ankunftszeit des Pulses. Im Allgemeinen stimmt sie nicht mit der wahren Ankunftszeit $t_s$ überein, sondern hängt von einer Zeitverzögerung des ersten Abtastwerts (Samplingwerts) in Bezug auf die wahre Ankunftszeit (die Abtastphase) ab. Der resultierende Fehler $t_e = t_s - t_m$ wird der Abtastphasenfehler (SPE) genannt. Die Verwendung eines asynchronen (in Bezug auf das Signal) Taktgebers erzeugt einen zufälligen SPE, was zu einer signifikanten Verschlechterung der gesamten Zeitmessauflösung führen kann.

In den Figuren 1 a) und 1 b) sind die berechnete Ankunftszeit $t_m$, die tatsächliche Ankunftszeit $t_s$, der Wendepunkt pi bei der S-ähnlichen Form (Figur 1 b)), das Offset, also die Differenz, bzw. der berechnete Zeit-Offset $\Delta t$ und der Abtastphasenfehler $t_e$ eingezeichnet. Weiterhin ist $t_{ph}$ die Verschiebung des ersten Abtastpunktes bezüglich der tatsächlichen Puls-Ankunft.

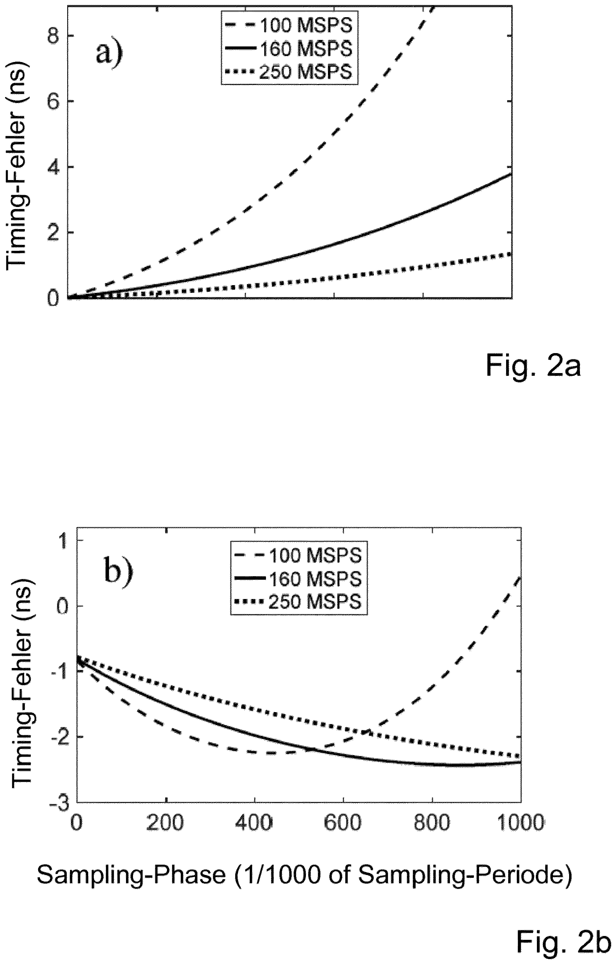

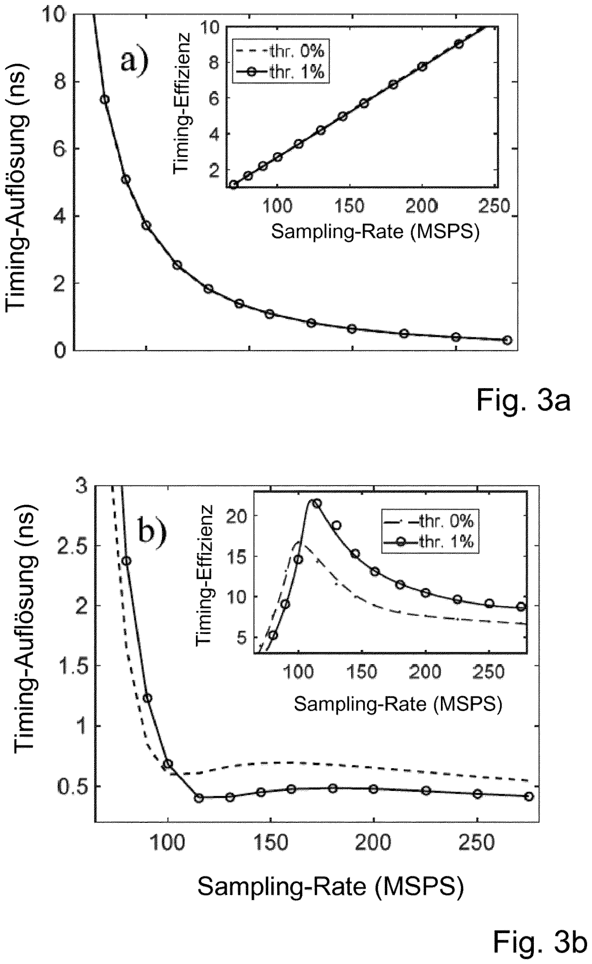

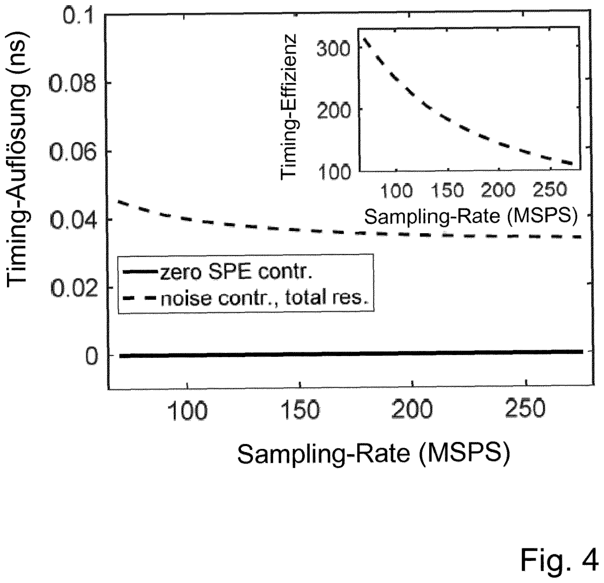

Die Figur 2 zeigt den simulierten Zeitmessfehler $t_e$ als Funktion von der Abtastphase für CR-RC- (Figur 2 a)) beziehungsweise CR-RC$^2$-Pulsformung (Figur 2b)). Hier ist die Spitzenzeit auf 30 ns eingestellt und der durch Rauschen verursachte Zeitmess-Jitter ist nicht enthalten. Man sieht, dass das LRA-Verfahren für beide Signalformen zu einer nichtlinearen Abhängigkeit des Zeitmessfehlers von der Abtastphase führt. Da ein asynchroner (in Bezug auf das Signal) Taktgeber üblicherweise in Experimenten verwendet wird, wird der Quadratmittel-(RMS)-Zeitmessfehler $t_{e,rms}$ als die Zeitmessauflösung betrachtet. Die berechnete Zeitmessauflösung ist in Figur 4(a) und Figur 4(b) für CR-RC- beziehungsweise CR-RC$^2$-Pulsformung gezeigt. Man beachte, dass bei niedrigen Abtastraten die Zeitmessauflösung für die CR-RC$^2$-Pulsformung verglichen mit der für die CR-RC-Pulformung viel besser ist. Zusätzlich gilt, dass, während sich für die CR-RC-Pulsformung die Zeitmessauflösung monoton verbessert, wenn die Abtastrate erhöht wird, es im Fall der CR-RC$^2$-Pulsformung einen optimalen Bereich von Abtastraten bei etwa 120 MSPS gibt. In diesem Bereich beträgt die Zeitmessauflösung etwa 500-600 ps, was etwa 1/20-1/15 des Abtastzeitraums entspricht (siehe Figur 4(b)). Der Unterschied zwischen CR-RC und CR-RC$^2$ ist deutlicher, wenn die durch $Q = T/t_{e,rms}$ definierte Zeitmesseffizienz aufgetragen wird (siehe die eingeschobenen Graphen in Figuren 3 a) und b)). Aus dem eingeschobenen Graphen gemäß Figur 3a) geht auch hervor, dass die niedrigen Schwellwerte die Messung nicht beeinflussen. Die Abhängigkeiten mit und ohne Schwellwert sind nahezu gleich.

Somit führt das LRA-Verfahren für beide Arten von Pulsanstieg zu einer niedrigen Zeitmesseffizienz. Sie ist besonders niedrig, wenn eine CR-RC-Formung (bzw. einen nichtlinearen Anstieg ohne Wendepunkt) und niedrige Abtastraten verwendet werden. Jedoch ist der große Vorteil des LRA-Verfahrens eine einfache Echtzeit-Berechnung der Zeitmarke, was es für Echtzeitanwendungen attraktiv macht.

Im Folgenden wird auf die nicht-lineare Anstiegsapproximation (nLRA) eingegangen.

Wie vorstehend bereist diskutiert, kann bei vielen Experimenten die Antwort von Strahlungsdetektoren auf hochenergetische Teilchen durch Gleichung (1) mit n=1 oder n=2 zufriedenstellend modelliert werden. Die steigende Flanke solcher Pulse ist eindeutig nichtlinear (siehe Figur 1). Durch Einstellen von t auf $t_1$ und $t_2$ auf $t_1+T$ erhält man aus Gleichung (1):

$$kr = \frac{t_1 - t_s}{t_1 + T - t_s} \qquad (4)$$

und

$$kr = \left( \frac{t_1 - t_s}{t_1 + T - t_s} \right)^2 \qquad (5)$$

für n=1 beziehungsweise n=2. Hier $r = a_1/a_2 = V(t_1)/V(t_1+T)$ und $k = \exp(-T/\tau)$. Um die Analogie zu dem LRA-Verfahren zu halten, kann der Zeitversatz $\Delta t$ durch $\Delta t = t_1 - t_s$ definiert werden. Dann sind die Lösungen der Gleichungen (4) und (5)

$$\Delta t = T \frac{kr}{1 - kr} \qquad (6)$$

beziehungsweise

$$\Delta t = T \frac{kr + \sqrt{kr}}{1 - kr}, \qquad (7)$$

Die Pulsstart-, bzw. tatsächliche Ankunftszeitzeit ist gegeben durch

$$t_s = t_1 - \Delta t . \qquad (8)$$

Dies sind die exakten Lösungen, unabhängig von der Abtastphase. Somit wird bei bekannter T, r, k und $t_1$ die Pulsstartzeit $t_s$ exakt berechnet, im Gegensatz zu dem LRA-Verfahren, bei dem im Allgemeinen ein Abtastphasenfehler ungleich Null auftritt (siehe Figur 3). Man beachte, dass sich Gleichung (6) auf Gleichung (2) reduziert, wenn k=1, d.h. wenn T→0. Das bedeutet, dass bei hohen Abtastraten und für durch Gleichung (1) mit n=1 beschriebene Pulse das LRA-Verfahren eine akkurate Startzeit gibt, d.h. der SPE geht auf Null, wenn die Abtastraten hoch genug sind. Gleichung (7) kann nicht in eine ähnliche Form wie Gleichung (2) umgeschrieben werden, was bedeutet, dass das auf eine CR-RC$^2$-Antwort angewandte LRA-Verfahren immer zu einem Zeitmessfehler ungleich Null führen wird.

Erfindungsgemäß sind Wege zur Implementierung der Gleichungen (6) und (7) geschaffen worden, um maximale Leistung mit minimalem Ressourcenverbrauch zu ermöglichen, was eine wichtige Anforderung insbesondere für Mehrkanaldatenerfassungssysteme ist.

Für den Fall der CR-RC-Pulsformung gilt Folgendes.

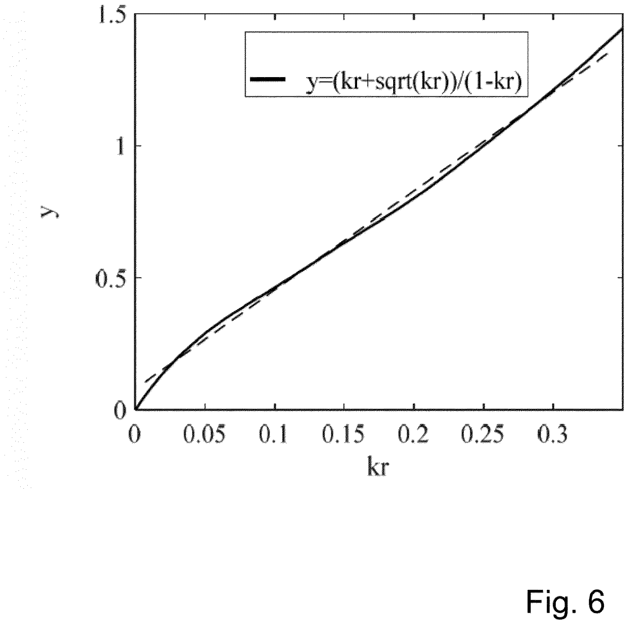

In einem rauschfreien Fall und wenn Werte für T, r, k und $t_1$ bekannt sind, kann die Ankunftszeit unter Verwendung der Gleichungen (6) und (8) exakt berechnet werden. Mit anderen Worten, im Gegensatz zu der LRA, für die der SPE inhärent ist, führt der erfindungsgemäß vorgesehen Algorithmus des Berechnens von $t_s$ keinen systematischen Fehler ein, d.h. $t_e$=0 und die Zeitmesseffizienz wäre unendlich. In der Praxis ist es nicht notwendig, eine unendliche Effizienz zu erhalten. Es reicht aus, den SPE-Fehler auf einen Wert unter den durch Rauschen verursachten zu beschränken. Dies erlaubt es, dass Werte des Faktors k in Gleichung (6) hinsichtlich der minimalen Implementierungsnutzung ausgewählt werden, was nur eine Verschiebungs- und eine Summier-Operation erfordert. Sie können beispielsweise 0,625 und 0,750 sein. Für $\tau$ = 30ns entspricht dies Abtastraten von 71 und 115 MSPS, bei denen die Abtasteffizienz nur durch Rauschen beeinflusst wird. Für andere Abtastraten als diese entsteht ein Zeitmessfehler $t_{e,1}$ ungleich Null aufgrund einer nicht akkuraten Anpassung des Faktors k. Als Beispiel ist die Abhängigkeit von $t_{e,1}$ von der Abtastrate für k=0,625 in Figur 6 durch die durchgezogene Linie gezeigt, ebenso wie der Beitrag eines weißen Rauschens mit einem Signal-Rausch-(SNR)-Verhältnis von 46 dB (gepunktete Linie) und die sich ergebende Zeitauflösung (gestrichelte Linie).. Aus Figur 6 ist ersichtlich, dass trotz des festen Wertes von k eine akzeptable Zeitauflösung (besser als 100 ps) selbst bei variierten (bis zu etwa 10%) Abtastraten erzielt werden kann. Eine ähnliche Schlussfolgerung gilt für zulässige Abweichungen in $\tau$, d.h. in der Pulsanstiegsdauer.

Für den Fall der CR-RC$^2$-Pulsformung gilt Folgendes.

Aufgrund des Ausdrucks $\sqrt{kr}$ erfordert Gleichung (7) mehr Implementierungsressourcen als Gleichung (6). Wie jedoch im Folgenden gezeigt wird, ergibt eine Linearisierung der Gleichung (7) eine gute Approximation. Unter der Annahme, dass der erste Abtastwert von dem wahren Pulsstart nicht mehr als um eine Abtastperiode entfernt ist, d.h. $(t_1 - t_s) \le T$, und unter Verwendung von Gleichung (5) erkennt man, dass mögliche kr-Werte insbesondere zwischen 0 und 0,25 liegen. Wird ein Schwellwert für die Puls-Detektierung angewendet, wird sich dieser Bereich ändern. Für den 1% Schwellwert und eine Abtastrate von 100 MSPS beispielsweise (was bei einem Anstieg von 30 ns 3 Abtastpunkten auf dem Anstieg entspricht), liegen die erwarteten kr-Werte insbesondere zwischen 0 und 0,3. Figur 6 zeigt die Funktion

$$y = \left(kr + \sqrt{kr}\right)\Big/(1 - kr)$$

(durchgezogene Linie) sowie deren Linearisierung (gestrichelte Linie). Diese Linearisierung kann insbesondere als beste lineare Approximation der y-Funktion erachtet werden, wenn die Messung bei einer Abtastrate in der Nähe von 100 MSPS durchgeführt wird und ein Schwellwert von 1% für die Pulsdetektion angewendet wird. Für diese Bedingungen wird der durch die Linearisierung bedingte Fehler (es wird angenommen, dass dieser Fehler in Einheiten der Abtastperiode T ausgedrückt wird und die Bedeutung eines Abtast-Phasen-Fehlers oder Sampling-Phasen-Fehlers, abgekürzt SPE hat) minimiert.

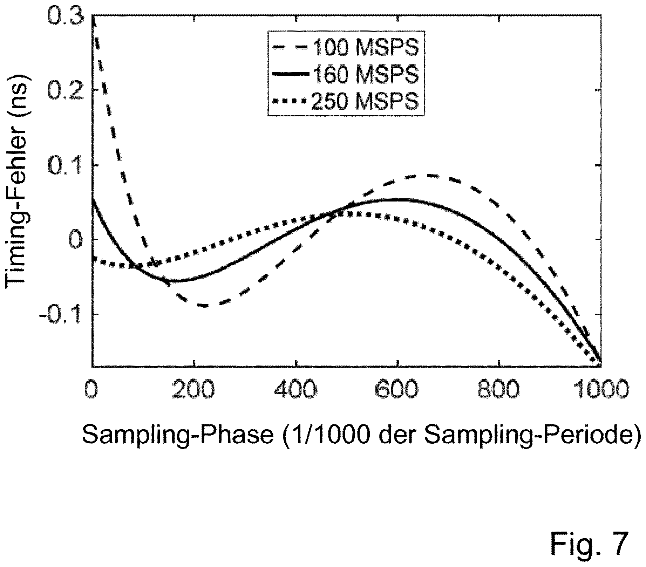

Der simulierte Timing-Fehler gegenüber der Abtastphase bei drei verschiedenen Abtastraten ist in Figur 7 gezeigt. Für diese Simulation wurde der Schwellwert von 0,8 % für die Pulsdetektion angewendet und die y-Funktion angenähert durch $y_0 = 0.1 + 3.58kr$, dies unabhängig von der Abtastrate. Es ist zu beachten, dass infolge der Linearisierung der y-Funktion der Timing-Fehler um den Nullwert oszilliert. Weiterhin erkennt man durch einen Vergleich dieses Ergenisses mit Figur 2 b), wo die LRA-Methode dargestellt ist, einen deutlich niedrigeren SPE bei allen Abtatsraten, obwohl die $y_0$-Funktion verwendet wurde, die für Abtastraten besonders optimiert ist, die in der Nähe von 100 MSPS liegen.

Für die gezeigten Abtastraten von 100 , 160 und 250 MSPS und einen Schwellwert von 0,8 % des Puls-Peak-Wertes ist ein Wert von m=3,58 in $k = m \exp(-T/\tau)$, also für die Linearisierung der S-ähnlichen steigenden Flanke, besonders geeignet. Insbesondere für andere Abtastraten und/oder Schwellwerte können auch andere Werte von m besonders geeignet sein. Dabei hat sich gezeigt, dass erfindungsgemäß besonders vorteilhafte Ergebnisse für verschiedene Atastraten und/oder Schwellwerte erzielt werden, wenn m im Bereich von 3,30 bis 4,0, insbesondere im Bereich 3,50 bis 3,90, bevorzugt im Bereich von 3,58 bis 3,80 liegt.

Bevorzugt gilt, dass für den Fall, dass das Verhältnis von Abtastrate und der Dauer der steigenden Flanke des Pulses derart ist bzw. gewählt wird, dass auf der steigenden Flanke 2 bis 3 Abtastpunkte liegen, m im Bereich von 3,55 bis 3,65 liegt. Für den Fall, dass das Verhältnis von Abtastrate und der Dauer der steigenden Flanke des Pulses derart ist bzw. gewählt wird, dass auf der steigenden Flanke 3 bis 4 Abtastpunkte liegen, liegt m bevorzugt im Bereich von 3,55 bis 3,70. Für den Fall, dass das Verhältnis von Abtastrate und der Dauer der steigenden Flanke des Pulses derart ist bzw. gewählt wird, dass auf der steigenden Flanke mehr als 4 Abtastpunkte liegen, liegt m bevorzugt im Bereich von 3,55 bis 3,90.

Weiterhihn kann vorgesehen sien, dass für eine Abtastrate im Bereich von 60 bis 100 MSPS, inbesondere 70 bis 100 MSPS, m im Bereich von 3,55 bis 3,65 liegt. Für eine Abtastrate im Bereich von mehr als 100 MSPS und weniger als 150 MSPS liegt m bevorzugt im Bereich von 3,55 bis 3,70. Für Abtastraten oberhalb von 150 MSPS liegt m bevorzugt im Bereich von 3,55 bis 3,90.

In weiterer bevorzugter Ausführungsform des erfindungsgemäßen Verfahrens kann vorgesehen sein, dass der Schwellwert im Bereich von 0,2 bis 3% des insbesondere durchschnittlichen Puls-Peak-Wertes liegt. Der Schwellwert kann insbesondere maximal 2% betragen, bevorzugt im Bereich von 1,2% bis 0,8% liegen. Als besonders geeigneter Schwellwert hat sich erwiesen, für die Pulsdetektion 1 % des insbesondere durchschnittlichen Puls-Peak-Wertes zu verwenden bzw. einzustellen. Der Puls-Peak-Wert stellt dabei insbesondere den durchschnittlichen maximalen Wert von Pulsen, insbesondere Deketorpulsen dar.

Besonders geeignete Kombinationen der Anzahl der Abtastpunkten auf der steigenden Flanke (also dem Verhältnis von Abtastrate und Dauer der steigenden Flanke), Schwellwerten (im Bereich von 0,2 bis 3 % des Puls-Peak-Wertes) und Werten von m sind in folgender Tabelle dargestellt:

| Anzahl der Abtastpunkte /Schwellwert (%) | 0,2 | 0,4 | 0,8 | 1,2 | 1,7 | 2,2 | 3 |
|---|---|---|---|---|---|---|---|
| 2 | 3,63 | 3,61 | 3,60 | 3,60 | 3,59 | 3,58 | 3,59 |
| 3 | 3,62 | 3,60 | 3,58 | 3,58 | 3,59 | 3,60 | 3,62 |
| 4 | 3,60 | 3,59 | 3,59 | 3,60 | 3,62 | 3,65 | 3,69 |
| 5 | 3,59 | 3,59 | 3,60 | 3,65 | 3,70 | 3,75 | 3,80 |

Besonders geeignete Kombinationen von Abtastraten (im Bereich von 70 bis 200 MSPS), Schwellwerten (im Bereich von 0,2 bis 3 % des Puls-Peak-Wertes) und Werten von m sind in folgender Tabelle dargestellt

| Abtastrate(MSPS) /Schwellwert (%) | 0,2 | 0,4 | 0,8 | 1,2 | 1,7 | 2,2 | 3 |
|---|---|---|---|---|---|---|---|
| 70 | 3,63 | 3,61 | 3,60 | 3,60 | 3,59 | 3,58 | 3,59 |

(fortgesetzt)

| Abtastrate(MSPS) /Schwellwert (%) | 0,2 | 0,4 | 0,8 | 1,2 | 1,7 | 2,2 | 3 |
|---|---|---|---|---|---|---|---|
| 100 | 3,62 | 3,60 | 3,58 | 3,58 | 3,59 | 3,60 | 3,62 |
| 150 | 3,60 | 3,59 | 3,59 | 3,60 | 3,62 | 3,65 | 3,69 |
| 200 | 3,59 | 3,59 | 3,60 | 3,65 | 3,70 | 3,75 | 3,80 |

Es versteht sich, dass sämtliche Ausführungen und/oder Ergebnisse, die für eine Approximation mit $k$ = 3.58exp(-$T/\tau$) erörtert werden, rein beispielhaft zu vertehen sind. Für Fälle, in denen ein anderer Wert für m geeigneter ist, insbesondere für von 100 MSPS verschiedene Abtastraten bzw. Verhältnisse von Abtastrate und Dauer der steigenden Flanke, die zu anderen Anzahlen von Abtastpunkten auf der steigenden Flanke korrespondieren und/oder von 1% verschiedene Schwellwerte, gelten die Ausführungen völlig analog.

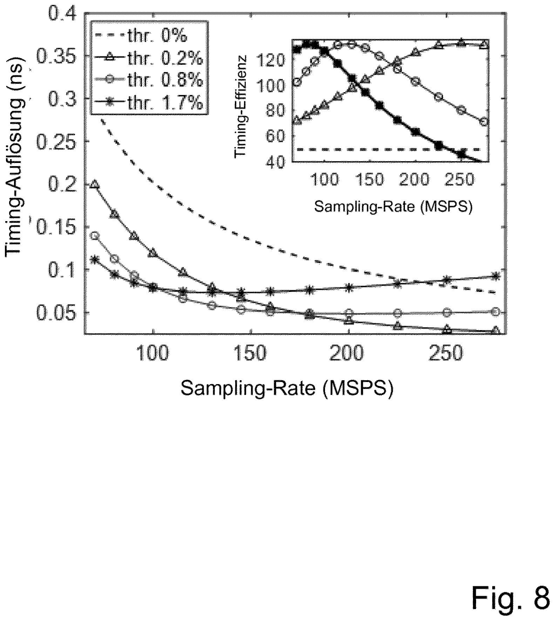

Unter Verwendung der Linearisierung der Funktion (rein beispielhaft mit $k$ = 3.58exp(-$T/\tau$)), wurde der RMS Timing-Fehler (Timing-Auflösung) in Abhängigkeit von der Abtastrate bei vier Schwellwerten für die Pulsdetektion berechnet (siehe Figur 8). Die Einsätze bzw. Nebengraphen zeigen die entsprechende Timing-Effizienz. Für den 0% Schwellwert ist die Timing-Effizienz etwa 49,5, dies unabhängig von der Abtastrate, während sie für Schwellwerte ungleich Null ein Maximum von etwa 132 bei bestimmten Abtastraten erreicht. Für den 0,8% Schwellwert liegt das Maximum nahe von 100 MSPS, und die Linearisierungs-begrenzt Timing-Auflösung ist besser als 100 Pikosekunden über einen gesamten Bereich niedriger Abtastraten etwa von 100 bis 200 MSPS. Aus Figur 8 kann auch geschlossen werden, dass, um eine höhere Effizienz bei niedrigeren Abtastraten zu erhalten, ein höherer Schwellwert gewählt werden sollte. Allerdings haben die Detektorsignale in der Praxis unterschiedliche Amplituden. So hat beispielsweise der gewählte Schwellwert von 1% eines üblichen Pulses den gleichen Wert wie ein Schwellwert von 2% bei einem Puls mit halber Amplitude. Dies ist der Grund, warum bei einem hohen dynamischen Bereich die niedrigeren Schwellwerte vorteilhaft sind, insbesondere eine Timing-Effizienz von wenigstens 50 garantieren.

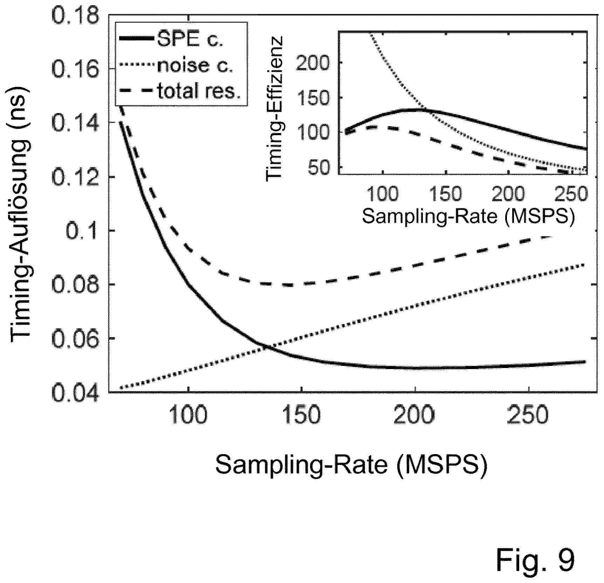

Figur 9 zeigt den Effekt von weißem Rauschen mit einem Signal-Rausch-Verhältnis (englisch signal-to-noise ratio, abgeküzt SNR) von 46 dB auf die totale Timing-Auflösung und Effizienz. Der angewendete Schwellwert war 0,8 % eines Signal-Peak-Wertes. Im Gegensatz zu der LRA-Methode, bei der derart moderates Rauschen die Zeitauflösung fast nicht beeinflusst, aufgrund eines hohen inheränten SPEs, besitzt die erfindungsgemäß vorgesehen nLRA-Methode einen niedrigen SPE und das moderate Rauschen wird zu einem signifikanten Faktor, der die Gesamt-Timing-Auflösung begrenzt, insbesonder bei höheren Abtastraten. Zusätzlich werden optimale Abtastraten in einem rauschbehafteten Setup zu niedrigeren Abtastraten-Bereich verschoben (vgl. die durchgezogenen und gestrichelten Linien im Einsatz von Figur 9). Bei diesen Bedingungen ist die Zeitauflösung für gewünschte Abtatsraten von insbesondere 100 bis 200 MSPS immer noch unterhlab von 100 ps. Zu beachten ist, dass eine Peaking-Zeit von 30 ns für die Simulation genommen wurde. Eine höhere Timing-Auflösung kann erreicht werden, indem die Peaking-Zeit reduziert wird. In diesem Falle wird der Rauschbeitrag durch eine steilere Puls-Anstiegsflanke verringert.

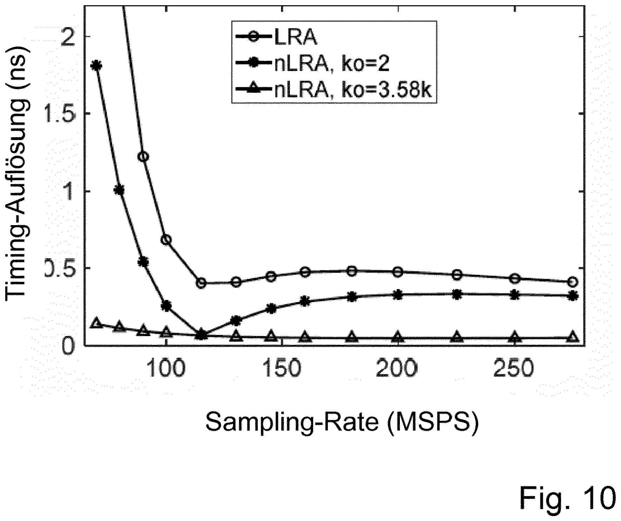

Die Ankunftszeitberechnung gemäß der linearisierten Form von Gleichung (7) benötigt nur einen Faktor, etwa $k_0$=3,58k, und ist für verschiedene Abtastraten und Signal-Peaking-Zeiten einfach zu konfigurieren. Zum Beispiel würden k0-Werte von 1,75, 1,875 und 2 Abtastraten von 92,6, 102 und 115 MSPS benötigen, um die maximale Timing-Effizienz zu erhalten. In Figur 10 sind Daten für die Timing-Auflösung, die durch die nLRA-Methode erhalten wurden (Dreiecke und Sterne) mit solchen der LRA-Methode (Kreise) verglichen. Die durchgezogenen Linien sollen nur der Führung des Auges dienen. Die Dreiecke entsprechen der Linearisierung der y-Funktion unter Verwendung von $k_0$=3,58k, wobei k für jede Abtastrate exakt berechnet ist. Die Sterne zeigen Werte, die für $k_0$=2 erhalten wurden, unabhängig von der Abtastrate. Die Simulation wurde für einen rauschfreien Setup und unter Verwendung eines Schwellwertes von 1% für die Pulsdetektion durchgeführt. Für einen Abtastraten-Bereich von 100 bis 170 MSPS ist die Zeitauflösung der nLRA-Methode höher als 0,1 ns, wenn der Faktor $k_0$=3,58k bei jeder Abtastrate exakt berechnet wird (siehe die Dreiecke in Figur 10), während die LRA-Methode nur eine Zeitauflösung von 0,6 bis 0,45 ns bietet (Kreise in Figur 10). Für eine fixen Wert von $k_0$=2 (Sterne) ist die optimale Abtastrate für die nLRA-Methode ungefähr 115 MSPS. Nichtsdestotrotz, im Vergleich zu der LRA-Methode kann eine beachtliche Verbesserung für alle Abtastraten beobachtet werden.

Es gibt auch eine andere Möglichkeit, den Faktor k zu ermitteln bzw. zu nähern, als über k = exp(-$T/\tau$) für den nichtlinearen Fall ohne Wendepunkt bzw. $k$ = $m$ exp(-$T/\tau$) mit 3,50 < m < 4,0 für den nichtlinearen Fall mit Wendepunkt.

$$\Delta t = T \frac{kr}{1 - kr}$$

Für einen nichtlineare Anstieg ohne Wendepunkt gilt . Wenn der erste Abtastpunkt eine Abtast-

$$\Delta t = T \frac{kr}{1 - kr} = T$$

periode vor der tatsächlichen Ankunftszeit des Pulses entfernt ist, sollte gelten, hier

$$r = \frac{a_1}{a_2} = \frac{a(T)}{a(2T)}$$

. Diese Bedingung bedeutet, dass der SPE (auch wenn die Abtastphase so hoch wie eine Abtastperiode ist) nahezu Null ist.

$$k = \frac{a(2T)}{2a(T)}$$

Aus dieser Gleichung kann $k$ als ermittelt werden.

Für einen nichtlinearen Anstieg mit Wendepunkt gilt $\Delta t = m\, Tkr$, beispielsweise $\Delta t = 3.58Tkr$. Wenn der erste Abtastpunkt eine Abtastperiode vor der tatsächlichen Ankunftszeit des Pulses entfernt ist, sollte $\Delta t = mTkr$, beispielsweise

$$r = \frac{a_1}{a_2} = \frac{a(T)}{a(2T)}$$

$\Delta t = 3.58Tkr = T$ gelten, hier . Diese Bedingung bedeutet, dass die Abtastphase so hoch wie eine Abtastperiode ist) nahezu Null ist. Aus dieser Gleichung ermitteln wir mk, beispielsweise

$$3.58k = \frac{a(2T)}{a(T)}$$

für m = 3,58 als .

Bei dem nichtlinearen Anstieg ohne Wendepunkt gilt, dass der aus dieser Berechnung mit zwei aufeinanderfolgenden Punkten erhaltene Faktor k den gleichen Wert wie aus den mit der vorherigen Gleichung bestimmten Wert $k$ = exp($-T/\tau$) hat.

Bei dem nichtlinearen Anstieg mit Wendepunkt gilt, dass der aus dieser Berechnung mit zwei aufeinanderfolgenden Punkten erhaltene Faktor k fast den gleichen Wert wie aus den mit der vorherigen Gleichung bestimmten Wert $k$ = 3.58exp($-T/\tau$) hat, siehe Tabelle mit Beispielen:

| Abtastrate (MSPS) | 90 | 100 | 115 | 130 | 145 | 160 | 180 |
|---|---|---|---|---|---|---|---|
| 3.58exp($-T/\tau$) Auflösung (ns) | 1.71 0.094 | 1.84 0.086 | 2.01 0.060 | 2.14 0.058 | 2.26 0.054 | 2.36 0.051 | 2.47 0.049 |
| $a(2T)/a(T)$ Auflösung (ns) | 1.75 0.116 | 1.87 0.09 | 2.02 0.066 | 2.13 0.061 | 2.22 0.067 | 2.29 0.078 | 2.36 0.095 |

Die Werte wurden unter Verwendung eines Schwellwertes von 1% erhalten.

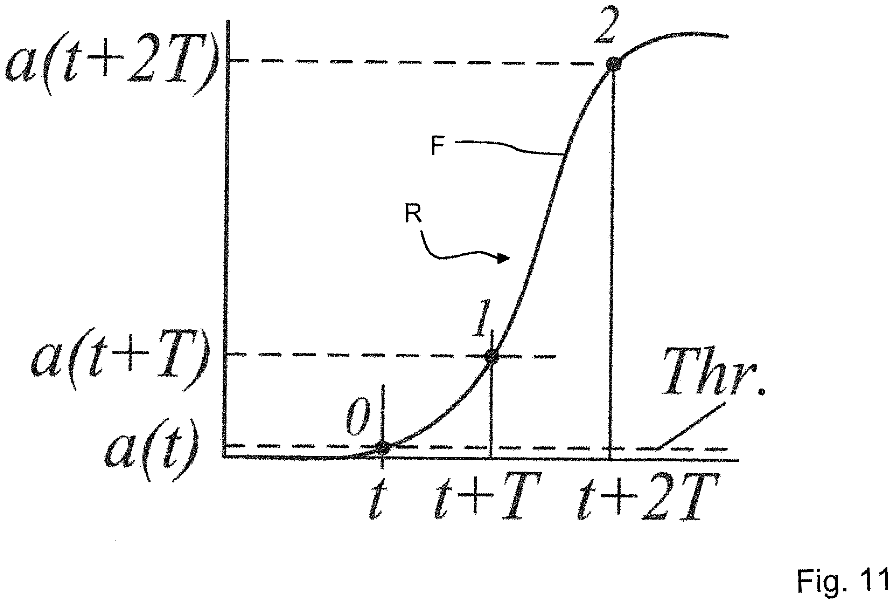

Die Figur 11 illustriert dies für die S-ähnliche Pulsform (und wiederum beispielhaft für m = 3,58). Bei der Zeit $t$ liegt der (aller)erste Abtastpunkt bzw. das (aller)erste Sample 0 an dem Schwellwert, der in der Figur 11 mit einer mit Thr bezeichneten, gestrichelten Linie dargestellt ist. Bevorzugt werden nur Pulse, für welche diese Bedingung erfüllt ist, zur Berechnung von Faktoren, konkret von k herangezogen. Dabei gilt, dass der allererste Abtastpunkt bevorzugt genau auf dem Schwellwert liegt, aber auch geringfügig von dem Schwellwert entfernt sein kann, jedoch höchstens um einen vorgegebenen Wert oberhalb dieses liegen darf. Für die nächsten beiden Abtastpunkte 2 und 1 wird dann der Faktor k berechnet, konkret, indem der Abtast-, insbesondere Amplituden-Wert des zweiten durch denjenigen des ersten divividiert, also $a_2/a_1$ ($a(2T)/a(T)$) gebildet wird. In der vorstehenden, rein beispielhaften Tabelle wurde für die Zeit $t$ der Abtastpunkt 0 als 0 belegt, Werte der Abtastpunkte 1 und 2 wurden vom Schwellwert Pegel genommen.

Somit kann, wenn ein Referenzpuls zur Verfügung steht, bei dem ein Abtastpunkt nahezu oder genau mit dem Schwellwert zusammenfällt, k einfach unter Nutzung insbesondere der folgenden beiden Abtastpunkte bestimmt wedren, wobei dann nur der Quotient aus deren (um den Basislinien-Wert bereinigten) Sampling- bzw. Amplitudenwerte zu bilden ist.

Was die Bestimmung der Pulsform bzw. der Form der steigenden Flanke der Pulse angeht, deren Ankunftszeit zu ermitteln ist, stehen unterschiedliche Möglichkeiten zur Verfügung.

Diese kann insbesondere durch Berücksichtigung der verwendeten Sensoren für die Strahlungsmessung und/oder Pulsformer, also Shaper, erfolgen. Es ist möglich, dass die Bestimmung durch einen Benutzer erfolgt, der beispielsweise eine verwendeten experimentellen Aufbau kennt, und daher weiß, welche Pulsform zu erwarten ist. Dann kann auch durch den Benutzer entschieden werden, welche Gleichung bzw. Gleichungsparameter c und k entsprechend für die $\Delta t$-Berechnung herangezogen werden.

Auch ist es möglich, dass eine automatische Bestimmung der Form des bzw. der Signalpulse bzw. der Form der steigenden Flanke des bzw. der Signalpulse erfolgt. Dies zwekmäßiger Weise vor der (erstmaligen) Berechnung der Differenz zwischen dem Zeitpunkt des ersten Samples des digitalisierten Signalpulses und der Ankunftszeit des Signalpulses.

Eine automatische Bestimmung und Auswahl der Gleichung bzw. Parameter c und k ist selbstverständlich auch möglich. Beispielsweise kann auch vorgesehen sein, dass eine Information über die Puls- bzw. Anstiegsflanken-Form entgegengenommen wird oder eine automatische Bestimmung der Form der steigenden Flanke erfolgt, und in Abhängigkeit dieser Information bzw. der automatischen Bestimmung automatisch die zugehörige Gleichung bzw. die zugehörigen Gleichungsparameter gewählt werden.

Eine automatische Bestimmung der Form der steigenden Flanke kann beispielsweise erfolgen, indem die Differenz zwischen dem Abtast-, insbesondere Amplituden-Wert zweier aufeinanderfolgender Abtastpunkte wenigstens eines digitalisierten Referenzpulses mit einer früheren Differenz zwischen dem Abtast-, insbesondere Amplituden-Wert zweier aufeinanderfolgender Abtastpunkte des Referenzpulses verglichen wird, und für den Fall, dass die Differenz gleich ist, ein zumindest im Wesentlichen linearer, insbesondere ein linearer Anstieg angenommen wird, und für den Fall, dass die Differenz der späteren Abtastpunkte kleiner als die der früheren ist, ein nichtlinearer Anstieg ohne Wendepunkt angenommen wird, und für den Fall, dass die Differenz der späteren Abtastpunkte größer als die der früheren ist, ein S-ähnlicher nichtlinearer Anstieg mit wenigstens einem Wendepunkt angenommen wird. Beispielsweise können drei aufeinanderfolgende Abtastpunkte/Samples eines digitalisierten Signalpulses, insbesondere ein (aller)erster, ein zweiter und ein dritter Abtastpunkt betrachtet werden, und die Differenz zwischen dem dritten und zweiten Abtastpunkt, und die Differenz zwischen dem zweiten und ersten Abtastpunkt als frühere Differenz gebildet werden, und die erhaltene frühere Differenz mit der späteren verglichen werden.

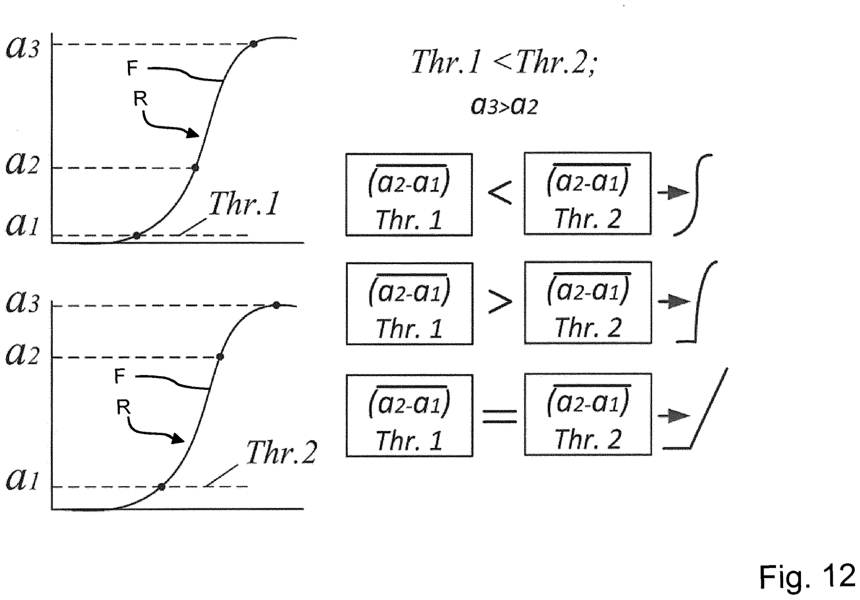

Auch ist es möglich, dass die automatische Bestimmung der Form der steigenden Flanke erfolgt, indem zwei Referenzpulse abgetastet werden, wobei für den einen Referenzpuls ein niedrigerer Schwellwert und für den anderen Referenzpuls ein höherer Schwellwert angesetzt wird, und für beide Referenzpulse die Differenz zwischen dem Abtast-, insbesondere Amplituden-Wert eines zweiten und ersten Abtastpunktes des Referenzpulses gebildet wird, und die Differenzen miteinander verglichen werden, und für den Fall, dass die Differenz gleich ist, ein zumindest im Wesentlichen linearer, insbesondere ein linearer Anstieg angenommen wird, und für den Fall, dass die zu dem niedrigeren Schwellwert gehörige Differenz größer ist als die zu dem höheren Schwellwert gehörige Differenz, ein nichtlinearer Anstieg ohne Wendepunkt angenommen wird, und für den Fall, dass die zu dem niedrigeren Schwellwert gehörige Differenz kleiner ist als die zu dem höheren Schwellwert gehörige Differenz, ein S-ähnlicher nichtlinearer Anstieg mit wenigstens einem Wendepunkt angenommen wird. Dies ist in der Figur 12 veranschaulicht. In den beiden Graphen sind zwei digitalisierte Referenzpulse R gleicher Form dargestellt, für deren Abtastung unterschiedliche Schwellwerte angesetzt wurden, konkret ein niedrigerer Schwellwert Thr. 1 für den oberen und ein höherer Schwellwert Thr. 2 für den unteren Referenzpuls R. Somit gilt Thr.1 < Thr. 2. Rechts neben den beiden Graphen sind die drei Bedingungen für die Differenz zwischen $a_2$ und $a_1$ dargestellt und daneben ist die resultierende Form der steigenden Flanke skizziert, wobei oben der nichtlineare Fall mit Wendepunkt (S-ähnlich), in der Mitte der nichtlineare Fall ohne Wendepunkt und unten der lineare Anstieg dargestellt sind. Bevorzugt werden mehrere Referenzpulse R betrachtet, für alle jeweils die Differenzen gebildet und die Werte gemittelt, um repräsentative Ergebnisse zu erhalten und Abweichungen auszugleichen, was in der Figur 12 durch den Strich oberhalb von $a_2$-$a_1$ angedeutet ist.

Für eine automatische Bestimmung der Form der steigenden Flanke werden bevorzugt einer oder mehrere Referenzpulse herangezogen, die von dem gleichen Aufbau stammen, wie der oder die Pulse, deren Zeit-Offset dann zu ermitteln ist, und die bevorzugt mit einer hohen Abtastrate, insbesondere der bei einem gegebenen Aufbau größtmöglichen Abtastrate digitalisiert werden bzw. wurden. Zum Erhalt der größtmöglichen Abtastrate kann auch das sogenannte Interleaving genutzt werden. Bei dieser Methode wird das gleiche Eingangssignal von zwei Kanälen mit gleicher Abtastrate abgetastet, wobei der Takt des einen Kanals um 180 Grad verschoben zum Takt des anderen Kanals ist. Dies verdoppelt die Abtastrate.

Weiterhin kann vorgesehen sein, dass die Dauer der steigenden Flanke insbesondere automatisch abgeschätzt wird, wobei die automatische Abschätzung bevorzugt über die Bestimmung der Anzahl derjenigen Abtastpunkte eines digitalisierten Referenzpulses erfolgt, für die gilt, dass der Abtast-, insbesondere Amplituden-Wert eines jeweils nachfolgenden Abtastpunktes größer ist als der Abtast-, insbesondere Amplituden-Wert des jeweils vorangegangenen Abtastpunktes. Besonders bevorzugt erfolgt eine Abschätzung der Dauer der steigenden Flanke für ein Mehrzahl von Referenzpulsen und es wird insbesondere der Mittelwert gebildet und als durchschnittliche Dauer angenommen. Dann kann insbesondere aus der Anzahl aufeinanderfolgender Abtastpunkte mit wachsender Amplitude und der Abtastperiode die Dauer abgeschätzt werden.

Eine Abschätzung der Dauer der steigenden Flanke erfolgt zweckmäßiger Weise vor der ersten Berechnung eines Zeit-Offsets $\Delta t$ insbesondere für einen gegebenen Aufbau, und kann immer dann wiederholt werden, wenn sich die Messbedingungen ändern.

Bevorzugt werden auch für die Bestimmung der Dauer der steigenden Flanke mehrere Referenzpulse betrachtet und die Ergebnisse gemittelt, um repräsentative Ergebnisse zu erhalten und Abweichungen auszugleichen.

Alternativ oder zusätzlich kann vorgesehen sein, dass die Dauer des Signalpulses im Bereich von 1 bis 150 Nanosekunden, bevorzugt im Bereich von 1 bis 70 Nanosekunden liegt.

Der digitalisierte Signalpuls, dessen Ankunftszeit unter Durchführung des erfindungsgemäßen Verfahrens bestimmt wird, kann insbesondere ein Sensorsignal, etwa einen Sensorpuls einer physikalischen Messeinrichtung, bevorzugt eines Strahlendetektors repräsentieren. Dann kann als Form für die steigende Flanke des Pulses beispielsweise ein nichtlinearer Anstieg ohne Wendepunkt für den Fall gewählt werden, dass der Puls eine insbesondere rauschfreie und/oder mittels eines Pulsformers (engl. Shapers) geformte Gammastrahlungs-Antwort eines Strahlendetektors, insbesondere eines mit einem Cerium dotierten Lutetium Yttrium Orthosilicat (LYSO) Szintillator gekoppelten Silizium-Photovervielfachers (SiPM), repräsentiert. Als Form für die steigende Flanke des Pulses kann ein S-ähnlicher nichtlinearer Anstieg mit Wendepunkt zum Beispiel für den Fall gewählt werden, dass der Puls eine insbesondere mittels eines Pulsformers/Shapers geformte Einzel-Cluster-Antwort auf $^{55}$Fe-Bestrahlung repräsentiert.

Die vorstehende Aufgabe wird darüber hinaus gelöst durch eine Auswerteeinheit zur Bestimmung einer Ankunftszeit von eine physikalische Messgröße repräsentierenden digitalisierten Signalpulsen, die ausgebildet und/oder eingerichtet ist, um

- eine Differenz zwischen dem Zeitpunkt eines ersten Abtastpunktes eines digitalisierten Signalpulses und einer Ankunftszeit des Signalpulses über die Gleichung

$$\Delta t = T \frac{ka_1}{a_2 - cka_1}$$

zu berechnen, wobei T die Abtastperiode darstellt, mit welcher der digitalisierte Signalpuls abgetastet ist, und $a_1$ der Abtast-, insbesondere Amplituden-Wert eines ersten Abtastpunktes $s_1$ und $a_2$ der Abtast-, insbesondere Amplituden-Wert eines zweiten, späteren Abtastpunktes $s_2$ des digitalisierten Signalpulses, wobei $s_1$ und $s_2$ bevorzugt die allerersten beiden Abtastpunkte des Signalpulses sind, und um

- unter Berücksichtigung des erhaltenen Wertes für $\Delta t$ eine Ankunftszeit des Signalpulses zu berechnen, insbesondere über die Gleichung

$$t_m = t_1 - \Delta t,$$

wobei $t_1$ der Zeitpunkt des ersten Abtastpunktes $s_1$ des Signalpulses (P) ist,

wobei die Auswerteeinheit entweder derart ausgebildet und/oder eingerichtet ist, dass in der Gleichung für $\Delta t$ k = exp(-T/$\tau$) oder k=a(2T)/2a(T), wobei a(2T) und a(T) die Abtast-, insbesondere Amplituden-Werte eines dritten und zweiten Abtastpunktes eines digitalisierten Referenzpulses sind, bei dem der Abtast-, insbesondere Amplituden-Wert eines ersten Abtastpunktes auf der steigenden Flanke einem für die Digitalisierung des Referenzpulses angesetzten Schwellwert entspricht oder höchstens um einen vorgegebenen Wert oberhalb des Schwellwertes liegt, und c =1 ist,

oder die Auswerteeinheit derart ausgebildet und/oder eingerichtet ist, dass in der Gleichung für $\Delta t$ k = $m$ exp(-T/$\tau$) mit 3,30 $\leq$ m $\leq$ 4,0, insbesondere 3,50 $\leq$ m $\leq$ 3,90, bevorzugt 3,58 $\leq$ m $\leq$ 3,80, oder k=a(2T)/a(T), wobei a(2T) und a(T) die Abtast-, insbesondere Amplituden-Werte eines dritten und zweiten Abtastpunktes auf der steigenden Flanke eines digitalisierten Referenzpulses sind, bei dem der Abtast-, insbesondere Amplituden-Werte eines ersten Abtastpunktes auf der steigenden Flanke einem für die Digitalisierung des Referenzpulses angesetzten Schwellwert entspricht oder höchstens um einen vorgegebenen Wert oberhalb des Schwellwertes liegt, und c = 0 ist,

oder die Auswerteinheit ausgebildet und/oder eingerichtet ist, um eine Information über die Form der steigenden Flanke des Signalpulses entgegenzunehmen, die ausgewählt ist aus der Gruppe umfassend

- einen zumindest im Wesentlichen linearen Anstieg,
- einen nichtlinearen Anstieg ohne Wendepunkt und
- einen S-ähnlichen nichtlinearen Anstieg mit wenigstens einem Wendepunkt,

und für den Fall, dass die steigende Flanke des Signalpulses sich durch einen zumindest im Wesentlichen linearen Anstieg auszeichnet, k=1 und c=1 zu verwenden,

und für den Fall, dass die steigende Flanke des Signalpulses sich durch einen nichtlinear Anstieg ohne Wendepunkt (pi) auszeichnet, k = exp(-T/$\tau$) oder k=a(2T)/2a(T), wobei $\tau$ eine die Puls-Peakzeit spezifizierende Zeitkonstante ist und a(2T) und a(T) die Abtast-, insbesondere Amplituden-Werte eines dritten und zweiten Abtastpunktes eines digitalisierten Referenzpulses sind, bei dem der Abtast-, insbesondere Amplituden-Wert eines ersten Abtastpunktes auf der steigenden Flanke einem für die Digitalisierung des Referenzpulses angesetzten Schwellwert entspricht oder höchstens um einen vorgegebenen Wert oberhalb des Schwellwertes liegt, und c =1 zu verwenden, und für den Fall, dass die steigende Flanke des Signalpulses sich durch einen S-ähnlichen nichtlinearen Anstieg mit wenigstens einem Wendepunkt auszeichnet, $k = m\exp(-T/\tau)$ mit $3{,}30 \leq m \leq 4{,}0$, insbesondere $3{,}50 \leq m \leq 3{,}90$, bevorzugt $3{,}58 \leq m \leq 3{,}80$, oder k=a(2T)/a(T), wobei a(2T) und a(T) die Abtast-, insbesondere Amplituden-Werte eines dritten und zweiten Abtastpunktes auf der steigenden Flanke eines digitalisierten Referenzpulses sind, bei dem der Abtast-, insbesondere Amplituden-Wert eines ersten Abtastpunktes auf der steigenden Flanke einem für die Digitalisierung des Referenzpulses angesetzten Schwellwert entspricht oder höchstens um einen vorgegebenen Wert oberhalb des Schwellwertes liegt, und c = 0 zu verwenden.

Eine solche Auswerteeinheit ist zur Durchführung des erfindungsgemäßen Verfahrens besonders geeignet.

In besonders bevorzugter Ausgestaltung der erfindungsgemäßen Auswerteeinheit ist vorgesehen, dass diese durch wenigstens ein, bevorzugt genau ein Field Programmable Gate Array, also ein feldprogrammierbares Gatter-Array, gegeben ist oder ein solches umfasst, und/oder dass die Auswerteeinheit einen Bestandteil einer anwendungsspezifischen integrierten Schaltung (abgekürzt ASIC) bildet oder eine solche umfasst. FPGAs bzw. ASICs haben sich als besonders geeignet für eine Implementierung der erfindungsgemäßen Puls-Ankunftszeit-Bestimmmung erwiesen. Diese können auf vergleichweise einfache Weise programmiert bzw. eingerichtet werden und stellen in der Regel kompakte Komponenten dar.

Insbesondere für den Fall, dass die Auswerteinheit in Form einer anwendungsspezifischen integrierten Schaltung (ASIC) gegeben ist, oder einen Bestandteil einer solche bildet, ist die Auswerteinheit bevorzugt ausgebildet und/oder eingerichtet, um eine Information über die Form der steigenden Flanke des oder der Signalpulse, dessen bzw. deren (angenommene) Ankunftszeit zu bestimmen ist, entgegenzunehmen, und kann die Auswerteeinheit für alle drei Fälle von Pulsformen die entsprechende, erfindungsgemäße Auswertung mit der zugehörigen Gleichung bzw. den zugehörigen Gleichungsparametern c und k durchführen. Die Auswerteeinheit ist dann entsprechend ausgebildet und/oder eingerichtet, um alle drei Fälle abzudecken.

Kommt hingegen ein FPGA als Auswerteeinheit zum Einsatz bzw. umfasst die Auswerteeinheit ein FPGA, und steht die Form des bzw. der auszuwertenden Pulse fest, kann - insbesondere, um logische Zellen zu sparen - die Auswerteeinheit bzw. das FPGA auch gezielt nur für eine der drei Puls-formen ausgebildet und/oder eingerichtet sein, insbesondere nur für den nichtlinearen Anstiegs-Fall ohne oder mit Wendepunkt.

Insbesondere in Kombination mit einer langsamen Signalformung (englisch: shaping) etwa mit Dauern der steigenden Flanke im Bereich zwischen 40 und 10 ns und einer niedrigen Abtastrate, etwa im Bereich von 50 bis 200 MSPS (Mega-Samples pro Sekunde, englisch: mega samples per second) kann eine sehr niedrige Gesmtleistungsaufnahme der kompletten Analog-/Abtast-/Verabreitungs-Kette erreicht werden. Für Abtatsraten unterhalb von 100 MSPS können Zeitauflösungen besser als 100 ps bei einer Leistungsaufnahme von nur 100 mW pro Kanal erzielt werden. Dies erlaubt es, hunderte von Kanälen innerhalb einer einzigen Auswerteeinheit, insbesondere eines einzigen, typischen FPGA-Chips (der insbesondere die digitale Verarbeitungskette bzw. einen Teil dieser bildet) oder innerhalb einer anwendungsspezifischen integrierten Schaltung (ASIC), die bevorzugt die gesamte Analog-/Abtast-/Verarbeitungs-Kette umfasst, zu verarbeiten.

In Weiterbildung zeichnet sich die erfindungsgemäße Auswerteeinheit durch eine Mehrkanal-Konfiguration mit insbesondere mehr als 100 Kanälen aus.

Eine weitere bevorzugte Ausführungsform zeichnet sich dadurch aus, dass die Auswerteeinheit wenigstens ein, bevorzugt genau ein Additions-Modul und/oder wenigstens ein, bevorzugt genau ein Subtraktions-Modul und/oder wenigstens ein, bevorzugt genau ein Divisions-Modul umfasst. U.a. mit diesen Modulen lässt sich die erfindungsgemäße

$$\Delta t = T \frac{ka_1}{a_2 - cka_1}$$

Gleichung                        mit verschiednenen Parametern c und k einfach implementieren. Ein Additions-Modul kommt dabei bevorzugt zum Einsatz, um durch Addtion von Vielfachen und/oder Bruchteilen eines $a_1$ einen gewünschten Wert für ka1 zu erhalten. Ein Subtraktions-Modul kommt bevorzugt zum Einsatz, um die Subtraktion im Ausdruck $a_2 - cka_1$ zu implementieren. Ein Divisions-Modul kommt bevorzugt zur Implementierung der Division in dem Ausdruck $ka_1/(a_2-cka_1)$ zum Einsatz.

Die Auswerteeinheit kann weiterhin ausgebildet und/oder eingerichtet sein, um die Form der steigenden Flanke automatisch zu bestimmen. Dann ist sie in Weiterbildung bevorzugt ausgebildet und/oder eingerichtet, um die vorstehend im Zusammenhang mit dem erfindungsgemäßen Verfahren erläuterten Schritte für die automatische Bestimmung durchzuführen.

Schließlich kann die erfindungsgemäße Auswerteeinheit ausgebildet und/oder eingerichtet sein, um die Dauer der steigenden Flanke automatisch abzuschätzen. Dann ist sie in Weiterbildung bevorzugt ausgebildet und/oder eingerichtet, um die vorstehend im Zusammenhang mit dem erfindungsgemäßen Verfahren erläuterten Schritte für die automatische Abschätzung durchzuführen.

Ein weiterer Gegenstand der Erfindung ist eine Vorrichtung zur Bestimmung einer Ankunftszeit von eine physikalische Messgröße repräsentierenden Signalpulsen, umfassend

- wenigstens einen, insbesondere mehrere Eingänge, über die eine physikalische Messgröße repräsentierende Signalpulse entgegengenommen werden können,
- wenigstens einen, insbesondere mehrere dem oder den Eingängen nachgeordnete Analog-Digital-Wandler, über welche entgegengenommene Signalpulse insbesondere mit einer vorgegebenen oder vorgebbaren Abtastperiode abgetastet und digitalisiert werden können,
- wenigstens eine dem oder den Analog-Digital-Wandlern nachgeordnete Auswerteeinheit gemäß der vorliegenden Erfindung.

Eine solche Vorrichtung hat sich als besonders geeignet zur Durchführung des erfindungsgemäßen Verfahrens erwiesen.

Die erfindungsgemäße Vorrichtung umfasst bevorzugt einen oder mehrere Filter und/oder Verstärker, wobei der oder die Filter und/oder Verstärker insbesonder dem oder den Eingängen nachgeordnet und/oder dem oder den Analog-Digital-Wandler vorgeschaltet sind. Ist wenigstens ein FPGA und/oder wenigstens ein ASIC vorgesehen, sind der oder die Filter bevorzugt dem wenigstens einen FPGA vorgeordent bzw. bilden bevorzugt einen Bestandteil wenisgtens eines ASICs.

Weiterhin kann vorgesehen sein, dass sich die die Vorrichtung durch eine Mehrkanal-Konfiguration mit insbesondere mehr als 100 Kanälen auszeichnet, wobei bevorzugt jeder Kanal einen Eingang, einen Analog-Digital-Wandler und insbesondere einen und/oder Verstärker umfasst, oder jedem Kanal ein Eingang, ein Analog-Digital-Wandler und insbesondere ein Filter und/oder Verstärker zugeordnet ist, und die Vorrichtung bevorzugt genau eine erfindungsgemäße Auswerteeinheit umfasst, mit der Signale sämtlicher Kanäle verarbeitbar sind oder verarbeitet werden.

Der oder die Analog-Digital-Wandler der erfindungsgemäßen Vorrichtung sind ferner bevorzugt als Pipelined-Analog-Digital-Wandler (ins Deutsche übersetzt: Fließband-Analog-Digital-Wandler) ausgebildet.

Ein weiterer Gegenstand der Erfindung ist ein Auswertesystem umfassend zwei oder mehr erfindungsgemäße Vorrichtungen zur Bestimmung der Ankunftszeit von eine physikalische Messgröße repräsentierenden Signalpulsen.

Schließlich ist Gegenstand der Erfindung ein Strahlendetektionssystem, umfassend einen oder mehrere Sensoren zur direkten oder indirekten Strahlendetektion und eine oder mehrere mit diesem oder diesen gekoppelte oder koppelbare erfindungsgemäße Vorrichtungen zur Bestimmung der Ankunftszeit von eine physikalische Messgröße repräsentierenden Signalpulsen, wobei der oder die Sensoren zur Strahlendetektion bevorzugt durch Photodetektoren und/oder Straw Rohre und/oder Silizium-Photovervielfacher (SiPM) und/oder Gasdetektoren gegeben sind oder solche umfassen.

Ein erfindungsgemäßes Strahlendetektionssystem umfasst bevorzugt eine Mehrzahl von Sensoren zur direkten oder indirekten Strahlendetektion (z.B. Photodetektoren, Straw Tubes oder dergleichen), die insbesondere mit einem Nyquist-Filter gekoppelt sind, sowie mehrere frei laufende Analog-Digital-Wandler und wenigstens eine Auswerte- bzw. Verarbeitungseinheit (englisch: processing unit), die ausgebildet und/oder eingerichtet ist, Ereignisse und/oder Energien und/oder Ankunftszeitmarkierungen an einen lokalen Computer in Echtzeit zu liefern.

Optional können weitere fortgeschrittene Funktionen, wie etwa die Suche für die Koinzidenz, in Echtzeit realisiert sein bzw. werden. Die Data Acquisition kann insbesondere unter Verwendung einer diskreten Elektronik oder ASICs mit konfigurierbaren Filtern und Verarbeitungsparametern implementiert sein.

Es sei angemerkt, dass im Rahmen des erfindungsgemäßen Verfahrens zweckmäßiger Weise in an sich bekannter Weise eine Bestimmung der Basislinie erfolgt, dies bevorzugt für jeden Signalpuls, dessen Ankunftszeit zu ermitteln ist. Die Basislinienbestimmung kann beispielsweise kontinuierlich oder periodisch, insbesondere aus Abtastpunkten bzw. zugehörigen Werten, ermittelt werden, also online "mitlaufen". Zur Bestimmung der Basislinie kann, wie beispielsweise auf den Seiten 220 bis 221 von Referenz [10] beschrieben, der Mittelwert mehrerer, etwa acht Abtastpunkte, also Samples, die vor dem Signalpuls liegen, gebildet werden.

Auch ist es möglich, einen sogenannten Medianfilter zu verwenden, der keinen Mittelwert bildet, sondern von mehreren Werten den mittlerer Größe ausgibt, beispielsweise von den Werten 20, 100 und 500 den Wert 100 liefern würde (Rang-3-Medianfilter, da drei Werte betrachtet werden), oder von den Werten 3, 8, 12, 17, 19 den Wert 12 (Rang-5-Medianfilter). Medianfilter sind ebenfalls hinlänglich aus dem Stand der Technik vorbekannt. Ein großer Vorteil eines Medianfilters besteht darin, dass er niedrige Amplituden und hochfrequentes Rauschen herausfiltert und gleichzeitig die ansteigende Flanke digitalisierter Pulse erhalten kann. Somit steht ein rauschfreies bzw. - reduziertes Signal zur Verfügung.

Im Rahmen des erfindungsgemäßen Verfahrens wird die Basislinie des bzw. der betrachteten Signalpulse daher bevorzugt unter Verwendung wenigstens eines Medianfilters ermittelt. Die erfindungsgemäße Auswerteeinheit bzw. die erfindungsgemäße Vorrichtung bzw. das erfindungsgemäße System umfassen entsprechend bevorzugt wenigstens einen Medianfilter für die Basislinienbestimmung. Als besonders geeignet hat sich ein Rang-3-Medianfilter erwiesen. Für die Berechnung der Basislinie wird bevorzugt der letzte (herausgefilterte) Abtastpunkt vor dem Anstieg des Signalpulses verwendet. Dieser Wert kann als Basislinien-Wert verwendet und von den Signalwerten abgezogen werden, um ein Null-Level für die Ankunftszeit- und andere Berechnungen zu erhalten. Die Sampling- bzw. Amplitudenwerte von Abtastpunkten, die im Rahmen der vorliegenden Erfindung betrachtet bzw. herangezogen werden, sind bzw. werden bevorzugt grundsätzlich um die Basislinie bzw. den Basislinien-Wert bereinigt, konkret durch Subtraktion letzteres.

Die erfindungsgemäße Auswerteeinheit, Vorrichtung und das System sind bevorzugt entsprechend ausgebildet und/oder eingerichtet.

Weitere Merkmale und Vorteile der vorliegenden Erfindung werden anhand der nachfolgenden Beschreibung von Ausführungsformen des erfindungsgemäßen Verfahrens und erfindungsgemäßer Systeme unter Bezugnahme auf die beiliegende Zeichnung deutlich. Darin zeigt:

Figur 1 a) Die Vorderflanke von Pulsen, die durch CR-RC-Formungsschaltungen erzeugt werden, wobei die berechnete Pulsstartzeit (Zeitmarke, $t_m$) durch den Schnittpunkt der Grundlinie mit einer durch die ersten zwei Abtastwerte verlaufenden Linie bestimmt wird.

Figur 1 b) Die Vorderflanke von Pulsen, die durch CR-RC$^2$-Formungsschaltungen erzeugt werden, wobei die berechnete Pulsstartzeit (Zeitmarke, $t_m$) durch den Schnittpunkt der Basislinie mit einer durch die ersten zwei Abtastwerte verlaufenden Linie bestimmt wird.

Figur 2 a) den Timing-Fehler $t_e$ gegenüber der Abtastphase für CR-RC-Formung bei unterschiedlichen Abtastraten.

Figur 2 b) den Timing-Fehler $t_e$ gegenüber der Abtastphase für CR-RC$^2$-Formung bei unterschiedlichen Abtastraten.

Figur 3 a) die Timing-Auflösung gegenüber der Abtastrate für CR-RC-Formung unter Verwendung der LRA-Methode, wobei die Einsätze die durch $Q=T/t_{e,rms}$ definierte Zeitmesseffizienz zeigen.

Figur 3 b) die Timing-Auflösung gegenüber der Abtastrate für CR-RC$^2$-Formung unter Verwendung der LRA-Methode, wobei die Einsätze die durch $Q=T/t_{e,rms}$ definierte Zeitmesseffizienz zeigen, (dito)

Figur 4 die Rausch-begrenzte (SNR von 46 dB) Timing-Auflösung gegenüber der Abtastrate für CR-RC-Formung unter Verwendung der nLRA-Methode, wobei ein Schwellwert von 0,8 % für die Detektion angewendet wurde und der Einsatz die Timing-Effizienz zeigt.

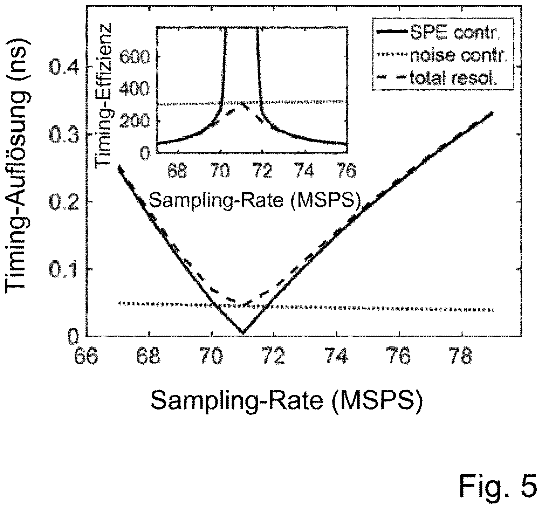

Figur 5 die Timing-Auflösung über der Abtastrate für eine CR-RC-Antwort und k= 0,625, wobei die durchgezogene und die gepunktete Linien den Beitrag durch den SPE und Rauschen mit einem SNR von 46 dB zeigen, die gestrichelten Linien die resultierende Gesamt-Auflösung und der Einsatz die zugehörigen Timing-Effizienzen zeigt.

Figur 6 die Funktion $y = \left( kr + \sqrt{kr} \right) / \left( 1 - kr \right)$ (durchgezogene Linie) und die durch $y_0 = 0.1 + 3.58kr$ gegebene Linearisierung (gestrichelte Linie).

Figur 7 den Timing-Fehler gegenüber der Abtastphase für CR-RC$^2$-Formung bei verschiedenen Abtastraten unter Verwendung der $y_0$-Funktion als Annäherung an die y-Funktion, unabhängig von der Abtastrate, wobei für die Pulsdetektion ein Schwellwert von 0,8 % angewendet worden ist.

Figur 8 die Linearisierungs-begrenzte Timing-Auflösung gegenüber der Abtastrate für CR-RC$^2$-Formung bei verschiedenen Schwellwerten für die Pulsdetektion, wobei der Einsatz die entsprechenden Timing-Effizienzen zeigt.

Figur 9 die Timing-Auflösung gegenüber der Abtastrate für eine CR-RC$^2$-Antwort, wobei der angewendete Schwellwert 0,8 % des Signal-Peak-Wertes ist und die durchgezogenen und gepunkteten Linien Beiträge des SPE und von weißem Rauschen mit einem SNR von 46 dB zeigen, und die gestrichelte Linie die resultierende Gesamt-Zeit-Auflösung und die Einsätze die entsprechenden Timing-Effizienzen.

Figur 10 die Timing-Auflösung gegenüber der Abtastrate für eine CR-RC$^2$-Antwort unter Verwendung der LRA-Methode (Kreise) und der nLRA-Methode (Dreiecke, Sterne), wobei die Simulation für einen rauschfreien Setup und unter Verwendung eines Schwellwertes von 0,8 % für die Pulsdetektion durchgeführt wurde.

Figur 11 einen Signalpuls, bei dem das allererste, mit 0 bezeichnete Sample mit dem für die Digitalisierung angesetzten Schwellwert zusammenfällt.

Figur 12 zwei digitalisierte Signalpulse gleicher Form, für die bei der Abtastung verschiedene Schwellwerte zugrunde gelegt wurde, und drei Bedingungen für die Bestimmung der Form der steigenden Flanke der Pulse.

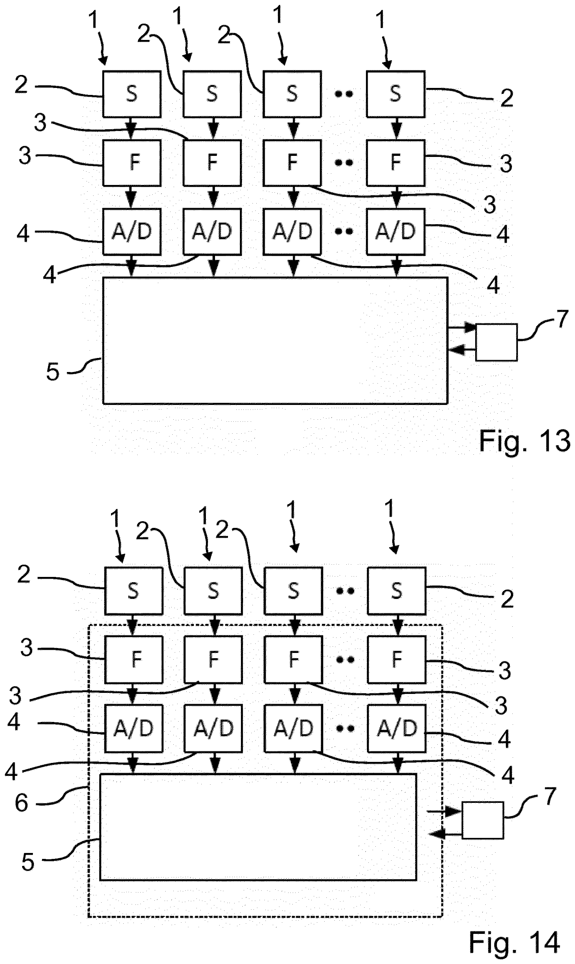

Figur 13 ein Ausführungsbeispiel eines erfindungsgemäßen Strahlendetektionssystems mit einem FPGA als Auswerteeinheit.

Figur 14 ein weiteres Ausführungsbeispiel eines erfindungsgemäßen Strahlendetektionssystems mit einem ASIC.

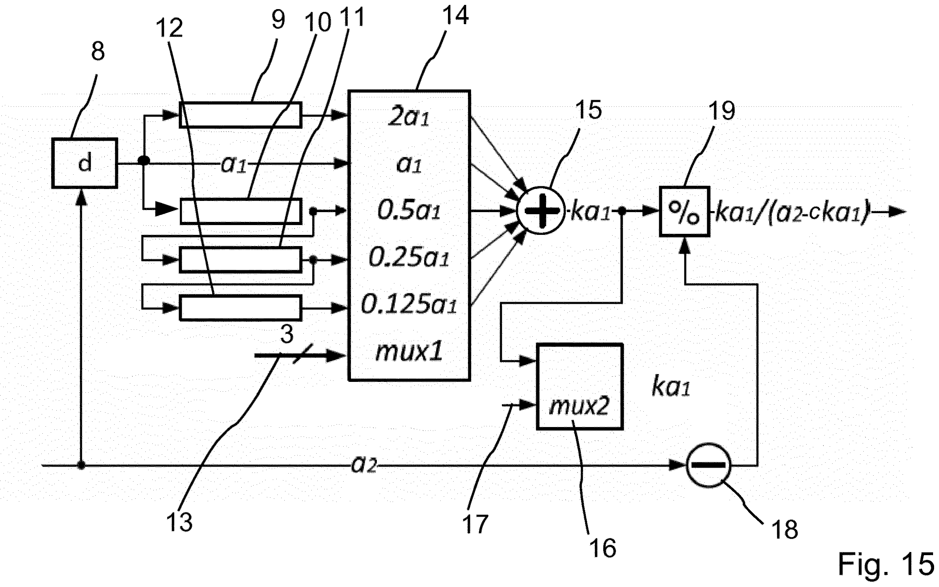

Figur 15 ein Ausführungsbeispiel für eine Auswerteeinheit in rein schematischer Darstellung.

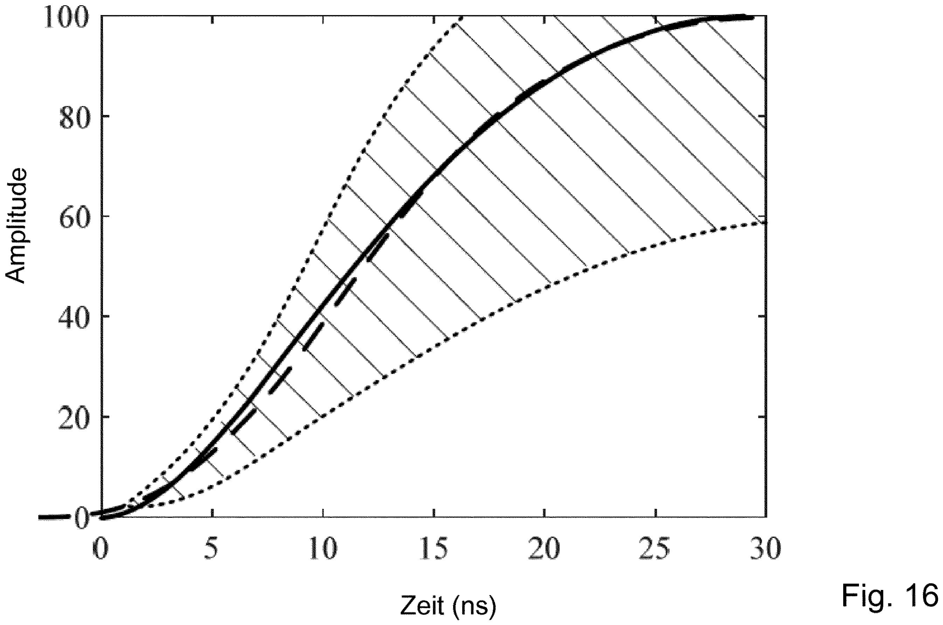

Figur 16 eine übliche Pulsform (durchgezogene Linie) und seine Annäherung (gestrichelte Linie) durch Gleichung (1) mit n=2, wobei das schraffierte Band die Abweichung von durchschnittlichen Werten zeigt.

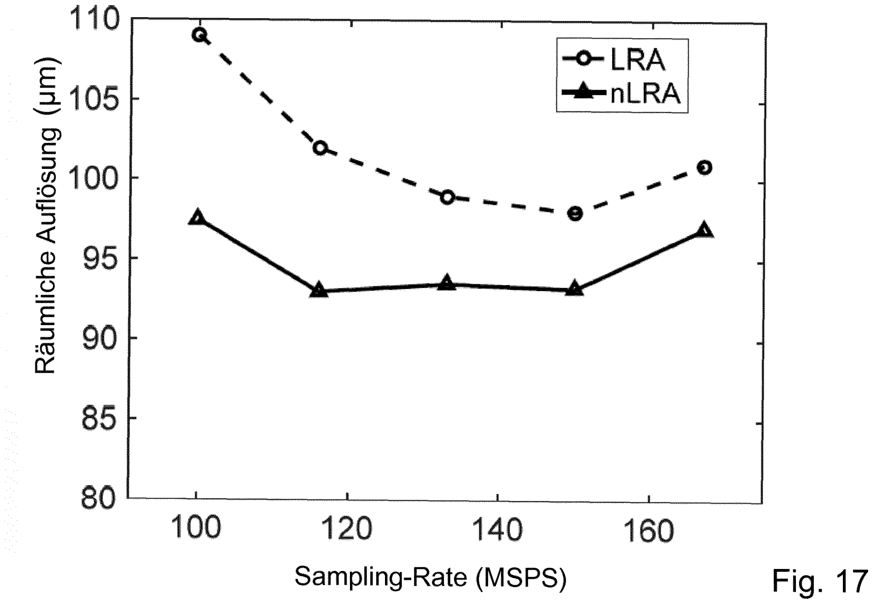

Figur 17 die räumliche Auflösung gegenüber der Abtastrate, experimentelle Ergebnisse in einem STT, wobei der Abtastraten-Bereich von 100 bis 166 MSPS optimal für die STT Pulsform ist, in diesem Bereich keine starke Abhängigkeit der Auflösung von der Abtastrate vorliegt.

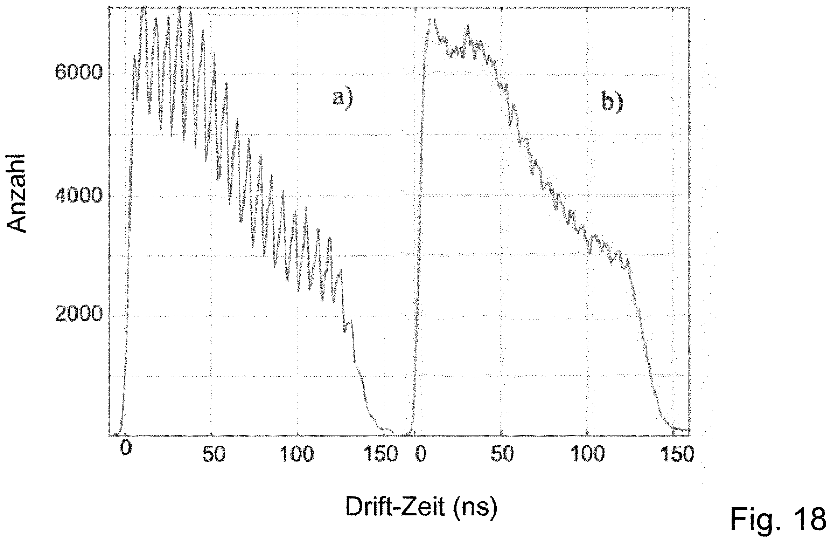

Figur 18 ein Ankunftszeit- (Drift-Zeit-) Histogramm bei einer 150 MSPS Abtastrate unter Verwendung der linearen und nichtlinearen Anstiegsannäherung (LRA und nLRA), genau wie in Figur 17 für eine S-ähnliche Pulsform und das gleiche Experiment gemäß Figur 17.

Die Figuren 1 bis 12 zeigen Graphen, die bereits vorstehend im Einzelnen erläutert wurden.

Die Figuren 13 und 14 zeigen jeweils in rein schematischer Darstellung ein Ausführungsbeispiel eines erfindungsgemäßen Strahlendetektionssystems.

Beide Ausführungsbeispiele zeichnen sich durch eine Mehrkanal-Konfiguration aus. Konkret umfasst das System gemäß beiden Ausführungsformen jeweils 160 Kanäle 1. In den Figuren 13 und 14 sind von den 160 Kanälen jeweils nur vier Stück exemplarisch gezeigt, wobei die Punkte zwischen dem dritten und vierten Kanal 1 von links andeuten, dass weitere Kanäle 1 vorhanden sind.

Jeder der 160 Kanäle 1 umfasst bzw. jedem Kanal 1 ist einen Sensor 2 zur direkten oder indirekten Detektion von Strahlung zugeordnet, bei denen es sich vorliegend um Photodetektoren handelt. Selbstverständlich können alternativ zu Photodetektoren als Sensoren 2 beispielsweise auch Straw-Rohren, Gasdetektoren oder dergleichen zum Einsatz kommen. Weiterhin umfasst jeder Kanal 1 bzw. ist jedem Kanal 1 ein dem jeweiligen Sensor 2 nachgeordneter, mit dem jeweiligen Sensor 2 gekoppelten Nyquist-Filter 3, welche vorliegend jeweils einen Shaper und Verstärker umfassen bzw. durch diese gebildet werden, zugeordnet sowie ein freilaufender (englisch: pipelined) Analog-Digital-Wandler 4. Bei den ACDs handelt es sich vorliegend um Pipelined 12-bit ADCs 4, die bei einer variierbaren Abtastrate im Bereich 100 bis 166 MSPS arbeiten.

Darüber hinaus weist jedes der beiden Systeme eine Verarbeitungs- bzw. Auswerteeinheit 5 (englisch: processing unit) auf. Bei dem Ausführungsbeispiel gemäß Figur 13 ist diese in Form eines feldprogrammiebaren Gate Arrays (FPGAs) 5 gegeben und bei den Ausführungsbeispiel gemäß Figur 14 bildet diese einen Teil einer sogenannten anwendungsspezifischen integrierten Schaltung, also eines ASICs 6. Bei dem zweiten Ausführungsbeispiel bilden die Filter 3 und ADCs 4 sämtlicher Kanäle 1 ebenfalls einen Teil des ASICs 6 bzw. sind auf diesem implementiert. Die Auswerteeinheiten 5 stellen Ausführungsbeispiele von Auswerteeinheiten gemäß der vorliegenden Erfindung dar.

Das FPGA 5 des Ausführungsbeispiels gemäß Figur 13 stellt eine diskrete Elektronik dar. Bei dem Ausführungsbeispiel nach Figur 14 sind die Filter 3 und Verarbeitungsparameter der Auswerteeinheit 5 konfigurierbar, worauf noch näher eingegangen wird.

Pfeile, welche jeweils den Sensor 2, den Filter 3, den ADC 4 und die Auswerteeinheit 5 verbinden, stellen die Signalweitergabe schematisch dar.

Die Auswerteinheit 5, Filter 2 und/oder ACDs können auf einer in den rein schematischen Figuren nicht dargestellten Platine angeordnet sein.

Es sei angemerkt, dass bei den Systemen gemäß den Figuren 13 und 14 jeweils die Filter 3, die ADCs 4 und die Auswerteeinheit 5 Bestandteil eines Ausführungsbeispiels einer erfindungsgemäßen Vorrichtung zur Bestimmung der Ankunftszeit von eine physikalische Messgröße repräsentierenden Signalpulsen sind bzw. jeweils eine solche bilden. Im Falle von Figur 12 ist entsprechend das ASIC 6 Bestandteil eines Ausführungsbeispiels einer solchen bzw. bildet ein Ausführungsbeispiel einer erfindungsgemäßen Vorrichtung.

Die Auswerteeinheiten 5 der in den Figuren 13 und 14 gezeigten Systeme sind jeweils mit einem externen PC 7 verbunden und liefern im Betrieb an diesen Daten, insbesondere Ereignisse und/oder Energien und/oder Ankunftszeiten bzw. Ankunftszeitmarkierungen, in Echtzeit. Optional können weitere fortgeschrittene Funktionen, wie etwa die Suche für die Koinzidenz, in Echtzeit realisiert sein bzw. werden.

Ein Ausführungsbeispiel für eine Auswerteeinheit 5 ist in Figur 15 rein schematisch gezeigt. Diese umfasste ein mit "d" bezeichnetes Modul 8, das eine Einzeltaktverzögerung (englisch: single clock delay) implementiert, um den ersten Abtastpunkt $s_1$ mit einer Signalhöhe bzw. Amplitude $a_1$ und den zweiten Abtastpunkt $s_2$ mit einer Signalhöhe bzw. Amplitude $a_2$ auf der steigenden Flanke F eines Signalpulses P (vergleiche zu den beiden allerersten Abtastpunkten $s_1$, $s_2$ auf der steigenden Flanke F eines Signalpulses P die vorstehend diskutierte Figur 1) von dem Abtast-Datenstrom zu erhalten.

Die Module 9 bis 12 sind Niedrig-Ressourcen-Implementierungen des Multiplikationsfaktors 2 (Einheit 9) und Divisionsfaktors 2 (Module 10 bis 12), wobei das Modul 9 bzw. dessen Funktion auch mit "shift left" und die Module 10 bis 12 bzw. deren Funktion auch mit "shift right" bezeichnet werden können.

Über den Pfeil 13 ist angedeutet, dass erforderliche Beiträge für die Realisierung eines eindeutigen Faktors k unter der Kontrolle eines lokalen Computers 7 (nur in Figuren 13 und 14 dargestellt) übergeben werden und die anderen Leitungen in dem Modul 14 auf null gesetzt werden. Wenn beispielsweise k=2,125 benötigt wird, werden die Signale 1 und 5 (von oben), die von den Modulen 9 und 12 kommen, durch das Modul 14 zu dem Additions-Modul 15 durchgegeben, und Signale von Leitungen 2 bis 4 (von oben) werden in Modul 14 auf null gesetzt und weiter als Null-Werte (die von den Modulen 10 und Mux1 stammen) auch zu diesem Modul 15 transferiert. Auf ähnliche Weise gibt das Modul 16 wiederum unter Kontrolle eines lokalen Computers 7 (nur in Figuren 13 und 14 dargestellt), was durch den Pfeil 17 dargestellt ist, $ka_1$ oder ein Null-Wert-Signal an das Subtraktions-Modul 18 aus, wodurch c=0 oder c=1 realisiert wird, und es wird entsprechend entweder $a_2$-0, also $a_2$, oder $a_2$-$ka_1$ an das Divisions-Modul 19 weitergegeben. Diese kann entsprechen als Ausgang $ka_1/(a_2-cka_1)$ mit c=0 oder 1 und verschiedenen Werten für k liefern.

Die komplette in Figur 15 gezeigte Struktur ist nur bei dem Ausführungsbeispiel gemäß Figur 14 implementiert, welches den konfigurierbaren ASIC 6 umfasst. Dieser ist entsprechend geeignet, zusammen mit verschiedenen Strahlungsdetektoren bzw. Sensoren 1, welche unterschiedliche Pulsformen liefern, zum Einsatz zu kommen. Das System gemäß Figur 15 bzw. der ASIC 6 ist ausgebildet, um eine Information über die Form der steigenden Flanke F der auszuwertenden Signalpulse P entgegenzunehmen. Vorliegend kann dies per Benutzereingabe über den PC 7 geschehen.

Bei dem Ausführungsbeispiel gemäß Figur 13 mit einem FPGA ist bevorzugt nur ein Teil der Struktur gemäß Figur 15 programmiert, dies für eine bestimmte Pulsform.

Die erfindungsgemäßen Systeme gemäß den Figuren 13 und 14 sind beide zur Durchführung von Ausführungsbeispielen des erfindungsgemäßen Verfahrens zur Bestimmung der Ankunftszeit eines eine physikalische Messgröße repräsentierenden, digitalisierten Signalpulses P (vgl. Figuren 1 a) und b)) geeignet.

Im Rahmen dieses wird bestimmt, welche Form die steigende Flanke F des Signalpulses P aufweist, wobei die Form ausgewählt wird aus der Gruppe umfassend

- einen zumindest im Wesentlichen linearen Anstieg,
- einen nichtlinearen Anstieg ohne Wendepunkt und
- einen S-ähnlichen nichtlinearen Anstieg mit wenigstens einem Wendepunkt.

In der Figur 1 sind nur die beiden letzteren Pulsformen dargestellt, also ein Puls P mit nichtlinearem Anstieg ohne Wendepunkt (Figur 1 a)) und ein Puls P mit einem S-ähnlichen nichtlinearen Anstieg mit einem Wendepunkt pi (Figur 1 b)).

In allen drei Fällen wird eine Differenz zwischen dem Zeitpunkt $t_1$ des ersten Abtastpunktes $s_1$ des digitalisierten Signalpulses P und einer angenommenen Ankunftszeit $t_m$ des Signalpulses P berechnet über die Gleichung

$$\Delta t = T \frac{ka_1}{a_2 - cka_1},$$

wobei T die Abtastperiode darstellt, mit welcher der digitalisierte Signalpuls P abgetastet ist, und $a_1$ der (um den Basis-

linien-Wert bereinigte) Abtast-, insbesondere Amplituden-Wert eines ersten, früheren Abtastpunktes $s_1$ und $a_2$ der (um den Basislinien-Wert bereinigte) Abtast-, insbesondere Amplituden-Wert eines zweiten, späteren Abtastpunktes $s_2$ des digitalisierten Signalpulses, wobei $s_1$ und $s_2$ die allerersten beiden Samples des Signalpulses P sind.

Für den Fall, dass ein zumindest im Wesentlichen linearer Anstieg als Form der steigenden Flanke F des Pulses P bestimmt wird, wird k =1 und c = 1 gesetzt.

Für den Fall, dass ein nichtlinear Anstieg ohne Wendepunkt pi als Form der steigenden Flanke F des Pulses P bestimmt wird, wird k = exp($-T/\tau$) oder k=a(2T)/2a(T), wobei a(2T) und a(T) die Abtast-, insbesondere Amplituden-Werte eines dritten und zweiten Abtastpunktes eines digitalisierten Referenzpulses R (siehe Figur 11) sind, bei dem der Abtast-, insbesondere Amplituden-Wert eines ersten Abtastpunktes auf der steigenden Flanke F einem für die Digitalisierung des Referenzpulses angesetzten Schwellwert entspricht oder höchstens um einen vorgegebenen Wert oberhalb des Schwellwertes liegt, und c = 1 gesetzt.

Für den Fall, dass ein S-ähnlicher nichtlinearer Anstieg mit wenigstens einem, insbesondere genau einem Wendepunkt pi als Form der steigenden Flanke F des Signalpulses P bestimmt wird, wird $k = m \exp(-T/\tau)$ mit $3{,}30 \leq m \leq 4{,}0$, insbesondere $3{,}50 \leq m \leq 3{,}90$, bevorzugt $3{,}58 \leq m \leq 3{,}80$, oder k=a(2T)/a(T), wobei a(2T) und a(T) die Abtast-, insbesondere Amplituden-Werte eines dritten und zweiten Abtastpunktes auf der steigenden Flanke F eines digitalisierten Referenzpulses R sind, bei dem der Abtast-, insbesondere Amplituden-Wert eines ersten Abtastpunktes auf der steigenden Flanke F einem für die Digitalisierung des Referenzpulses angesetzten Schwellwert entspricht oder höchstens um einen vorgegebenen Wert oberhalb des Schwellwertes liegt, und c = 0 gesetzt, wobei $\tau$ eine die Puls-Peakzeit spezifizierende Zeitkonstante ist.

Das bedeutet, dass

- für den zumindest im Wesentlichen linearen Anstieg die LRA-Methode angewendet wird, mit einer Offset-Berechnung

$$\Delta t = T \frac{a_1}{a_2 - a_1}$$

- für den nichtlinearen Anstieg ohne Wendepunkt die nLRA-Methode angewendet wird, wobei der Offset berechnet wird durch

$$\Delta t = T \frac{k a_1}{a_2 - k a_1}$$

- für den S-ähnlichen nichtlinearen Anstieg die nLRA-Methode verwendet wird, mit einer Offset-Berechnung von

$$\Delta t = T \frac{k a_1}{a_2}$$

Als Form für die steigende Flanke F des Pulses P wird ein nichtlinearer Anstieg ohne Wendepunkt gewählt, wenn die Pulsform durch die Gleichung

$$V(t) = A \left( \frac{t - t_s}{\tau} \right)^n \exp\left( -\frac{t - t_s}{\tau} \right)$$

mit n = 1 beschrieben werden kann, und als Form für die steigende Flanke F des Pulses P wird ein S-ähnlicher nichtlinearer Anstieg mit wenigstens einem, insbesondere genaue einem Wendepunkt für den Fall gewählt, dass die Pulsform durch die Gleichung

$$V(t) = A \left( \frac{t - t_s}{\tau} \right)^n \exp\left( -\frac{t - t_s}{\tau} \right)$$

mit n = 2 beschrieben werden kann, wobei t die Zeit, $t_s$ die Ankunftszeit des Pulses P, A ein amplitudenbezogener Faktor und $\tau$ eine die Puls-Peakzeit spezifizierende Zeitkonstante ist.

$\tau$ ist insbesondere eine Zeitkonstante, die für einen nichtlinearen Anstieg ohne Wendepunkt als Puls-Anstiegszeit und für einen nichtlinearen Anstieg mit Wendepunkt als die Hälfte der Puls-Anstiegszeit angenommen wird.

Die Dauer der steigenden Flanke F kann automatisch abgeschätzt werden, wobei die automatische Abschätzung bevorzugt über die Bestimmung der Anzahl derjenigen ersten Abtastpunkte eines Referenzpulses erfolgt, für die gilt, dass der Abtast-, insbesondere Amplituden-Wert eines jeweils nachfolgenden Abtastpunktes größer ist als der Abtast-, insbesondere Amplituden-Wert des jeweils vorangegangenen Abtastpunktes. Besonders bevorzugt erfolgt eine Abschätzung der Dauer der steigenden Flanke F für ein Mehrzahl von Referenzpulsen und es wird insbesondere der Mittelwert gebildet und als durchschnittliche Dauer angenommen. Dann kann aus der Anzahl aufeinanderfolgender Abtastpunkte mit wachsender Amplitude und der Abtastperiode die Dauer abgeschätzt werden.

k kann auch über a(2T)/a(T) ermittelt bzw. abgeschätzt werden, wenn wenigstens ein Referenzpuls R herangezogen werden kann bzw. wird, bei dem der (aller)erste Abtastpunkt mit dem angesetzten Schwellwert Thr. zusammenfällt, wie vorstehend im Zusammenhang mit Figur 11 im Einzelnen erläutert.

Als Form für die steigende Flanke F des Pulses P wird beispielsweise ein nichtlinearer Anstieg ohne Wendepunkt pi für den Fall gewählt, dass der Puls P eine insbesondere rauschfreie und/oder mittels eines Pulsformers geformte Gammastrahlungs-Antwort eines Strahlendetektors, insbesondere eines mit einem Cerium dotierten Lutetium Yttrium Orthosilicat (LYSO) Szintillator gekoppelten SiPMs, repräsentiert. Als Form die steigende Flanke F des Pulses P kann hingegen ein S-ähnlicher nichtlinearer Anstieg mit Wendepunkt pi insbesondere für den Fall gewählt werden, dass der Puls P eine insbesondere mittels eines Pulsformers geformte Einzel-Cluster-Antwort auf $^{55}$Fe-Bestrahlung repräsentiert.

Geht man beispielsweise davon aus, dass ein Sensor 2 bzw. Detektor Pulse P mit S-ähnlicher Form liefert (Figur 1 b)), für welche k=2,75 erforderlich ist, würde dies auf einem ASIC 6 die vorstehend beschriebene Mux1-Konfiguration benötigen und eine Mux2-Konfiguration, die Nullwerte (c=0) an den Subtraktions-Block 18 liefert. Wenn der Detektor beispielsweise eine S-ähnliche Pulsform (n=2) mit Anstiegszeit von 30 ns hat, wird $\tau$ bei der Berechnung des Faktors k mit 15 ns genommen (dabei ist zu beachten, dass bei n=2 die Dauer des Anstiegs $2\tau$ ist). Die Abtastrate ist 130 MSPS. Der berechnete Faktor k ist $\kappa$=3.58 exp(-T/$\tau$)=2.142, in der Konfiguration der Anlage wird der naheliegendste einstellbare Faktor k=2.125 gewählt. Um eine bessere Anpassung zu erreichen, kann die Anzahl der Multiplier/Divider vergrößert werden (siehe Figur 15, Module 9 bis 12).

Es sei angemerkt, dass fest verdrahtete, gewichtete Leitungen von Signal a1 alternativ zu Mux1 verwendet werden können. Die Additions-Einheit 15 kann ferner für eine Summand-Anzahl optimiert werden.

Auch kann, insbesondere wenn die Pulsform einmal bestimmt worden ist, was durch Berücksichtigung der verwendeten Sensoren 2 für die Strahlungsmessung und/oder Pulsformer, also Shaper, möglich ist, ein FPGA 5 verwendet werden, welches - um logische Zellen zu sparen - nur die zu einer eine der drei Pulsform-Varianten gehörige Auswertung abdeckt.

Der FPGA 5 des Systems aus Figur 13 deckt vorliegend konkret nur die dritte Variante, also eine S-ähnliche Form der Puls-Anstiegsflanke F ab, umfasst entsprechend nur einen zugehörigen Teil der in Figur 15 gezeigten Struktur.

Es sei angemerkt, dass auch eine automatische Bestimmung der Form der steigenden Flanke F möglich ist, dies insbesondere durch Betrachtung eines oder mehrere Referenzpulse R. Dann können insbesondere jeweils frühere und spätere Differenzen zwischen aufeinanderfolgenden Abtastpunkten miteinander verglichen werden, oder auch Differenzen eines Paares von Referenzpulsen R, für die verschieden große Schwellwerte angesetzt wurden, was vorstehend im Zusammenhang mit Figur 12 näher erläutert wurde.

Mit dem System gemäß Figur 14 kann flexibel in allen drei Fällen $\Delta$t bestimmt werden, es sind also alle drei Fälle abgedeckt, da der ASIC 6 die in Figur 15 gezeigte Struktur vollständig umfasst. Welche Parameter c und k zum Einsatz kommen, ergibt sich in Abhängigkeit einer Benutzereingabe zur Pulsform über den PC 7.

Sobald $\Delta$t unter Verwendung der zu der jeweiligen Pulsform gehörigen Gleichung bzw. den zu der jeweiligen Pulsform gehörigen Gleichungs-Parameter c und k berechnet wurde, kann unter Berücksichtigung des erhaltenen Wertes für $\Delta$t eine angenommene Ankunftszeit $t_m$ des Signalpulses P berechnet werde. Dies erfolgt vorliegend über die Gleichung

$$t_m = t_1 - \Delta t,$$

wobei $t_1$ der Zeitpunkt des ersten Samples $s_1$ ist. Diese Berechnung kann ebenfalls über die zum Einsatz kommende Auswerteeinheit 5.

In den Figuren 1 a) und b) ist die angenommene Ankunftszeit $t_m$ und die tatsächliche Ankunftszeit $t_s$, die mit dieser nicht übereinstimmen muss, und in der Regel nicht übereinstimmen wird, dargestellt.

Die bestimmte Ankunftszeit $t_m$ kann dann bei der weiteren Verarbeitung des digitalisierten Signalpulses P berücksichtigt werden.

Es ist klar, dass im Rahmen einer Strahlungsmessung eine Vielzahl von Signalpulse P entstehen kann bzw. wird, und eine Vielzahl von Kanälen 1 zum Einsatz kommt, wobei dann für jeden Signalpuls P auf die vorstehend - beispielhaft anhand eines Signalpulses P - beschriebene Weise ein Ankunftszeit $t_m$ bestimmt wird.

Im Folgenden wird eine Ankunftszeitanalyse betrachtet, die auf einen durch COSY (Kühler Synchrotron) des Forschungszentrums Jülich [9] bereitgestellten Protonenteststrahl mit 2,7 GeV/c angewandt wird. Die Straw-Rohren (in den Figuren nicht weiter dargestellt) wurden in einzelnen Schichten organisiert, die aus 16 Straws bestehen. Der Detektor arbeitete mit einem Absolutdruck von 2 Bar mit Ar/CO2 gemischt im Verhältnis 8/2. Die Spannung (HV) wurde auf 1800 V eingestellt.

Die Signale von Straw-Rohren werden über 12 Meter lange Micro-Koaxial-Kabel mit der Elektrik verbunden. Die Front-End-Elektronik umfasst noch die Spannungsentkopplung, Transimpedanzverstärker (beides nicht gezeigt) mit einer Verstärkung von 400 und CR-RC$^2$-Pulsformer. Die koaxialen Kabel und Pulsformer führen zu einer Signal-Peaking-Zeit von etwa 20 ns und zeigten ein SNR von etwa 38 dB. Pipelined 12-bit ADCs 4, die bei einer variierbaren Abtastrate im Bereich 100 bis 166 MSPS arbeiten, wurden für die Abtastung verwendet. Die aufgezeichneten Daten wurden für eine Offline-Evaluierung von LRA und nLRA-Methoden gespeichert.

Zuerst wurde eine Bestrahlung mit einer $^{55}$Fe-Quelle durchgeführt. Wie erwartet haben die Pulse eine S-ähnliche Anstiegsform mit einer Spitzenzeit von etwa 23 ns. Die summierte Clusterantwort durch einen Proton-Teststrahl weicht von der durch eine $^{55}$Fe-Quelle erzeugten Antwort ab. Die summierte Clusterantwortform ist von der Clusterstatistik und von dem Spurabstand zum Draht abhängig [6]. Die Dauer der steigenden Flanke ist nicht mehr durch den Pulsformer alleine definiert. In dem Fall, dass Teilchen weit vom Draht entfernt passieren, besteht die summierte Clusterantwort aus einigen wenigen Clustern und ihr Anstiegswert kann geringfügig über den 25 ns liegen. Die Pulsanstiegsdauer in dem Fall, dass Teilchen in der Nähe des Drahtes fliegen, ist länger (etwa 35 ns), kann einige wenige Wendepunkte aufweisen. Die Spitzenwerte in dem Fall, dass Teilchen in der Nähe des Drahtes und in der Nähe der Röhrchen-Wandfliegen, sind niedriger als in den anderen Fällen. Die Vielfalt der mehreren Clusterantwortformen sowie eine aus einer $^{55}$Fe-Bestrahlung erhaltene Einzelclusterantwort ist in [6] beschrieben. Unter Heranziehung einer großen Menge an Daten wurde eine Durchschnitts-Pulsanstiegsform bis zum zweiten Wendepunkt berechnet. Sie weist eine S-ähnliche Form mit einem Wendepunkt auf, der ungefähr in der Mitte der Anstiegsdauer platziert ist. Und eine Durchschnitts-Anstiegsdauer ist verglichen mit einer $^{55}$Fe-Antwort erhöht und beträgt nun etwa 30 ns. Dies ist der Grund dafür, dass, um konsistent zu bleiben, alle Simulationen unter Verwendung dieser Anstiegszeit durchgeführt wurden. Eine Durchschnitts-Pulsform und ihre Approximation sind in Figur 16 zu sehen.

Die Messungen wurden unter Verwendung von fünf Abtastraten durchgeführt: 100, 116, 133, 150 und 166 MSPS. Die unter Verwendung von Linear- und Nicht-Linearanstiegsapproximations-Verfahren berechnete, räumliche Auflösung ist in Figur 17 gezeigt (LRA mit Kreisen und nLRA mit Dreiecken).

Die Zeitmess- bzw. Timing-Auflösung trägt nur einen Teil zur gesamten, räumlichen Auflösung des STT bei. Die anderen Einflussfaktoren sind Ungenauigkeit der Drahtposition, Streuung und andere Clusterausbreitung (englisch: cluster spread). Die Gesamtdriftzeit war etwa 140 ns, der Straw-Rohr-Radius betrug 5 mm. Das bedeutet, dass 1 ns Zeitmessauflösung etwa 36 $\mu$m räumlicher Auflösung entspricht. Man kann die simulierte Verbesserung der Timing-Auflösung für 100 MSPS von nLRA in Figur 9 (~ 95ps) mit der durch LRA gemäß Figur 3 (~ 650 ps) vergleichen, was in etwa einer räumlichen Auflösung von 22 $\mu$m entspricht. Der Vergleich des Abtastraten-Verhaltens von simulierten und experimentellen Kurven (Figur 3, Figur 9, Figur 16) zeigt eine gute Übereinstimmung zwischen Simulation und Experiment. Die Auflösung, die mit einer niedrigen Abtastrate von 100 MSPS unter Verwendung der nLRA-Methode erhalten wird ist fast gleich zu der, die man für eine höhere Abtastrate von 166 MSPS erhält.

Es gibt eine weitere Möglichkeit, die Effizienz der nLRA-Methode zu überprüfen. Die Figur 18 zeigt Driftzeit-Histogramme unter Anwendung von LRA (Figur 18 a)) beziehungsweise nLRA (Figur 18 b)) (für STT, also Pulsform nach Gleichung (1) und n=2). Die beiden Histogramme resultieren aus der Verwendung einer Abtastrate von 150 MSPS. Wenn ein gesamtes Driftintervall von 140 ns durch die Abtastperiode (etwa 7 ns) geteilt wird, werden exakt 20 Wellen erhalten, wie man in Figur 18 (a) sieht. Die Tiefe der Wellen entspricht dem SPE. In der Figur 18 (b) (nLRA-Verfahren) können noch die SPE-Wellen erkannt werden, aber deren Tiefe ist signifikant reduziert, ebenso wie der SPE.

Es sei angemerkt, dass insbesondere für groß angelegte Experimente, eine Mehrzahl von erfindungsgemäßen Vorrichtungen zur Bestimmung der Ankunftszeit von eine physikalische Messgröße repräsentierenden Signalpulsen bzw. ein erfindungsgemäßes Auswertesystemen mit mehreren solchen Vorrichtungen bzw. ein erfindungsgemäßes Strahlendetektionssystem mit mehreren solchen Vorrichtungen und mehreren Sensoren zum Einsatz kommen kann.

Im Folgenden wird beispielhaft eine konkrete Ausgestaltung insbesondere für groß angelegte Experimente beschrieben.

Als Hardware kann ein Baugruppenträger wie beispielsweise ein o-pen-VPX-Crate mit 16 Einschüben (in den Figuren nicht dargestellt) zur Verarbeitung von mehr als 2240 Kanälen einschließlich Verstärker-/Pulsformer-, Abtast- und Verarbeitungsschaltungen, verwendet werden. 14 Einschübe des Crates dienen dann bevorzugt für Datenerfassungs-Platinen, auf welchen jeweils eine Auswerteeinheit 5 und insbesondere Filter 3 und ADCs 4 implementiert sind, und die letzten zwei Einschübe können für Datenkonzentrator- und Steuerungsaufgaben genutzt werden. In den rückwärtigen Einschüben des Crates können dann beispielsweise 160 Verstärker/Pulsformer-Kanäle pro Einschub implementiert sein. In den vorderen Einschüben können dann die Module zur Abtastung und Verarbeitung, bestehend aus 40 4-Kanal-ADCs 4 und einem einzigen Virtex-FPGA-XC7V585T, implementiert sein.

Die Übertragung der 160 differenziellen Signale zwischen vorderem und hinterem Einschub erfolgt über eine modifizierte open VPX-Backplane. Vordere und hintere Module können im VME-Format entwickelt sein.

Im Weiteren wird nicht nochmals im Detail auf das DAQ (Data Acquisition System)-System eingegangen, sondern nur auf einige wenige Merkmale in Bezug auf Leistungsaufnahme der DAQ, mit der eine gewünschte Zeitauflösung von 100ps erreicht werden kann.

Die Parameter einer anlogen Kette können beispielsweise sein: Koaxialkabel mit einer Länge von 12m, die den Detektor mir der Hochspannungs-Entkopplung verbinden, gefolgt von einem Transimpedanz-Verstärker und einem $CR\text{-}RC^2$-Pulsformer. Der Transimpedanz-Verstärker könnte ein OPA847 von Texas Instruments sein. Dieser bietet eine hohe Bandbreite (3,9GHz), eine hohe Flankensteilheit (950mV/ns) und eine sehr niedrige Eingangs-Rauschspannung ($0.85nV/\sqrt{Hz}$) bei einem Versorgungsstrom von 18mA. Die gesamte Leistungsaufnahme der analogen Kette ist mit 90mW pro Kanal berechnet. Das Datenerfassungs-System dient Aufbauten, die durch eine kurze Dauer Anstiegszeit die Pulse und eine hohe Flankensteilheit charakterisiert sind. Für eine Anstiegzeit von 30ns benötigt der Verstärker eine Flankensteilheit von kleiner als 150mV/ns. Mit einem angepassten Verstärker kann in diesem Fall die Leistungsaufnahme der analogen Kette auf 15-20mW reduziert werden.

Verwendet werden kann weiterhin eine Pipeline-Analoggeräte-HMCAD1520-ADC 4. Ein Pipeline-ADC 4 stellt einen besten Leistungsaufnahme/Abtastrate-Kompromiss bereit. Dieser ADC 4 bietet eine variable Abtastrate von 80 bis zu 166 MSPS und höhere Raten mit einer reduzierten Kanalanzahl durch Kombination mehrerer Kanäle. Zwei serielle Verbindungen übertragen (jeweils bis zu 1 GHz) die abgetasteten Daten zur Virtex-7-FPGA 5. Es gibt eine gute Übereinstimmung zwischen ADC 4 und FPGA 5. Die ADC-Abtastrate (bis zu 166 MSPS) entspricht der FPGA (bis zu 200 MSPS bei einer hohen verwendeten Logikdichte), wohingegen eine ADC-Übertragungsrate (bis zu 1 GHz) der FPGA-Erfassungsrate (bis zu 1,2 GHz) entspricht. Die nominale Leistungsaufnahme des ADC ist etwa 100 mW/ pro Kanal. Dieser kann durch Konfiguration einer niedrigen Abtastrate, beispielsweise 100 MSPS, auf 60mW/Kanal gesenkt werden.

In FPGA 5 implementierte Operationen sind dann insbesondere Datenerfassung, Medianfilter, Grundlinienberechnung und -Subtraktion, Ankunftszeitberechnung nach nLRA, Energieberechnung zur Teilchenunterscheidung. Die erforderliche dynamische Leistung der FPGA 5 ist etwa 20 mW/Kanal. Den größten Teil davon verbrauchen I/O-Pins, und die Erfassung der Daten der ADCs 4. Die Pileup-Auflösungs- und Selbstauslösefunktionen sind noch nicht integriert.

Alle Kanäle auf Platinen haben die gleiche Signalausbreitungszeit: es ist keine Kalibrierung für die Platinen selbst erforderlich, so dass bei der Entwicklung der digitalen Signalverarbeitung keine Unterschiede in den Kanälen berücksichtigt werden müssen. Durch die Längenanpassung in analoger und digitaler Kette sowie vollsynchrone Taktung, sind keine zusätzlichen FPGA-Ressourcen für Datenverzögerungen an den Eingängen erforderlich.

Die vorliegende Erfindung bietet viele Vorteile. In Abweichung vom Stand der Technik wird bei der Bestimmung der Ankunftszeit von Pulsen deren Form berücksichtigt und verschiedene Pulsformen werden unterschiedlich behandelt, wodurch optimale Ergebnisse erzielt werden können. Trotz der vorteilhaften unterschiedlichen Behandlung bzw. weiteren Verarbeitung im Falle verschiedener Pulsformen kommt erfindungsgemäß dieselbe Gleichung bzw. Gleichungsstruktur zur Berechnung des Zeit-Offsets Δt zum Einsatz, wobei für die Berücksichtigung verschiedener Pulsformen und Peak-Zeiten lediglich c und k in der Gleichung anzupassen sind. Dies macht das erfindungsgemäße Verfahren besonders gut anwendbar auf verschieden Detektorarten, insbesondere verschiedene Arten von Strahlendetektoren.

Die Erfindung schlägt eine einfache, leicht zu implementierende nichtlineare Anstiegsapproximation (nLRA) vor. Die (angenommene) Puls-Start- bzw-Puls-Ankunftszeit wird direkt von den ersten beiden Punkten, konkret Samples $s_1$, $s_2$ auf der steigenden Flanke F des Pulses P abgeleitet und der Abtastphasenfehler wird signifikant reduziert, wodurch Zeitauflösungen deutlich unterhalb von 1/100 Bruchteil der Abtastperiode erzielt werden können.

Es ist insbesondere möglich, für alle drei Fälle von Pulsformen die gleiche Auswerteeinheit 5 zu nutzen, wie vorstehend im Zusammenhang mit Figur 14 erläutert.

Es fällt nur eine äußerst geringe Verarbeitungsressource an, wobei dennoch eine hohe Zeitauflösung erzielt wird.

**Bezugszeichenliste**

1     Kanal
2     Sensor
3     Filter
4     Analog-Digital-Wandler
5     Auswerteinheit
6     integrierte Schaltung (ASIC)

| 7 | PC |
|---|---|
| 8 | Modul |
| 9 | Modul |
| 10 | Modul |
| 11 | Modul |
| 12 | Modul |
| 13 | Pfeil |
| 14 | Modul |
| 15 | Additions-Modul |
| 16 | Modul |
| 17 | Pfeil |
| 18 | Subtraktions-Modul |
| 19 | Divisions-Modul |
| P | Signalpuls |
| F | steigende Flanke |
| R | Referenzpuls |
| T | Abtastperiode |
| $p_i$ | Wendepunkt |
| $s_{1,2}$ | Abtastpunkt |
| $t_m$ | Ankunftszeit |
| $t_{1,2}$ | Zeitpunkt |
| $a_{1,2}$ | Abtastwert |

Referenzen

[1] M. A. Nelson, B. D. Rooney, D. R. Dinwiddie, and G. S. Brunson, " Analysis of digital timing methods with BaF2 scintillators," Nucl. Instrum. Methods Phys. Res. A, Accel. Spectrom. Detect. Assoc. Equip., vol. 505, nos. 1- 2, pp. 324- 327, Jun. 2003.

[2] L. Bardelli, G. Poggi, M. Bini, G. Pasquali, and N. Taccetti, "Time measurements by means of digital sampling techniques: A study case of 100 ps FWHM time resolution with a 100 MSample/s, 12 bit digitizer," Nucl. Instrum. Methods Phys. Res. A, Accel. Spectrom. Detect. Assoc. Equip., vol. 521, nos. 2- 3, pp. 480- 492, Apr. 2004S.

[3] V. Paulauskas, M. Madurga, R. Grzywacz, D. Miller, S. Padgett, and H. Tan, "A digital data acquisition framework for the Versatile Array of Neutron Detectors at Low Energy (VANDLE)," Nucl. Instrum. Methods Phys. Res. A, Accel. Spectrom. Detect. Assoc. Equip., vol. 737, pp. 22- 28, Feb. 2014

[4] B. Joly et al., "An optimal filter based algorithm for PET detectors with digital sampling front-end," IEEE transactions on nuclear science, vol. 57, no. 1, pp. 63- 70, Feb. 2010

[5] William K. Warburton, and Wolfgang Hennig, "New Algorithms for improved digital pulse arrival timing with sub-GSps ADCs," IEEE transactions on nuclear science, vol. 64, no. 12, pp. 3627-3634, December 2017

[6] L. Jokhovets, M. Drochner, A. Erven, W. Erven, G. Kemmerling, H. Kleines, P. Kulessa, H.W. Loevenich, P. Marciniewski, M. Mertens, H. Ohm, K. Pysz, J. Ritman, V. Serdyuk, S. v. Waasen, P. Wintz, P. Wüstner, "ADC-based real-time signal processing for the PANDA Straw Tube Tracker," IEEE transactions on nuclear science, vol. 61, no. 6, pp. 3627-3634, December 2014

[7] M. Streun, G. Brandenburg, H. Larue, E. Zimmermann, K. Ziemons, H. Halling, "Coincidence detection by digital processing of free-running sampled pulses," Nuclear instruments and methods in physics research, section A 4867, pp. 530-534, 2002.

[8] M. Streun, G. Brandenburg, M. Khodaverdi, H. Larue, C. Parl, K. Ziemons, "Timemark correction for the Clear-PETTM scanners" IEEE Nuclear Science Symposium Conference Record, M07-155, 2005.

[9] P.Guerra, J.E.Ortuno, J.J.Vaquero, G.Kontaxakis, M.Desco, A.Santos, " Modeling the Acquisition Front-End in High Resolution Gamma-Ray Imaging, " IEEE transactions on nuclear science, vol. 53, no. 3, pp. 1150-1155, June 2006

[10] Wei Hu, Yong Choi, Key Jo Hong, Jihoon Kang, Jin Ho Jung, Youn Suk Huh, Hyun Keong Lim, Sang Su Kim, Byung Jun Min, Byung-Tae Kim, "A simple and improved digital timing method for positron emission tomography" Nuclear instruments and methods in physics research, section A 622, pp. 219-224, 2010.

[11] C.L. Kim, G.C. Wang, S. Dolinsky, "Multi-Pixel Photon Counters for TOF PET Detector and its Challenges" IEEE Nuclear Science Symposium Conference Record, M02-3, 2008.

[12] R. Maier, "Cooler synchrotron COSY - Performance and perspectives," Nuclear instruments and methods in physics research, section A390, pp. 1-8, 1997.

[13] J. Fedorisin, "Simulations of MPD Straw End-Cap Tracker", Proceedings of Science (XXII International Baldin Seminar on High Energy Physics Problems) 130, 2015, DOI 10.22323/1.225.0130.

[14] W. Sansen, Z. Chang, "Limits of Low Noise Performance of Detector Readout Front Ends in CMOS Technlogy", IEEE Transactions on Circuits and Systems, Vol. 37, Issue 11, pp. 1375-1382, 1990.

**Patentansprüche**

1. Verfahren zur Bestimmung einer Ankunftszeit ($t_m$) eines eine physikalische Messgröße repräsentierenden, digitalisierten Signalpulses (P), bei dem

   - bestimmt wird, welche Form die steigende Flanke (F) des Signalpulses (P) aufweist, wobei die Form ausgewählt wird aus der Gruppe umfassend

     - einen zumindest im Wesentlichen linearen Anstieg,
     - einen nichtlinearen Anstieg ohne Wendepunkt (pi) und
     - einen S-ähnlichen nichtlinearen Anstieg mit wenigstens einem Wendepunkt (pi),

   - in allen drei Fällen mittels einer Auswerteeinheit (5) eine Differenz zwischen dem Zeitpunkt ($t_1$) des ersten Abtastpunktes ($s_1$) des Signalpulses (P) und der Ankunftszeit ($t_m$) des Signalpulses (P) berechnet wird über die Gleichung

$$\Delta t = T \frac{ka_1}{a_2 - cka_1}$$

   wobei T die Abtastperiode darstellt, mit welcher der digitalisierte Signalpuls (P) abgetastet ist, und $a_1$ der Abtast-, insbesondere Amplituden-Wert eines ersten Abtastpunktes $s_1$ und $a_2$ der Abtast-, insbesondere Amplituden-Wert eines zweiten, späteren Abtastpunktes $s_2$ des digitalisierten Signalpulses (P), wobei $s_1$ und $s_2$ bevorzugt die allerersten beiden Abtastpunkte des Signalpulses (P) sind, und wobei für den Fall, dass ein zumindest im Wesentlichen linearer Anstieg als Form der steigenden Flanke (F) bestimmt wird, k =1 und c = 1 gesetzt wird, und für den Fall, dass ein nichtlinear Anstieg ohne Wendepunkt (pi) als Form der steigenden Flanke (F) bestimmt wird, k = exp(-T/τ) oder k=a(2T)/2a(T), wobei a(2T) und a(T) die Abtast-, insbesondere Amplituden-Werte eines dritten und zweiten Abtastpunktes eines digitalisierten Referenzpulses (R) sind, bei dem der Abtast-, insbesondere Amplituden-Wert eines ersten Abtastpunktes auf der steigenden Flanke (F) einem für die Digitalisierung des Referenzpulses angesetzten Schwellwert entspricht oder höchstens um einen vorgegebenen Wert oberhalb des Schwellwertes liegt, und c = 1 gesetzt wird, und für den Fall, dass ein S-ähnlicher nichtlinearer Anstieg mit wenigstens einem Wendepunkt (pi) als Form der steigenden Flanke (F) bestimmt wird, $k = m$ exp(-$T$/τ) mit $3{,}30 \leq m \leq 4{,}0$, insbesondere $3{,}50 \leq m \leq 3{,}90$, bevorzugt $3{,}58 \leq m \leq 3{,}80$, oder k=a(2T)/a(T), wobei a(2T) und a(T) die Abtast-, insbesondere Amplituden-Werte eines dritten und zweiten Abtastpunktes auf der steigenden Flanke (F) eines digitalisierten Referenzpulses (R) sind, bei dem der Abtast-, insbesondere Amplituden-Wert eines ersten Abtastpunktes auf der steigenden Flanke (F) einem für die Digitalisierung des Referenzpulses angesetzten Schwellwert entspricht oder höchstens um einen vorgegebenen Wert oberhalb des Schwellwertes liegt, und c = 0 gesetzt wird, wobei τ eine die Puls-Peakzeit spezifizierende Zeitkonstante ist, und
   - mittels der Auswerteeinheit (5) unter Berücksichtigung des erhaltenen Wertes für Δt die Ankunftszeit ($t_m$) des Signalpulses (P) berechnet wird, insbesondere über die Gleichung

$$t_m = t_1 - \Delta t,$$

   wobei $t_1$ der Zeitpunkt des ersten Abtastpunktes $s_1$ des Signalpulses (P) ist, insbesondere, wobei die Ankunftszeit ($t_m$) bei der weiteren Verarbeitung des digitalisierten Signalpulses (P) berücksichtigt wird.

2. Verfahren nach Anspruch 1, **dadurch gekennzeichnet, dass** als Form für die steigende Flanke (F) des Signalpulses (P) ein nichtlinearer Anstieg ohne Wendepunkt (pi) gewählt wird, wenn die Pulsform durch die Gleichung

$$V\left(t\right) = A\left(\frac{t-t_s}{\tau}\right)^{n} \exp\left(-\frac{t-t_s}{\tau}\right)$$

mit n = 1 beschrieben werden kann,
und
als Form für die steigende Flanke (F) des Signalpulses (P) ein S-ähnlicher nichtlinearer Anstieg mit wenigstens einem Wendepunkt (pi) für den Fall gewählt wird, dass die Pulsform durch die Gleichung

$$V\left(t\right) = A\left(\frac{t-t_s}{\tau}\right)^{n} \exp\left(-\frac{t-t_s}{\tau}\right)$$

mit n = 2 beschrieben werden kann, wobei t die Zeit, $t_s$ die Ankunftszeit des Signalpulses, A ein amplitudenbezogener Faktor und $\tau$ eine die Puls-Peakzeit spezifizierende Zeitkonstante ist.

3. Verfahren nach einem der vorhergehenden Ansprüche, **dadurch gekennzeichnet, dass** der digitalisierte Signalpuls (P) ein Sensorsignal, insbesondere einen Sensorpuls einer physikalischen Messeinrichtung, bevorzugt eines Strahlendetektors repräsentiert, und als Form für die steigende Flanke (F) des Signalpulses (P) ein nichtlinearer Anstieg ohne Wendepunkt (pi) für den Fall gewählt wird, dass der Signalpuls eine insbesondere rauschfreie und/oder mittels eines Pulsformers geformte Gammastrahlungs-Antwort eines Strahlendetektors, insbesondere eines mit einem Cerium dotierten Lutetium Yttrium Orthosilicat Szintillator gekoppelten Silizium-Photovervielfachers (SiPM), repräsentiert, und als Form die steigende Flanke (F) des Signalpulses (P) ein S-ähnlicher nichtlinearer Anstieg mit Wendepunkt (pi) für den Fall gewählt wird, dass der Signalpuls eine insbesondere mittels eines Shapers geformte Einzel-Cluster-Antwort auf $^{55}$Fe-Bestrahlung repräsentiert, und/oder dass das Verhältnis der Abtastrate zu der Dauer der steigenden Flanke (F) des Signalpulses (P) derart gewählt oder eingestellt wird, dass mindestens zwei Abtastpunkte, bevorzugt mindestens drei Abtastpunkte, besonders bevorzugt genau drei Abtastpunkte auf der steigenden Flanke (F) liegen.

4. Verfahren nach einem der vorhergehenden Ansprüche, **dadurch gekennzeichnet, dass** der Signalpuls (P) mit einer Abtastrate von weniger als 200 Mega-Abtastpunkten pro Sekunde, insbesondere weniger als 150 Mega-Abtastpunkten pro Sekunde, bevorzugt weniger als 100 Mega-Abtastpunkten pro Sekunde digitalisiert ist oder wird, und/oder dass der Schwellwert für die Pulsdetektion im Bereich von 0,2 bis 3% des insbesondere durchschnittlichen Puls-Peak-Wertes liegt, und/oder dass die Dauer des Signalpulses (P) im Bereich von 1 bis 150 Nanosekunden, bevorzugt im Bereich von 1 bis 70 Nanosekunden liegt.

5. Verfahren nach einem der vorhergehenden Ansprüche, **dadurch gekennzeichnet, dass** eine automatische Bestimmung der Form der steigenden Flanke (F) des Signalpulses (P) erfolgt, insbesondere, indem die Differenz zwischen dem Abtast-, insbesondere Amplituden-Wert zweier aufeinanderfolgender Abtastpunkte wenigstens eines digitalisierten Referenzpulses (R) mit einer früheren Differenz zwischen dem Abtast-, insbesondere Amplituden-Wert zweier aufeinanderfolgender Abtastpunkte des Referenzpulses (R) verglichen wird, und für den Fall, dass die Differenz gleich ist, ein zumindest im Wesentlichen linearer, insbesondere ein linearer Anstieg angenommen wird, und für den Fall, dass die Differenz der späteren Abtastpunkte kleiner als die der früheren ist, ein nichtlinearer Anstieg ohne Wendepunkt (pi) angenommen wird, und für den Fall, dass die Differenz der späteren Abtastpunkte größer als die der früheren ist, ein S-ähnlicher nichtlinearer Anstieg mit wenigstens einem Wendepunkt (pi) angenommen wird, bevorzugt, wobei die automatische Bestimmung der Form der steigenden Flanke (F) erfolgt, indem zwei Referenzpulse (R) abgetastet werden, wobei für den einen Referenzpuls (R) ein niedrigerer Schwellwert und für den anderen Referenzpuls (R) ein höherer Schwellwert angesetzt wird, und für beide Referenzpulse (R) die Differenz zwischen dem Sampling-, insbesondere Amplitudenwert eines zweiten und ersten Abtastpunktes des Referenzpulses (R) gebildet wird, und die Differenzen miteinander verglichen werden, und für den Fall, dass die Differenz gleich ist, ein zumindest im Wesentlichen linearer, insbesondere ein linearer Anstieg angenommen wird, und für den Fall, dass die zu dem niedrigeren Schwellwert gehörige Differenz größer ist als die zu dem höheren Schwellwert gehörige Differenz, ein nichtlinearer Anstieg ohne Wendepunkt (pi) angenommen wird, und für den Fall, dass die zu dem niedrigeren Schwellwert gehörige Differenz kleiner ist als die zu dem höheren Schwellwert gehörige Differenz, ein S-ähnlicher nichtlinearer Anstieg mit wenigstens einem Wendepunkt (pi) angenommen wird.

6. Verfahren nach einem der vorhergehenden Ansprüche, **dadurch gekennzeichnet, dass** die Dauer der steigenden Flanke (F) insbesondere automatisch abgeschätzt wird, wobei die automatische Abschätzung bevorzugt über die Bestimmung der Anzahl derjenigen Abtastpunkte eines digitalisierten Referenzpulses (R) erfolgt, für die gilt, dass der Abtast-, insbesondere Amplituden-Wert eines jeweils nachfolgenden Abtastpunktes größer ist als der Abtast-, insbesondere Amplituden-Wert des jeweils vorangegangenen Abtastpunktes, und besonders bevorzugt eine Abschätzung der Dauer der steigenden Flanke (F) für ein Mehrzahl von Referenzpulsen (R) erfolgt und der Mittelwert gebildet und als durchschnittliche Dauer angenommen wird.

**7.** Auswerteeinheit (5) zur Bestimmung einer Ankunftszeit ($t_m$) von eine physikalische Messgröße repräsentierenden digitalisierten Signalpulsen (P), die ausgebildet und/oder eingerichtet ist, um

- eine Differenz zwischen dem Zeitpunkt eines ersten Abtastpunktes ($s_1$) eines digitalisierten Signalpulses (P) und einer Ankunftszeit ($t_m$) des Signalpulses (P) über die Gleichung

$$\Delta t = T \frac{k a_1}{a_2 - c k a_1}$$

zu berechnen, wobei T die Abtastperiode darstellt, mit welcher der digitalisierte Signalpuls (P) abgetastet ist, und $a_1$ der Abtast-, insbesondere Amplituden-Wert eines ersten Abtastpunktes $s_1$ und $a_2$ der Abtast-, insbesondere Amplituden-Wert eines zweiten, späteren Abtastpunktes $s_2$ des digitalisierten Signalpulses (P), wobei $s_1$ und $s_2$ bevorzugt die allerersten beiden Abtastpunkte des Signalpulses (P) sind, und um
- unter Berücksichtigung des erhaltenen Wertes für $\Delta t$ eine Ankunftszeit ($t_m$) des Signalpulses (P) zu berechnen, insbesondere über die Gleichung

$$t_m = t_1 - \Delta t$$

wobei $t_1$ der Zeitpunkt des ersten Abtastpunktes $s_1$ des Signalpulses (P) ist,
wobei die Auswerteeinheit (5) entweder derart ausgebildet und/oder eingerichtet ist, dass in der Gleichung für $\Delta t$ $k = \exp(-T/\tau)$ oder $k=a(2T)/2a(T)$, wobei a(2T) und a(T) die Abtast-, insbesondere Amplituden-Werte eines dritten und zweiten Abtastpunktes eines digitalisierten Referenzpulses (R) sind, bei dem der Abtast-, insbesondere Amplituden-Wert eines ersten Abtastpunktes auf der steigenden Flanke (F) einem für die Digitalisierung des Referenzpulses angesetzten Schwellwert entspricht oder höchstens um einen vorgegebenen Wert oberhalb des Schwellwertes liegt, und c =1 ist,
oder die Auswerteeinheit (5) derart ausgebildet und/oder eingerichtet ist, dass in der Gleichung für $\Delta t$ $k = m \exp(-T/\tau)$ mit $3,30 \leq m \leq 4,0$, insbesondere $3,50 \leq m \leq 3,90$, bevorzugt $3,58 \leq m \leq 3,80$, oder $k=a(2T)/a(T)$, wobei a(2T) und a(T) die Abtast-, insbesondere Amplituden-Werte eines dritten und zweiten Abtastpunktes auf der steigenden Flanke (F) eines digitalisierten Referenzpulses (R) sind, bei dem der Abtast-, insbesondere Amplituden-Wert eines ersten Abtastpunktes auf der steigenden Flanke (F) einem für die Digitalisierung des Referenzpulses angesetzten Schwellwert entspricht oder höchstens um einen vorgegebenen Wert oberhalb des Schwellwertes liegt, und c = 0 ist,
oder die Auswerteeinheit (5) ausgebildet und/oder eingerichtet ist, um eine Information über die Form der steigenden Flanke (F) des Signalpulses (P) entgegenzunehmen, die ausgewählt ist aus der Gruppe umfassend

- einen zumindest im Wesentlichen linearen Anstieg,
- einen nichtlinearen Anstieg ohne Wendepunkt (pi) und
- einen S-ähnlichen nichtlinearen Anstieg mit wenigstens einem Wendepunkt (pi),

und für den Fall, dass die steigende Flanke (F) des Signalpulses (P) sich durch einen zumindest im Wesentlichen linearen Anstieg auszeichnet, k=1 und c=1 zu verwenden,
und für den Fall, dass die steigende Flanke (F) des Signalpulses (P) sich durch einen nichtlinear Anstieg ohne Wendepunkt (pi) auszeichnet, $k = \exp(-T/\tau)$ oder $k=a(2T)/2a(T)$, wobei $\tau$ eine die Puls-Peakzeit spezifizierende Zeitkonstante ist und a(2T) und a(T) die Abtast-, insbesondere Amplituden-Werte eines dritten und zweiten Abtastpunktes eines digitalisierten Referenzpulses (R) sind, bei dem der Abtast-, insbesondere Amplituden-Werte eines ersten Abtastpunktes auf der steigenden Flanke (F) einem für die Digitalisierung des Referenzpulses angesetzten Schwellwert entspricht oder höchsten um einen vorgegebenen Wert oberhalb des Schwellwertes liegt, und c =1 zu verwenden, und für den Fall, dass die steigende Flanke (F) des Signalpulses (P) sich durch einen S-ähnlichen nichtlinearen Anstieg mit wenigstens einem Wendepunkt (pi) auszeichnet, $k = m \exp(-T/\tau)$ mit $3,30 \leq m \leq 4,0$, insbesondere $3,50 \leq m \leq 3,90$, bevorzugt $3,58 \leq m \leq 3,80$, oder $k=a(2T)/a(T)$, wobei a(2T) und a(T) die Abtast-, insbesondere Amplituden-Werte eines dritten und zweiten Abtastpunktes auf der steigenden Flanke (F) eines digitalisierten Referenzpulses (R) sind, bei dem der Abtast-, insbesondere Amplituden-Wert eines ersten Abtastpunktes auf der steigenden Flanke (F) einem für die Digitalisierung des Referenzpulses angesetzten Schwellwert entspricht oder höchsten um einen vorgegebenen Wert oberhalb des Schwellwertes liegt, und c = 0 zu verwenden.

8. Auswerteeinheit (5) nach Anspruch 7, **dadurch gekennzeichnet, dass** die Auswerteeinheit (5) durch ein Field Programmable Gate Array gegeben ist oder ein solches umfasst, und/oder dass die Auswerteeinheit (5) einen Bestandteil einer anwendungsspezifischen integrierten Schaltung (6) bildet oder eine solche umfasst, und/oder dass sich die Auswerteeinheit (5) durch eine Mehrkanal-Konfiguration mit insbesondere mehr als 100 Kanälen (1) auszeichnet, und/oder dass die Auswerteeinheit (5) wenigstens ein, bevorzugt genau ein Additions-Modul (15) und/oder wenigstens ein, bevorzugt genau ein Subtraktions-Modul (18) und/oder wenigstens ein, bevorzugt genau ein Divisions-Modul (19) umfasst.

9. Auswerteeinheit (5) nach Anspruch 7 oder 8, **dadurch gekennzeichnet, dass** die Auswerteeinheit (5) ausgebildet und/oder eingerichtet ist, um die Form der steigenden Flanke (F) eines Signalpulses (P) automatisch zu bestimmen, bevorzugt, wobei die Auswerteeinheit (5) ausgebildet und/oder eingerichtet ist, um die Bestimmung der Form der steigenden Flanke (F) durchzuführen, indem die Differenz zwischen dem Abtast-, insbesondere Amplituden-Wert zweier aufeinanderfolgender Abtastpunkte wenigstens eines digitalisierten Referenzpulses (R) mit einer früheren Differenz zwischen dem Abtast-, insbesondere Amplituden-Wert zweier aufeinanderfolgender Abtastpunkte des Referenzpulses (R) verglichen wird, und für den Fall, dass die Differenz gleich ist, ein zumindest im Wesentlichen linearer, insbesondere ein linearer Anstieg angenommen wird, und für den Fall, dass die Differenz der späteren Abtastpunkte kleiner als die der früheren ist, ein nichtlinearer Anstieg ohne Wendepunkt (pi) angenommen wird, und für den Fall, dass die Differenz der späteren Abtastpunkte größer als die der früheren ist, ein S-ähnlicher nichtlinearer Anstieg mit wenigstens einem Wendepunkt (pi) angenommen wird, bevorzugt, wobei die Auswerteeinheit (5) ausgebildet und/oder eingerichtet ist, die Bestimmung der Form der steigenden Flanke (F) durchzuführen, indem zwei Referenzpulse (R) abgetastet werden, wobei für den einen Referenzpuls (R) ein niedrigerer Schwellwert und für den anderen Referenzpuls (R) ein höherer Schwellwert angesetzt wird, und für beide Referenzpulse (R) die Differenz zwischen dem Abtast-, insbesondere Amplituden-Wert eines zweiten und ersten Abtastpunktes des Referenzpulses (R) gebildet wird, und die Differenzen miteinander verglichen werden, und für den Fall, dass die Differenz gleich ist, ein zumindest im Wesentlichen linearer, insbesondere ein linearer Anstieg angenommen wird, und für den Fall, dass die zu dem niedrigeren Schwellwert gehörige Differenz größer ist als die zu dem höheren Schwellwert gehörige Differenz, ein nichtlinearer Anstieg ohne Wendepunkt (pi) angenommen wird, und für den Fall, dass die zu dem niedrigeren Schwellwert gehörige Differenz kleiner ist als die zu dem höheren Schwellwert gehörige Differenz, ein S-ähnlicher nichtlinearer Anstieg mit wenigstens einem Wendepunkt (pi) angenommen wird.

10. Auswerteeinheit (5) nach einem der Ansprüche 7 bis 9, **dadurch gekennzeichnet, dass** die Auswerteeinheit (5) ausgebildet und/oder eingerichtet ist, um die Dauer der steigenden Flanke (F) automatisch abzuschätzen, wobei die automatische Abschätzung bevorzugt über die Bestimmung der Anzahl derjenigen ersten Abtastpunkte wenigstens eines digitalisierten Referenzpulses (R) erfolgt, für die gilt, dass der Abtast-, insbesondere Amplituden-Wert eines jeweils nachfolgenden Abtastpunktes größer ist als der Abtast-, insbesondere Amplituden-Wert des jeweils vorangegangenen Abtastpunktes.

11. Vorrichtung zur Bestimmung einer Ankunftszeit von eine physikalische Messgröße repräsentierenden Signalpulsen (P), umfassend

   - wenigstens einen, insbesondere mehrere Eingänge, über die eine physikalische Messgröße repräsentierende Signalpulse (P) entgegengenommen werden können,
   - wenigstens einen, insbesondere mehrere dem oder den Eingängen nachgeordnete Analog-Digital-Wandler (4), über welche entgegengenommene Signalpulse (P) insbesondere mit einer vorgegebenen oder vorgebbaren Abtastperiode (T) abgetastet und digitalisiert werden können,
   - wenigstens eine dem oder den Analog-Digital-Wandlern (4) nachgeordnete Auswerteeinheit (5) nach einem der Ansprüche 7 bis 10.

12. Vorrichtung nach Anspruch 11, **dadurch gekennzeichnet, dass** die Vorrichtung einen oder mehrere Filter (3) und/oder Verstärker umfasst, wobei der oder die Filter und/oder Verstärker bevorzugt dem oder den Eingängen nachgeordnet und/oder dem oder den Analog-Digital-Wandler vorgeschaltet sind, und/oder dass sich die Vorrichtung durch eine Mehrkanal-Konfiguration mit insbesondere mehr als 100 Kanälen (1) auszeichnet, wobei bevorzugt jeder Kanal (1) einen Eingang, einen Analog-Digital-Wandler (4) und insbesondere einen Filter (3) und/oder Verstärker umfasst, oder jedem Kanal (1) ein Eingang, ein Analog-Digital-Wandler (4) und insbesondere ein Filter (3) und/oder Verstärker zugeordnet ist, und die Vorrichtung bevorzugt genau eine Auswerteeinheit (5) umfasst, mit der Signale sämtlicher Kanäle (1) verarbeitbar sind oder verarbeitet werden.

13. Vorrichtung nach Anspruch 11 oder 12, **dadurch gekennzeichnet, dass** der oder die Analog-Digital-Wandler (4) als Fließband-Analog-Digital-Wandler ausgebildet sind.

14. Auswertesystem umfassend zwei oder mehr Vorrichtungen gemäß einem der Ansprüche 11 bis 13.

15. Strahlendetektionssystem, umfassend einen oder mehrere Sensoren (2) zur direkten oder indirekten Strahlendetektion und eine oder mehrere mit diesem oder diesen gekoppelte oder koppelbare Vorrichtungen nach einem der Ansprüche 11 bis 13, wobei der oder die Sensoren (2) bevorzugt durch Photodetektoren und/oder Straw Rohre und/oder Silizium-Photovervielfacher (SiPM) und/oder Gasdetektoren gegeben sind oder solche umfassen.

**Claims**

1. Method for determining an arrival time ($t_m$) of a digitised signal pulse (P) representing a physical measurand, in which

    - the shape of the rising edge (F) of the signal pulse (P) is determined, the shape being selected from the group comprising

        - at least an essentially linear increase,
        - a non-linear increase without inflection point (pi) and
        - an S-like non-linear increase with at least one inflection point (pi),

    - in all three cases, an evaluation unit (5) is used to calculate a difference between the time ($t_1$) of the first sampling point ($s_1$) of the signal pulse (P) and the arrival time ($t_m$) of the signal pulse (P) using the equation

$$\Delta t = T \frac{ka_1}{a_2 - cka_1}$$

    where T represents the sampling period with which the digitised signal pulse (P) is sampled, and $a_1$ is the sampling value, in particular the amplitude value, of a first sampling point $s_1$ and $a_2$ is the sampling value, in particular the amplitude value, of a second, later sampling point $s_2$ of the digitised signal pulse (P), where $s_1$ and $s_2$ are preferably the very first two sampling points of the signal pulse (P), and where, in the event that an at least substantially linear rise is determined as the form of the rising edge (F), k = 1 and c = 1 is set, and where, in the event that a non-linear rise without an inflection point (pi) is determined as the form of the rising edge (F), k = 1 and c = 1, is set and in in the case that a non-linear rise without inflection point (pi) is determined as the shape of the rising edge (F), $k = \exp(-T/\tau)$ or $k = a(2T)/2a(T)$, where a(2T) and a(T) are the sample values, in particular the amplitude values, of a third and second sample point of a digitised reference pulse (R) at which the sample value, in particular the amplitude value of a first sampling point on the rising edge (F) corresponds to a threshold value set for the digitisation of the reference pulse or is at most a predetermined value above the threshold value, and c = 1 is set, and in the event that an S-like non-linear rise with at least one inflection point (pi) is determined as the shape of the rising edge (F), $k = m \exp(-T/\tau)$ with $3.30 \leq m \leq 4.0$, in particular $3.50 \leq m \leq 3.90$, preferably $3.58 \leq m \leq 3.80$, or $k = a(2T)/a(T)$, where in a(2T) and a(T) are the sample values, in particular amplitude values, of a third and second sample point on the rising edge (F) of a digitised reference pulse (R), at which the sample value, in particular amplitude value, of a first sampling point on the rising edge (F) corresponds to a threshold value set for the digitisation of the reference pulse or is at most a predetermined value above the threshold value, and c = 0, where $\tau$ is a time constant specifying the pulse peak time, and
    - the arrival time ($t_m$) of the signal pulse (P) is calculated by means of the evaluation unit (5), taking into account the value obtained for $\Delta t$, in particular using the equation

$$t_m = t_1 - \Delta t,$$

where $t_1$ is the time of the first sampling point $s_1$ of the signal pulse (P), in particular, wherein the arrival time ($t_m$) is taken into account in the further processing of the digitised signal pulse (P).

2. Method according to claim 1, **characterised in that** a non-linear rise without inflection point (pi) is selected as the shape for the rising edge (F) of the signal pulse (P) if the pulse shape can be described by the equation

$$V(t) = A\left(\frac{t - t_s}{\tau}\right)^n \exp\left(-\frac{t - t_s}{\tau}\right)$$

can be described with n = 1,
and
an S-like non-linear slope with at least one inflection point (pi) is selected as the shape for the rising edge (F) of the signal pulse (P) in the event that the pulse shape can be described by the equation

$$V(t) = A\left(\frac{t - t_s}{\tau}\right)^n \exp\left(-\frac{t - t_s}{\tau}\right)$$

can be described with n = 2, where t is the time, $t_s$ is the arrival time of the signal pulse, A is an amplitude-related factor and $\tau$ is a time constant specifying the pulse peak time.

3. Method according to one of the preceding claims, **characterised in that** the digitised signal pulse (P) represents a sensor signal, in particular a sensor pulse of a physical measuring device, preferably a radiation detector, and a non-linear rise without inflection point (pi) is selected as the shape for the rising edge (F) of the signal pulse (P) for the case, that the signal pulse represents a gamma radiation response of a radiation detector, in particular a silicon photomultiplier (SiPM) coupled to a cerium-doped lutetium yttrium orthosilicate scintillator, which response is in particular noise-free and/or shaped by means of a pulse shaper, and the shape of the rising edge (F) of the signal pulse (P) is selected to be an S-like non-linear slope with inflection point (pi) in the event that the signal pulse represents a single-cluster response to $^{55}$Fe irradiation, in particular shaped by means of a shaper, and/or that the ratio of the sampling rate to the duration of the rising edge (F) of the signal pulse (P) is selected or set in such a way that at least two sampling points, preferably at least three sampling points, particularly preferably exactly three sampling points lie on the rising edge (F).

4. Method according to one of the preceding claims, **characterised in that** the signal pulse (P) is or is digitised at a sampling rate of less than 200 mega sampling points per second, in particular less than 150 mega sampling points per second, preferably less than 100 mega sampling points per second, and/or that the threshold value for the pulse detection is in the range from 0.2 to 3% of the pulse peak value, in particular the average pulse peak value, and/or that the duration of the signal pulse (P) is in the range from 1 to 150 nanoseconds, preferably in the range from 1 to 70 nanoseconds.

5. Method according to one of the preceding claims, **characterised in that** the shape of the rising edge (F) of the signal pulse (P) is determined automatically, in particular by comparing the difference between the sampling value, in particular the amplitude value, of two successive sampling points of at least one digitised reference pulse (R) with an earlier difference between the sampling value, in particular the amplitude value, of two successive sampling points of the reference pulse (R), and in the event that the difference is the same, an at least substantially linear, in particular a linear increase is assumed, and in the event that the difference of the later sampling points is smaller than that of the earlier ones, a non-linear increase without inflection point (pi) is assumed, and in the event that the difference of the later sampling points is greater than that of the earlier ones, an S-like non-linear increase with at least one inflection point (pi) is assumed, preferably, wherein the automatic determination of the shape of the rising edge (F) is performed by sampling two reference pulses (R), wherein a lower threshold value is set for one reference pulse (R) and a higher threshold value is set for the other reference pulse (R), and the difference between the sampling value, in particular the amplitude value, of a second and first sampling point of the reference pulse (R) is formed for both reference pulses (R), and the differences are compared with each other, and in the event that the difference is the same, an at least substantially linear, in particular a linear, in the event that the difference between the first and second sampling points of the reference pulse (R) is formed, and the differences are compared with each other, an at least substantially linear, in particular a linear increase is assumed, and in the event that the difference associated with the lower threshold value is greater than the difference associated with the higher threshold value, a non-linear increase without inflection point (pi) is assumed, and in the event that the difference associated with the lower threshold value is smaller than the difference associated with the higher threshold value, an S-like non-linear increase with at least one inflection point (pi) is assumed.

6.  Method according to one of the preceding claims, **characterised in that** the duration of the rising edge (F) is estimated, in particular automatically, the automatic estimation preferably being carried out by determining the number of those sampling points of a digitised reference pulse (R) for which it applies that the sampling value, in particular amplitude value, of a respective subsequent sampling point is greater than the sampling value, in particular amplitude value, of the respective preceding sampling point, and particularly preferably an estimation of the duration of the rising edge (F) is carried out, in particular amplitude value of a respective subsequent sampling point is greater than the sampling, in particular amplitude value of the respective preceding sampling point, and particularly preferably an estimation of the duration of the rising edge (F) is carried out for a plurality of reference pulses (R) and the mean value is formed and assumed to be the average duration.

7.  Evaluation unit (5) for determining an arrival time ($t_m$) of digitised signal pulses (P) representing a physical measured variable, which is designed and/or set up in order to

    - to calculate a difference between the time of a first sampling point ($s_1$) of a digitised signal pulse (P) and an arrival time ($t_m$) of the signal pulse (P) via the equation

    $$\Delta t = T \frac{ka_1}{a_2 - cka_1}$$

    where T is the sampling period with which the digitised signal pulse (P) is sampled, and $a_1$ is the sample value , in particular the amplitude value of a first sample point $s_1$ and $a_2$ is the sample value, in particular the amplitude value of a second, later sample point $s_2$ of the digitised signal pulse (P), where $s_1$ and $s_2$ are preferably the very first two sample points of the signal pulse (P), and in order to calculate an arrival time ($t_m$) of the signal pulse (P).
    - taking into account the value obtained for $\Delta t$ , in particular using the equation

    $$t_m = t_1 - \Delta t$$

    where $t_1$ is the time of the first sampling point $s_1$ of the signal pulse (P),
    wherein the evaluation unit (5) is either designed and/or set up such that in the equation for $\Delta t$ k = exp(-T/$\tau$) or k = a(2T)/2a(T), wherein a(2T) and a(T) are the sampling values, in particular amplitude values, of a third and second sampling point of a digitised reference pulse (R), in which the sampling value, in particular the amplitude value, of a first sampling point on the rising edge (F) corresponds to a threshold value set for the digitisation of the reference pulse or is at most a predetermined value above the threshold value, and c =1,
    or the evaluation unit (5) is designed and/or set up in such a way that in the equation for $\Delta t$ $k = m$ exp(-$T/\tau$) with 3.30 $\leq$ m $\leq$4.0, in particular 3.50 $\leq$ m $\leq$3.90, preferably 3.58 $\leq$ m $\leq$3.80, or k=a(2T)/a(T), where a(2T) and a(T) are the sampling value, in particular amplitude values of a third and second sampling point on the rising edge (F) of a digitised reference pulse (R), in which the sampling value, in particular the amplitude value, of a first sampling point on the rising edge (F) corresponds to a threshold value set for the digitisation of the reference pulse or is at most a predetermined value above the threshold value, and c = 0,
    or the evaluation unit (5) is designed and/or set up to receive information about the shape of the rising edge (F) of the signal pulse (P), which is selected from the group comprising

        - at least an essentially linear increase,
        - a non-linear increase without inflection point (pi) and
        - an S-like non-linear increase with at least one inflection point (pi),

    and in the event that the rising edge (F) of the signal pulse (P) is **characterised by** an at least essentially linear increase, k=1 and c=1 should be used,
    and in the event that the rising edge (F) of the signal pulse (P) is **characterised by** a non-linear rise without an inflection point (pi), k = exp(-T/· ) or k=a(2T)/2a(T), where $\tau$ is a time constant specifying the pulse peak time and a(2T) and a(T) are the sample values, in particular amplitude values, of a third and second sample point of a digitised reference pulse (R), in which the sampling, in particular amplitude, values of a first sampling point on the rising edge (F) correspond to a threshold value set for the digitisation of the reference pulse or are highest above the threshold value by a predetermined value, and c =1 is to be used,

and in the event that the rising edge (F) of the signal pulse (P) is **characterised by** an S-like non-linear rise with at least one inflection point (pi), $k = m \exp(-T/\tau)$ with 3.30 ≤m ≤4.0, in particular 3.50 ≤m ≤3.90, preferably 3.58 ≤m ≤3.80, or k=a(2T)/a(T), where a(2T) and a(T) are the sample values, in particular amplitude values, of a third and second sample point on the rising edge (F) of a digitised reference pulse (R), in particular amplitude values of a third and second sampling point on the rising edge (F) of a digitised reference pulse (R), in which the sampling value, in particular amplitude value, of a first sampling point on the rising edge (F) corresponds to a threshold value set for the digitisation of the reference pulse or is at most a predetermined value above the threshold value, and c = 0.

8. Evaluation unit (5) according to claim 7, **characterised in that** the evaluation unit (5) is provided by a field programmable gate array or comprises such an array, and/or **in that** the evaluation unit (5) forms a component of an application-specific integrated circuit (6) or comprises such a circuit, and/or **in that** the evaluation unit (5) is **characterised by** a multi-channel configuration with in particular more than 100 channels (1), and/or **in that** the evaluation unit (5) comprises at least one, preferably exactly one addition module (15) and/or at least one, preferably exactly one subtraction module (18) and/or at least one, preferably exactly one division module (19).

9. Evaluation unit (5) according to claim 7 or 8, **characterised in that** the evaluation unit (5) is designed and/or set up to automatically determine the shape of the rising edge (F) of a signal pulse (P), preferably, wherein the evaluation unit (5) is designed and/or set up to perform the determination of the shape of the rising edge (F) by comparing the difference between the sample value, in particular the amplitude value, of two successive sample points of at least one digitised reference pulse (R) with an earlier difference between the sample value, in particular the amplitude value, of two successive sample points of the reference pulse (R), and, in the event that the difference is equal, an at least substantially linear, in particular a linear, increase is assumed, in particular amplitude value of two successive sampling points of the reference pulse (R) is compared, and in the event that the difference is the same, an at least substantially linear, in particular a linear increase is assumed, and in the event that the difference of the later sampling points is smaller than that of the earlier sampling points, a non-linear increase without inflection point (pi) is assumed, and in the event that the difference of the later sampling points is greater than that of the earlier sampling points, an S-like non-linear increase with at least one inflection point (pi) is assumed, preferably, wherein the evaluation unit (5) is designed and/or set up to determine the shape of the rising edge (F) by sampling two reference pulses (R), wherein a lower threshold value is set for one reference pulse (R) and a higher threshold value is set for the other reference pulse (R), and for both reference pulses (R) the difference between the sampling value, in particular the amplitude value, of a second and first sampling point of the reference pulse (R) is formed, and the differences are compared with one another, and in the event that the difference is the same, an at least one threshold value is formed, that the difference is the same, an at least substantially linear, in particular a linear increase is assumed, and in the event that the difference associated with the lower threshold value is greater than the difference associated with the higher threshold value, a non-linear increase without inflection point (pi) is assumed, and in the event that the difference associated with the lower threshold value is smaller than the difference associated with the higher threshold value, an S-like non-linear increase with at least one inflection point (pi) is assumed.

10. Evaluation unit (5) according to one of claims 7 to 9, **characterised in that** the evaluation unit (5) is designed and/or set up in order to automatically estimate the duration of the rising edge (F), the automatic estimation preferably taking place via the determination of the number of those first sampling points of at least one digitised reference pulse (R) for which it applies that the sampling value, in particular amplitude value, of a respective subsequent sampling point is greater than the sampling value, in particular amplitude value, of the respective preceding sampling point.

11. Device for determining an arrival time of signal pulses (P) representing a physical measurand, comprising

- at least one, in particular several inputs, via which signal pulses (P) representing a physical measured variable can be received,
- at least one, in particular a plurality of analogue-to-digital converters (4) arranged downstream of the input(s), via which received signal pulses (P) can be sampled and digitised, in particular with a predetermined or predeterminable sampling period (T),
- at least one evaluation unit (5) downstream of the analogue-to-digital converter(s) (4) according to one of claims 7 to 10.

**12.** Device according to claim 11, **characterised in that** the device comprises one or more filters (3) and/or amplifiers, the filter or filters and/or amplifiers preferably being arranged downstream of the input or inputs and/or upstream of the analogue-to-digital converter or converters, and/or **in that** the device is **characterised by** a multi-channel configuration with, in particular, more than 100 channels (1), wherein preferably each channel (1) comprises an input, an analogue-to-digital converter (4) and in particular a filter (3) and/or amplifier, or each channel (1) is assigned an input, an analogue-to-digital converter (4) and in particular a filter (3) and/or amplifier, and the device preferably comprises precisely one evaluation unit (5) with which signals of all channels (1) can be processed or are processed.

**13.** Device according to claim 11 or 12, **characterised in that** the analogue-to-digital converter or converters (4) are designed as conveyor belt analogue-to-digital converters.

**14.** Evaluation system comprising two or more devices according to any one of claims 11 to 13.

**15.** Radiation detection system comprising one or more sensors (2) for direct or indirect radiation detection and one or more devices coupled or couplable thereto according to any one of claims 11 to 13, wherein the sensor or sensors (2) are preferably given by or comprise photodetectors and/or straw tubes and/or silicon photomultipliers (SiPM) and/or gas detectors.

**Revendications**

**1.** Procédé de détermination d'un temps d'arrivée ($t_m$) d'une impulsion de signal numérisée (P) représentant une physique, dans lequel

- on détermine quelle forme présente le flanc montant (F) de l'impulsion de signal (P), la forme étant choisie dans le groupe comprenant

     - une augmentation au moins essentiellement linéaire,
     - une augmentation non linéaire sans point d'inflexion (pi) et
     - une augmentation non linéaire semblable à S avec au moins un point d'inflexion (pi),

- dans les trois cas, une différence entre l'instant ($t_1$) du premier point d'échantillonnage ($s_1$) de l'impulsion de signal (P) et l'instant d'arrivée ($t_m$) de l'impulsion de signal (P) est calculée au moyen d'une unité d'évaluation (5) par l'intermédiaire de l'équation

$$\Delta t = T \frac{ka_1}{a_2 - cka_1}$$

où T représente la période d'échantillonnage avec laquelle l'impulsion de signal numérisée (P) est échantillonnée, et $a_1$ est la valeur d'échantillonnage, en particulier la valeur d'amplitude d'un premier point d'échantillonnage $s_1$ et $a_2$ est la valeur d'échantillonnage, en particulier la valeur d'amplitude d'un deuxième point d'échantillonnage ultérieur $s_2$ de l'impulsion de signal numérisée (P), où $s_1$ et $s_2$ sont de préférence les deux tout premiers points d'échantillonnage de l'impulsion de signal (P), et où, dans le cas où, une montée au moins sensiblement linéaire est déterminée comme forme du front montant (F), k =1 et c = 1 sont fixé, et dans le cas où une montée non linéaire sans point d'inflexion (pi) est déterminée comme forme du front montant (F), k = exp(-T/$\tau$) ou k=a(2T)/2a(T), où a(2T) et a(T) sont les valeurs d'échantillonnage, en particulier les valeurs d'amplitude, d'un troisième et d'un deuxième point d'échantillonnage d'une impulsion de référence numérisée (R), où la valeur d'échantillonnage, en particulier la valeur d'amplitude d'un premier point d'échantillonnage sur le flanc montant (F) correspond à une valeur de seuil appliquée pour la numérisation de l'impulsion de référence ou se situe au maximum à une valeur prédéterminée au-dessus de la valeur de seuil, et c = 1 est fixé, et dans le cas où une montée non linéaire semblable à un S est déterminée avec au moins un point d'inflexion (pi) comme forme du flanc montant (F), $k = m$ exp(-$T/\tau$) avec 3,30 $\leq$ m $\leq$ 4,0, notamment 3,50 $\leq$ m $\leq$ 3,90, de préférence 3,58 $\leq$ m $\leq$ 3,80, ou k=a(2T)/a(T), où a(2T) et a(T) sont les valeurs d'échantillonnage, en particulier les valeurs d'amplitude d'un troisième et d'un deuxième point d'échantillonnage sur le front montant (F) d'une impulsion de référence numérisée (R), où la valeur d'échantillonnage, en particulier la valeur d'amplitude d'un premier point d'échantillonnage sur le flanc montant (F) correspond à une valeur de seuil appliquée pour la numérisation de l'impulsion de référence ou se situe au maximum à une valeur prédéterminée au-dessus de la valeur de seuil, et c = 0, est

fixé $\tau$ étant une constante de temps spécifiant le temps de pic de l'impulsion, et

- le temps d'arrivée ($t_m$) de l'impulsion de signal (P) est calculé au moyen de l'unité d'évaluation (5) en tenant compte de la valeur obtenue pour $\Delta t$, notamment au moyen de l'équation

$$t_m = t_1 - \Delta t,$$

où $t_1$ est l'instant du premier point d'échantillonnage $s_1$ de l'impulsion de signal (P), en particulier, l'instant d'arrivée ($t_m$) étant pris en compte lors du traitement ultérieur de l'impulsion de signal numérisée (P).

2. Procédé selon la revendication 1, **caractérisé en ce que** on choisit comme forme pour le front montant (F) de l'impulsion de signal (P) une montée non linéaire sans point d'inflexion (pi), lorsque la forme de l'impulsion est définie par l'équation

$$V(t) = A \left( \frac{t - t_s}{\tau} \right)^n \exp\left( -\frac{t - t_s}{\tau} \right)$$

avec n = 1,
et
on choisit comme forme pour le front montant (F) de l'impulsion de signal (P) une montée non linéaire semblable à un S avec au moins un point d'inflexion (pi) dans le cas où la forme de l'impulsion est définie par l'équation

$$V(t) = A \left( \frac{t - t_s}{\tau} \right)^n \exp\left( -\frac{t - t_s}{\tau} \right)$$

avec n = 2, où t est le temps, $t_s$ le temps d'arrivée de l'impulsion de signal, A un facteur lié à l'amplitude et $\tau$ une constante de temps spécifiant le temps de pic de l'impulsion.

3. Procédé selon l'une des revendications précédentes, **caractérisé en ce que** l'impulsion de signal numérisée (P) représente un signal de capteur, en particulier une impulsion de capteur d'un dispositif de mesure physique, de préférence d'un détecteur de rayonnement, et **en ce que** l'on choisit comme forme pour le flanc montant (F) de l'impulsion de signal (P) une montée non linéaire sans point d'inflexion (pi) pour le cas, que l'impulsion de signal est une réponse au rayonnement gamma, en particulier sans bruit et/ou formée au moyen d'un formateur d'impulsions, d'un détecteur de rayonnement, en particulier d'un photomultiplicateur au silicium (SiPM) couplé à un scintillateur à l'orthosilicate de lutécium et d'yttrium dopé au cérium, et on choisit comme forme du front montant (F) de l'impulsion de signal (P) une montée non linéaire semblable à un S avec un point d'inflexion (pi) dans le cas où l'impulsion de signal représente une réponse à un seul cluster, formée en particulier au moyen d'un shaper, à une irradiation de Fe[55], et/ou **en ce que** le rapport entre la fréquence d'échantillonnage et la durée du front montant (F) de l'impulsion de signal (P) est choisi ou réglé de telle sorte qu'au moins deux points d'échantillonnage, de préférence au moins trois points d'échantillonnage, de manière particulièrement préférée exactement trois points d'échantillonnage se trouvent sur le front montant (F).

4. Procédé selon l'une des revendications précédentes, **caractérisé en ce que** l'impulsion de signal (P) est ou sera numérisée à une fréquence d'échantillonnage inférieure à 200 méga-points d'échantillonnage par seconde, notamment inférieure à 150 méga-points d'échantillonnage par seconde, de préférence inférieure à 100 méga-points d'échantillonnage par seconde, et/ou **en ce que** la valeur seuil pour la détection d'impulsion se situe dans la plage de 0,2 à 3% de la valeur de pic d'impulsion, en particulier moyenne, et/ou **en ce que** la durée de l'impulsion de signal (P) se situe dans la plage de 1 à 150 nanosecondes, de préférence dans la plage de 1 à 70 nanosecondes.

5. Procédé selon l'une des revendications précédentes, **caractérisé en ce qu'**on effectue une détermination automatique de la forme du front montant (F) de l'impulsion de signal (P), notamment en comparant la différence entre la valeur d'échantillonnage, notamment d'amplitude, de deux points d'échantillonnage successifs d'au moins une impulsion de référence numérisée (R) avec une différence antérieure entre la valeur d'échantillonnage, notamment d'amplitude, de deux points d'échantillonnage successifs de l'impulsion de référence (R), et dans le cas où la différence est égale, on suppose une augmentation au moins sensiblement linéaire, en particulier une augmentation linéaire, et dans le cas où la différence des points d'échantillonnage ultérieurs est inférieure à celle des points d'échantillonnage antérieurs, on suppose une augmentation non linéaire sans point d'inflexion (pi), et dans le cas où la différence des points d'échantillonnage ultérieurs est supérieure à celle des points d'échantillonnage antérieurs, on suppose une augmentation non linéaire semblable à un S avec au moins un point d'inflexion (pi), de préférence, la détermination automatique de la forme du flanc montant (F) s'effectuant en échantillonnant deux impulsions de référence (R), une valeur de seuil plus basse étant appliquée pour l'une des impulsions de référence (R) et une valeur de seuil plus élevée étant appliquée pour l'autre impulsion de référence (R), et la différence entre la valeur d'échantillonnage, en particulier la valeur d'amplitude, d'un deuxième et d'un premier point d'échantillonnage de l'impulsion de référence (R) étant formée pour les deux impulsions de référence (R), et les différences étant comparées entre elles, et dans le cas où la différence est égale, on suppose une augmentation au moins sensiblement linéaire, en particulier une augmentation linéaire, et dans le cas où la différence associée à la valeur de seuil inférieure est supérieure à la différence associée à la valeur de seuil supérieure, on suppose une augmentation non linéaire sans point d'inflexion (pi), et dans le cas où la différence associée à la valeur de seuil inférieure est inférieure à la différence associée à la valeur de seuil supérieure, on suppose une augmentation non linéaire semblable à un S avec au moins un point d'inflexion (pi).

6. Procédé selon l'une des revendications précédentes, **caractérisé en ce que** la durée du flanc montant (F) est estimée en particulier automatiquement, l'estimation automatique s'effectuant de préférence par la détermination du nombre de points d'échantillonnage d'une impulsion de référence numérisée (R) pour lesquels il est vrai que la valeur d'échantillonnage, en particulier la valeur d'amplitude d'un point d'échantillonnage suivant respectif est supérieure à la valeur d'échantillonnage, en particulier la valeur d'amplitude du point d'échantillonnage précédent respectif, et de préférence une estimation de la durée du flanc montant (F) est effectuée pour une pluralité d'impulsions de référence (R) et la valeur moyenne est formée et prise comme durée moyenne.

7. Unité d'évaluation (5) pour déterminer un temps d'arrivée ($t_m$) d'impulsions de signal (P) numérisées représentant une mesurandephysique, qui est conçue et/ou agencée pour

- une différence entre l'instant d'un premier point d'échantillonnage ($s_1$) d'une impulsion de signal numérisée (P) et un temps d'arrivée ($t_m$) de l'impulsion de signal (P) par l'intermédiaire de l'équation

$$\Delta t = T \frac{ka_1}{a_2 - cka_1}$$

où T représente la période d'échantillonnage avec laquelle l'impulsion de signal numérisée (P) est échantillonnée, et $a_1$ la valeur d'échantillonnage, en particulier la valeur d'amplitude, d'un premier point d'échantillonnage $s_1$ et $a_2$ la valeur d'échantillonnage, en particulier la valeur d'amplitude, d'un deuxième point d'échantillonnage ultérieur $s_2$ de l'impulsion de signal numérisée (P), $s_1$ et $s_2$ étant de préférence les deux tout premiers points d'échantillonnage de l'impulsion de signal (P), et pour calculer la valeur d'amplitude de l'impulsion de signal numérisée (P).
- en tenant compte de la valeur obtenue pour · t, à calculer un temps d'arrivée ($t_m$) de l'impulsion de signal (P), notamment par l'intermédiaire de l'équation

$$t_m = t_1 - \Delta t$$

où $t_1$ est l'instant du premier point d'échantillonnage $s_1$ de l'impulsion de signal (P),
l'unité d'évaluation (5) étant conçue et/ou aménagée de telle sorte que, dans l'équation pour $\Delta t$, k = exp(-T/$\tau$) ou k = a(2T)/2a(T), a(2T) et a(T) étant les valeurs d'échantillonnage, en particulier les valeurs d'amplitude d'un troisième et d'un deuxième point d'échantillonnage d'une impulsion de référence numérisée (R), dans lequel la valeur d'échantillonnage, en particulier la valeur d'amplitude d'un premier point d'échantillonnage sur le flanc montant (F) correspond à une valeur de seuil appliquée pour la numérisation de l'impulsion de référence ou est supérieure à la valeur de seuil d'au plus une valeur prédéterminée, et c =1,
ou l'unité d'évaluation (5) est conçue et/ou aménagée de telle sorte que dans l'équation pour $\Delta t$ k = m exp(-T/$\tau$) avec 3,30 ≤m ≤4,0, en particulier 3,50 ≤m ≤3,90, de préférence 3,58 ≤m ≤3,80, ou k=a(2T)/a(T), a(2T) et a(T) étant les valeurs d'échantillonnage, en particulier les valeurs d'amplitude d'un troisième et d'un deuxième point d'échantillonnage sur le flanc montant (F) d'une impulsion de référence numérisée (R), dans lequel la valeur d'échantillonnage, en particulier la valeur d'amplitude, d'un premier point d'échantillonnage sur le flanc montant (F) correspond à une valeur de seuil appliquée pour la numérisation de l'impulsion de référence ou est supérieure à la valeur de seuil d'au plus une valeur prédéterminée, et c = 0,
ou l'unité d'évaluation (5) est conçue et/ou agencée pour recevoir une information sur la forme du flanc montant (F) de l'impulsion de signal (P), qui est choisie dans le groupe comprenant

- une augmentation au moins essentiellement linéaire,
- une augmentation non linéaire sans point d'inflexion (pi) et
- une augmentation non linéaire semblable à S avec au moins un point d'inflexion (pi),

et, dans le cas où le front montant (F) de l'impulsion de signal (P) se **caractérise par** une montée au moins sensiblement linéaire, utiliser k=1 et c=1,
et dans le cas où le flanc montant (F) de l'impulsion de signal (P) se **caractérise par** une montée non linéaire sans point d'inflexion (pi), $k = \exp(-T/\tau)$ ou $k=a(2T)/2a(T)$, $\tau$ étant une constante de temps spécifiant le temps de pic de l'impulsion et $a(2T)$ et $a(T)$ étant les valeurs d'échantillonnage, en particulier les valeurs d'amplitude, d'un troisième et d'un deuxième point d'échantillonnage d'une impulsion de référence numérisée (R), dans lequel les valeurs d'échantillonnage, en particulier les valeurs d'amplitude d'un premier point d'échantillonnage sur le flanc montant (F) correspondent à une valeur de seuil appliquée pour la numérisation de l'impulsion de référence ou sont supérieures à la valeur de seuil d'une valeur prédéterminée, et à utiliser c =1,
et dans le cas où le flanc montant (F) de l'impulsion de signal (P) se **caractérise par** une montée non linéaire semblable à un S avec au moins un point d'inflexion (pi), $k = m \exp(-T/\tau)$ avec $3{,}30 \leq m \leq 4{,}0$, en particulier $3{,}50 \leq m \leq 3{,}90$, de préférence $3{,}58 \leq m \leq 3{,}80$, ou $k=a(2T)/a(T)$, où $a(2T)$ et $a(T)$ sont les valeurs d'échantillonnage, notamment les valeurs d'amplitude d'un troisième et d'un deuxième point d'échantillonnage sur le flanc montant (F) d'une impulsion de référence numérisée (R), pour laquelle la valeur d'échantillonnage, notamment la valeur d'amplitude d'un premier point d'échantillonnage sur le flanc montant (F) correspond à une valeur de seuil appliquée pour la numérisation de l'impulsion de référence ou se situe au plus haut d'une valeur prédéfinie au-dessus de la valeur de seuil, et à utiliser c = 0.

8. Unité d'évaluation (5) selon la revendication 7, **caractérisée en ce que** l'unité d'évaluation (5) est donnée par un Field Programmable Gate Array ou comprend un tel Field Programmable Gate Array, et/ou **en ce que** l'unité d'évaluation (5) forme un composant d'un circuit intégré (6) spécifique à l'application ou comprend un tel circuit, et/ou **en ce que** l'unité d'évaluation (5) se **caractérise par** une configuration multicanaux avec notamment plus de 100 canaux (1), et/ou **en ce que** l'unité d'évaluation (5) comprend au moins un, de préférence exactement un module d'addition (15) et/ou au moins un, de préférence exactement un module de soustraction (18) et/ou au moins un, de préférence exactement un module de division (19).

9. Unité d'évaluation (5) selon la revendication 7 ou 8, **caractérisée en ce que** l'unité d'évaluation (5) est conçue et/ou agencée pour déterminer automatiquement la forme du flanc montant (F) d'une impulsion de signal (P), de préférence, l'unité d'évaluation (5) étant conçue et/ou agencée pour effectuer la détermination de la forme du flanc montant (F) en comparant la différence entre la valeur d'échantillonnage, en particulier la valeur d'amplitude, de deux points d'échantillonnage successifs d'au moins une impulsion de référence numérisée (R) avec une différence antérieure entre la valeur d'échantillonnage, en particulier la valeur d'amplitude, de l'impulsion de référence (R), en particulier la valeur d'amplitude de deux points d'échantillonnage successifs de l'impulsion de référence (R), et dans le cas où la différence est égale, on suppose une croissance au moins sensiblement linéaire, en particulier une croissance linéaire, et dans le cas où la différence des points d'échantillonnage ultérieurs est inférieure à celle des points d'échantillonnage antérieurs, on suppose une croissance non linéaire sans point d'inflexion (pi), et dans le cas où la différence des points d'échantillonnage ultérieurs est supérieure à celle des points d'échantillonnage antérieurs, on suppose une croissance non linéaire semblable à un S avec au moins un point d'inflexion (pi), de préférence, l'unité d'évaluation (5) étant conçue et/ou agencée pour effectuer la détermination de la forme du flanc montant (F) en échantillonnant deux impulsions de référence (R), une valeur de seuil plus basse étant appliquée pour l'une des impulsions de référence (R) et une valeur de seuil plus élevée étant appliquée pour l'autre impulsion de référence (R), et pour les deux impulsions de référence (R), on forme la différence entre la valeur d'échantillonnage, en particulier la valeur d'amplitude d'un deuxième et d'un premier point d'échantillonnage de l'impulsion de référence (R), et on compare les différences entre elles, et dans le cas où, que la différence est égale, on suppose une augmentation au moins sensiblement linéaire, en particulier linéaire, et dans le cas où la différence associée au seuil inférieur est supérieure à la différence associée au seuil supérieur, on suppose une augmentation non linéaire sans point d'inflexion (pi), et dans le cas où la différence associée au seuil inférieur est inférieure à la différence associée au seuil supérieur, on suppose une augmentation non linéaire semblable à un S avec au moins un point d'inflexion (pi).

**10.** Unité d'évaluation (5) selon l'une des revendications 7 à 9, **caractérisée en ce que** l'unité d'évaluation (5) est conçue et/ou agencée pour estimer automatiquement la durée du flanc montant (F), l'estimation automatique s'effectuant de préférence par la détermination du nombre de premiers points d'échantillonnage d'au moins une impulsion de référence numérisée (R) pour lesquels il est vrai que la valeur d'échantillonnage, en particulier la valeur d'amplitude, d'un point d'échantillonnage respectivement suivant est supérieure à la valeur d'échantillonnage, en particulier à la valeur d'amplitude, du point d'échantillonnage respectivement précédent.

**11.** Dispositif pour déterminer un temps d'arrivée d'impulsions de signal (P) représentant une mesurandephysique, comprenant

- au moins une, en particulier plusieurs entrées, par lesquelles des impulsions de signal (P) représentant une grandeur de mesure physique peuvent être reçues,
- au moins un, en particulier plusieurs convertisseurs analogique-numérique (4) disposés en aval de la ou des entrées, par l'intermédiaire desquels des impulsions de signal (P) reçues peuvent être échantillonnées et numérisées, en particulier avec une période d'échantillonnage (T) prédéfinie ou pouvant être prédéfinie,
- au moins une unité d'évaluation (5) disposée en aval du ou des convertisseurs analogique-numérique (4) selon l'une des revendications 7 à 10.

**12.** Dispositif selon la revendication 11, **caractérisé en ce que** le dispositif comprend un ou plusieurs filtres (3) et/ou amplificateurs, le ou les filtres et/ou amplificateurs étant de préférence disposés en aval de la ou des entrées et/ou en amont du ou des convertisseurs analogique-numérique, et/ou **en ce que** le dispositif se **caractérise par** une configuration multicanaux avec notamment plus de 100 canaux (1), de préférence chaque canal (1) comprenant une entrée, un convertisseur analogique-numérique (4) et en particulier un filtre (3) et/ou un amplificateur, ou une entrée, un convertisseur analogique-numérique (4) et en particulier un filtre (3) et/ou un amplificateur étant associés à chaque canal (1), et le dispositif comprenant de préférence exactement une unité d'évaluation (5) avec laquelle des signaux de tous les canaux (1) peuvent être traités ou sont traités.

**13.** dispositif selon la revendication 11 ou 12, **caractérisé en ce que** le ou les convertisseurs analogique-numérique (4) sont conçus comme des convertisseurs analogique-numérique à la chaîne.

**14.** Système d'évaluation comprenant deux ou plusieurs dispositifs selon l'une quelconque des revendications 11 à 13.

**15.** Système de détection de rayonnement comprenant un ou plusieurs capteurs (2) pour la détection directe ou indirecte de rayonnement et un ou plusieurs dispositifs couplés ou pouvant être couplés à celui-ci ou à ceux-ci selon l'une quelconque des revendications 11 à 13, dans lequel le ou les capteurs (2) sont de préférence donnés par ou comprennent des photodétecteurs et/ou des tubes de Straw et/ou des photomultiplicateurs au silicium (SiPM) et/ou des détecteurs de gaz.

Fig. 1a

Zeit, ns

Fig. 1b

Fig. 2a

Sampling-Phase (1/1000 of Sampling-Periode)

Fig. 2b

Fig. 3a

Fig. 3b

Fig. 4

Fig. 5

Fig. 6

Fig. 7

Fig. 8

Fig. 9

Fig. 10

Fig. 11

Fig. 12

EP 3 887 865 B1

Fig. 13

Fig. 14

Fig. 15

EP 3 887 865 B1

Fig. 16

Fig. 17

EP 3 887 865 B1

EP 3 887 865 B1

Fig. 18

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20180113160 A1
- US 20180113203 A1

**In der Beschreibung aufgeführte Nicht-Patentliteratur**

- A simple and improved digital timing method for positron emission tomography. **VON WEI HU et al.** Nuclear Instruments & Methods in Physics Research, Section A. Elsevier B.V, 01. Oktober 2010, vol. 622, 219-224
- **M. A. NELSON ; B. D. ROONEY ; D. R. DINWIDDIE ; G. S. BRUNSON.** Analysis of digital timing methods with BaF2 scintillators. *Nucl. Instrum. Methods Phys. Res. A, Accel. Spectrom. Detect. Assoc. Equip.,* Juni 2003, vol. 505 (1- 2), 324-327
- **L. BARDELLI ; G. POGGI ; M. BINI ; G. PASQUALI ; N. TACCETTI.** Time measurements by means of digital sampling techniques: A study case of 100 ps FWHM time resolution with a 100 MSample/s, 12 bit digitizer. *Nucl. Instrum. Methods Phys. Res. A, Accel. Spectrom. Detect. Assoc. Equip,* April 2004, vol. 521 (2- 3), 480-492
- **V. PAULAUSKAS ; M. MADURGA ; R. GRZYWACZ ; D. MILLER ; S. PADGETT ; H. TAN.** A digital data acquisition framework for the Versatile Array of Neutron Detectors at Low Energy (VANDLE). *Nucl. Instrum. Methods Phys. Res. A, Accel. Spectrom. Detect. Assoc. Equip.,* Februar 2014, vol. 737, 22-28
- **B. JOLY et al.** An optimal filter based algorithm for PET detectors with digital sampling front-end. *IEEE transactions on nuclear science,* Februar 2010, vol. 57 (1), 63-70
- **WILLIAM K. WARBURTON ; WOLFGANG HENNIG.** New Algorithms for improved digital pulse arrival timing with sub-GSps ADCs. *IEEE transactions on nuclear science,* Dezember 2017, vol. 64 (12), 3627-3634
- **L. JOKHOVETS ; M. DROCHNER ; A. ERVEN ; W. ERVEN ; G. KEMMERLING ; H. KLEINES ; P. KULESSA ; H.W. LOEVENICH ; P. MARCINIEWSKI ; M. MERTENS.** ADC-based real-time signal processing for the PANDA Straw Tube Tracker. *IEEE transactions on nuclear science,* Dezember 2014, vol. 61 (6), 3627-3634
- **M. STREUN ; G. BRANDENBURG ; H. LARUE ; E. ZIMMERMANN ; K. ZIEMONS ; H. HALLING.** Coincidence detection by digital processing of free-running sampled pulses. *Nuclear instruments and methods in physics research, section A,* 2002, vol. 4867, 530-534
- **M. STREUN ; G. BRANDENBURG ; M. KHODAVERDI ; H. LARUE ; C. PARL ; K. ZIEMONS.** Timemark correction for the ClearPETTM scanners. *IEEE Nuclear Science Symposium Conference Record,* 2005, M07-155
- **P.GUERRA ; J.E.ORTUNO ; J.J.VAQUERO ; G.KONTAXAKIS ; M.DESCO ; A.SANTOS.** Modeling the Acquisition Front-End in High Resolution Gamma-Ray Imaging. *IEEE transactions on nuclear science,* Juni 2006, vol. 53 (3), 1150-1155
- **WEI HU ; YONG CHOI ; KEY JO HONG ; JIHOON KANG ; JIN HO JUNG ; YOUN SUK HUH ; HYUN KEONG LIM ; SANG SU KIM ; BYUNG JUN MIN ; BYUNG-TAE KIM.** A simple and improved digital timing method for positron emission tomography. *Nuclear instruments and methods in physics research, section A,* 2010, vol. 622, 219-224
- **C.L. KIM ; G.C. WANG ; S. DOLINSKY.** Multi-Pixel Photon Counters for TOF PET Detector and its Challenges. *IEEE Nuclear Science Symposium Conference Record,* 2008, M02-3
- **R. MAIER.** Cooler synchrotron COSY - Performance and perspectives. *Nuclear instruments and methods in physics research, section A390,* 1997, 1-8
- **J. FEDORISIN.** Simulations of MPD Straw End-Cap Tracker. *Proceedings of Science (XXII International Baldin Seminar on High Energy Physics Problems),* 2015, vol. 130
- **W. SANSEN ; Z. CHANG.** Limits of Low Noise Performance of Detector Readout Front Ends in CMOS Technlgy. *IEEE Transactions on Circuits and Systems,* 1990, vol. 37 (11), 1375-1382